# EUROPEAN PATENT APPLICATION

(11) **EP 1 406 472 A1**
(43) Date of publication of application: **07.04.2004**
(21) Application number: 02741437.4
(22) Date of filing: 08.07.2002
(51) Int. Cl.: H05B 3/74, H05B 3/16, H05B 3/10, C04B 37/00, H05B 3/20, H01L 21/02, H01L 21/68, C23C 16/44

(54) **CERAMIC HEATER AND CERAMIC JOINED ARTICLE**

(30) Priority: 09.07.2001 JP 2001207601; 21.12.2001 JP 2001389961; 18.02.2002 JP 2002040736
(71) Applicant: IBIDEN CO., LTD., Ogaki-shi Gifu-ken 503-0917 (JP)
(72) Inventor: ITO, Yasutaka, Ibi-gun, Gifu 501-0695 (JP)
(74) Representative: Gillard, Marie-Louise
(86) International application number: PCT/JP2002/006893
(87) International publication number: WO 2003/007661

(57) **Abstract**

An obj ect of the present invention is to provide a ceramic heater capable of stably supporting a semiconductor wafer and evenly heating the whole of a semiconductor wafer or the like without generating any warp in the semiconductor wafer or the like. The ceramic heater according to the present invention comprises: a disk-like ceramic substrate; a heating element formed on a surface of or inside the ceramic substrate; and through holes for letting lifter pins pass through the ceramic substrate, wherein the number of the formed through holes is three or more, and the through holes are formed in an area whose distance from the center of the ceramic substrate is 1/2 or more of the distance from the center to the outer edge of the ceramic substrate.

## Description

### Technical Field

The present invention mainly relates to a ceramic heater and a ceramic bonded body which are used in the production and inspection of semiconductors, the field of optics, and so on.

### Background Art

Conventionally, a heater, wafer prober or the like wherein a base material made of a metal such as stainless steel or aluminum alloy is used has been used in semiconductor producing/inspecting devices and so on, examples of which include an etching device and a chemical vapor phase growth device and the like.

However, such a heater made of metal has the following problems.

First, the thickness of the heater plate must be as thick as about 15 mm since the heater is made of a metal. Because in a thin metal plate, a bend, a strain and so on are generated on the basis of thermal expansion resulting from heating so that a silicon wafer put on the metal plate is damaged or inclined. However, if the thickness of the heater plate is made thick, a problem that the heater becomes heavy and bulky arises.

The temperature of a face for heating an object to be heated such as a silicon wafer (referred to as a heating face hereinafter) and the like is controlled by changing the voltage or current quantity applied to the heating elements. However, since the metal plate is thick, the temperature of the heater plate does not follow the change in the voltage or current quantity promptly. Thus, a problem that the temperature is not easily controlled is caused.

Thus, JP Kokai Hei 11-40330 and so forth suggest a ceramic substrate wherein a nitride ceramic or a carbide ceramic, with a high thermal conductivity and a high strength, is used as a substrate and heating elements formed by sintering metal particles are provided on a surface of a plate-form body made of such a ceramic.

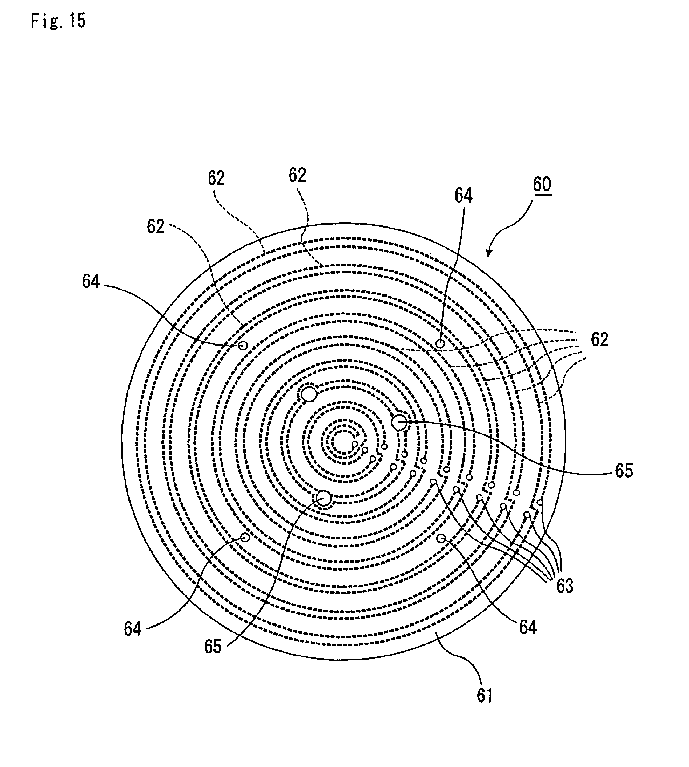

As illustrated in Fig. 15, usually, in such a ceramic heater, heating elements 62 are formed inside a ceramic substrate 61 and further through holes for passing lifterpins through are formed in the vicinity of the center. This is because by letting the lifter pins pass through the through holes 65 and then moving the pins up and down, a semiconductor wafer can be relatively easily received from the previous line or the semiconductor wafer can be carried to the next line. Reference numeral 64 represents bottomed holes 64 for embedding temperature measuring elements such as thermocouples, and reference numeral 63 represents external terminals for connecting the heating elements 62 to a power source.

As described above, the through holes 65 are arranged in the vicinity of the center of the ceramic substrate 61. This is because in order to work the lifter pins by means of one motor, it is preferred that the positions of the lifter pins are closer to each other.

In the case that this ceramic heater 60 is used to heat an object tobeheated, such as a semiconductor wafer and the like, the temperature distribution in the surface of the ceramic heater 60 is reflected on the semiconductor wafer or the like if the object is heated in the state that the object contacts the heating face of the ceramic heater 10. As a result, it is difficult that the semiconductor wafer or the like is evenly heated.

In order that the surface temperature of the ceramic heater 60 is made to heat the semiconductor wafer or the like evenly, highly complicated control is required. Hence, the temperature control is not easy.

Thus, when the semiconductor wafer is heated, there can be usually used a method of supporting the semiconductor wafer by means of the lifter pins provided for carrying the semiconductor wafer. That is, the lifters pins are held in the state that they project slightly from the surface of the ceramic substrate 61, and the lifter pins are used to support the semiconductor wafer in the state that the semiconductor wafer is a given distance apart from the surface of the ceramic substrate 61. The semiconductor wafer is then heated.

According to this method of using the lifter pins, the semiconductor wafer is heated by radiation from the ceramic substrate 61 or convection current since the semiconductor wafer is held in the state that the semiconductor wafer is apart from the surface of the ceramic heater 61 by the given distance. Accordingly, the temperature distribution in the surface of the ceramic substrate 61 is not usually reflected directly on the semiconductor wafer, so that the semiconductor wafer is more evenly heated and any temperature distribution is not easily generated in the semiconductor wafer.

However, when the lifter pins are used to intend to carry the semiconductor wafer, the semiconductor wafer may not be stably supported. In this case, there arises a problem that the semiconductor wafer is inclined to get out of position.

At the time when a semiconductor wafer or a liquid crystal substrate is put thereon and heated (as well as the time of the state that a semiconductor wafer or a liquid crystal substrate is put on the heated ceramic substrate and until the temperature thereof returns to the original temperature, that is, a transition state), there is caused a problem that temperature difference is generated in the obj ect to be heated, such as the semiconductor wafer or the liquid crystal substrate.

Moreover, a problem that free particles adhere to the object to be heated is also encountered.

Thus, the present inventors analyzed a cause for which an obj ect to be heated, such a semiconductor wafer or a liquid crystal substrate, (which may be referred to as a semiconductor wafer or the like hereinafter) , is inclined or temperature unevenness is generated when the semiconductor wafer or the like is heated. As a result, it has been found out that in the case that the lifter pins concentrate around the center, the object to be heated, such as the semiconductor wafer cannot be stably supported and the heat capacity per unit area (volume) in the central portion of the ceramic substrate 61 gets smaller than that in the peripheral portion so that the temperature of the central portion of the ceramic substrate 61 rises easily at the time of heating the ceramic substrate.

It has also been found out that if the lifter pins are present in the vicinity of the center when a plate-form object to be heated, such as a semiconductor wafer or a liquid crystal substrate, is lifted up, the object warps and hence the peripheral portion of the object contacts the ceramic substrate 61 so that free particles are generated.

When the ceramic heater 60 having these through holes 65 is used to heat an object to be heated such as a semiconductor wafer or a liquid crystal substrate, the temperature in the vicinity of the through holes 65 locally becomes low. That is, a cooling spot is generated. This results in a problem that the temperature of the semiconductor wafer, the liquid crystal substrate or the like falls in this portion so that the semiconductor wafer, the liquid crystal substrate or the like is not easily heated evenly.

Furthermore, JP Kokai Hei 4-324276 suggests a ceramic heater in which aluminum nitride, which is a non-oxide ceramic having a high thermal conductivity and a large strength, is used as a substrate; heating elements and conductor filled through holes made of tungsten are made in this aluminum nitride substrate; and Nichrome wires as external terminals are brazed thereto.

Since such a ceramic heater has a ceramic substrate having a large mechanical strength at high temperatures, the thickness of the ceramic substrate can be made small to make the heat capacity small. As a result, the temperature of the ceramic substrate can be caused to follow change in the voltage or electric current quantity promptly.

A ceramic heater as described above adopts a means for bonding a cylindrical ceramic with a disk-like ceramic to protect wires such as external terminals from reactive gas, halogen gas and the like used in a semiconductor producing step, as described in Japanese Patent gazette Nos. 2525974 and 2783980, and JP Kokai 2000-114355.

However, in the case that the ceramic heater described in Japanese Patent gazette No. 2525974 is used, it is exposed to reactive gas, halogen gas and the like for a long time and thermal stress concentrates on the bonding interface between the cylindrical ceramic and the disk-like ceramic, (which may be referred to as the interface hereinafter). Thus, by repeating temperature-rising and temperature-dropping thereof, thermal fatigue is generated, thereby causing a problem that cracks and the like are generated in the interface and air-tightness of the interface deteriorates so that the wires such as the external terminals are corroded.

In the ceramic heater described in Japanese Patent gazette No. 2783980, in the interface thereof, the ceramic particles grow to extend to both sides of the interface, whereby the cylindrical ceramic is bonded to the disk-like ceramic. Therefore, the bonding strength of the interface is strong but thermal stress concentrates locally. Thus, by repeating temperature-rising and temperature-dropping thereof, thermal fatigue is generated so that cracks and the like may be generated in the interface, the cylindrical ceramic, or the disk-like ceramic.

For recent semiconductor products, it is required to shorten a time necessary for throughput. Thus, it is strongly required to shorten a time for rising or dropping the temperature thereof. However, in the ceramic heaters described in Japanese Patent gazette No. 2525974, JP Kokai Hei 2000-114355 and so forth, a flange portion is formed in the cylindrical ceramic, thereby causing a problem that the thermal capacity increases and temperature-rising speed drops.

In order to shorten the temperature-rising time, it is necessary to increase the temperature-rising speed. In order to shorten the temperature-dropping time, it is necessary to rise the temperature-dropping speed. However, if the temperature of the ceramic heater is abruptly risen or dropped, larger thermal stress is generated in the interface and the like. Thus, cracks and the like as described above become easy to be generated increasingly.

### Summary of the Invention

The present invention has been made in view of the above-mentioned problems. An object thereof is to provide a ceramic heater capable of stably supporting an object to be heated, such as a semiconductor wafer, a liquid crystal substrate and the like, and evenly heating the semiconductor wafer or the like.

Another object of the present invention is to provide a ceramic heater which prevents the generation of cooling spots, and causes no drop in the temperature of a semiconductor wafer, a liquid crystal substrate and the like in the vicinity of through holes formed in a ceramic substrate so that the object to be heated, such as the semiconductor wafer, the liquid crystal substrate and the like can be evenly heated.

Still another object of the present invention is to provide a ceramic bonded body capable of keeping sufficient air-tightness and largely improving the reliability thereof because of the face that no thermal stress concentrates locally in the bonding interface between a ceramic body having a given shape such as a cylindrical shape or a columnar shape and a disk-like ceramic so that no cracks and the like are generated in this portion.

In order to attain the above-mentioned objects, a ceramic heater according to the first aspect of the present invention comprises: a disk-like ceramic substrate; a heating element formed on a surface of or inside the above-mentioned ceramic substrate; and through holes for letting lifter pins pass through at the above-mentioned ceramic substrate, wherein three or more of the above-mentioned through holes are formed, and the above-mentioned through holes are formed in an area whose distance from the center of the above-mentioned ceramic substrate is 1/2 or more of the distance from the center of the above-mentioned ceramic substrate to the outer edge of the above-mentioned ceramic substrate.

According to the above-mentioned ceramic heater, the three or more through holes are present in the peripheral portion of the ceramic substrate; therefore, the lifter pins, which are passed through the through holes, are also present in the peripheral portion of the ceramic substrate and do not concentrate in the central portion so that a semiconductor wafer or the like supported by the lifter pins does not become unstable. As a result, even if impact and the like are caused when the ceramic heater is used, the semiconductor wafer or the like does not easily get out of position. Thus, an object to be heated, such as the semiconductor wafer, can be stably supported by the lifter pins.

In the case that the semiconductor wafer or the like is heated to rise the temperature thereof, a difference in the thermal capacity per unit area (volume) between the central portion of the ceramic substrate and the peripheral portion thereof turns into a substantially negligible degree. As a result, the thermal capacity per unit volume (area) in the central portion of the ceramic substrate becomes almost equivalent to that in the peripheral portion. Thus, the semiconductor wafer or the like can be evenly heated even at the temperature-rising time thereof (at the transition time).

Furthermore, in the case that the through holes are present in the vicinity of the center, a plate-form object to be heated, such as a semiconductor wafer or a liquid crystal substrate, warps when the plate-form object is pushed up by the lifter pins. Thus, the outer circumference of the plate-form object scrubs the ceramic substrate surface so that free particles are generated. However, according to the ceramic heater of the first aspect of the present invention, such a problem is not caused.

It is desired that the through holes are formed at substantially regular intervals on a single circle having a concentric circle relationship with the above-mentioned ceramic substrate. Since the lifter pins passed through the through holes are widely dispersed on the ceramic substrate and are arranged at regular intervals, a semiconductor wafer or the like can be more stably supported. Moreover, the semiconductor wafer or the like can be kept more horizontally so that the distance between the ceramic substrate and the semiconductor wafer or the like is made constant. As a result, the semiconductor wafer or the like can be more evenly heated.

A ceramic heater according to a second aspect of the present invention comprises: a disk-like ceramic substrate; a heating element formed on a surface of or inside the above-mentioned ceramic substrate; and through holes for letting lifter pins pass through at the above-mentioned ceramic substrate, wherein the diameter of each of the above-mentioned through holes on a heating face side for heating an obj ect to be heated is larger than the diameter of the above-mentioned through hole on the side opposite to the above-mentioned heating face.

In case the ceramic heater is provided with the through holes for passing the lifter pins through, the temperature around side walls of the through holes drops since the side walls of the through holes usually contact gas having a lower temperature than the substrate itself. As a result, cooling spots are generated in the heating face.

When a semiconductor wafer, a liquid crystal substrate or the like is put on this ceramic heater, in the cooling spots heat is taken away by the cooling spots; therefore, the temperature in this portion drops so that evenness in the temperature of the semiconductor wafer, the liquid crystal substrate and the like is lost.

However, according to the ceramic heater of the second aspect of the present invention, the diameter of each of the above-mentioned through holes on a heating face side for heating an object to be heated is larger than the diameter of the above-mentioned through hole on the side opposite to the above-mentioned heating face; thus, no solid constituting the substrate is present in portions where cooling spots are generated. As a result, the occupation ratio of space becomes large so that the heat capacity thereof gets small. Accordingly, the temperature of the semiconductor wafer, the liquid crystal substrate and the like of the portion in the vicinity of the formed through holes hardly drops, so that the object to be heated, such as the semiconductor wafer or the liquid crystal substrate and the like, can be more evenly heated.

Regarding the through holes with a diameter on the heating face side being larger than that on the bottom face side, in case the through holes are constituted so as to have a columnar portion and a diameter-increasing portion having the diameter becoming larger as the portion is closer to the heating face, that is, so as to have a funnel shape, gas having accumulated heat remains in the funnel-shaped portion and cooling spots themselves are not enlarged. Thus, the object to be heated, such as the semiconductor wafer or the liquid crystal substrate, can be more evenly heated.

Since the through holes having the above-mentioned shape can be relatively easily formed with a drill and the like, the through holes can be effectively formed.

The wafer or the like is heated while the space of the above-mentioned diameter-increasing portion is not filled. This is because when the diameter-increasing portion is filled with a filling member, the ceramic and the filling member are rubbed with each other so that free particles are generated.

Further, a ceramic bonded body according to a third aspect of the present invention includes: a disk-like ceramic substrate inside which a conductor is provided; and a ceramic body bonded to the bottom face of the above-mentioned ceramic substrate, wherein the center of an area surrounded by the interface between the above-mentioned ceramic body and the above-mentioned ceramic substrate or the center of an area constituted by the interface between the above-mentioned ceramic body and the above-mentioned ceramic substrate is 3 to 200 µm apart from the center of the bottom face of the above-mentioned ceramic substrate.

In the ceramic bonded body according to the third aspect of the present invention, the ceramic body may be a columnar body or a plate-form body, or may be a hollow body such as a cylindrical body, or may be a filled body having a ceramic-filled structure, which has no cavity inside.

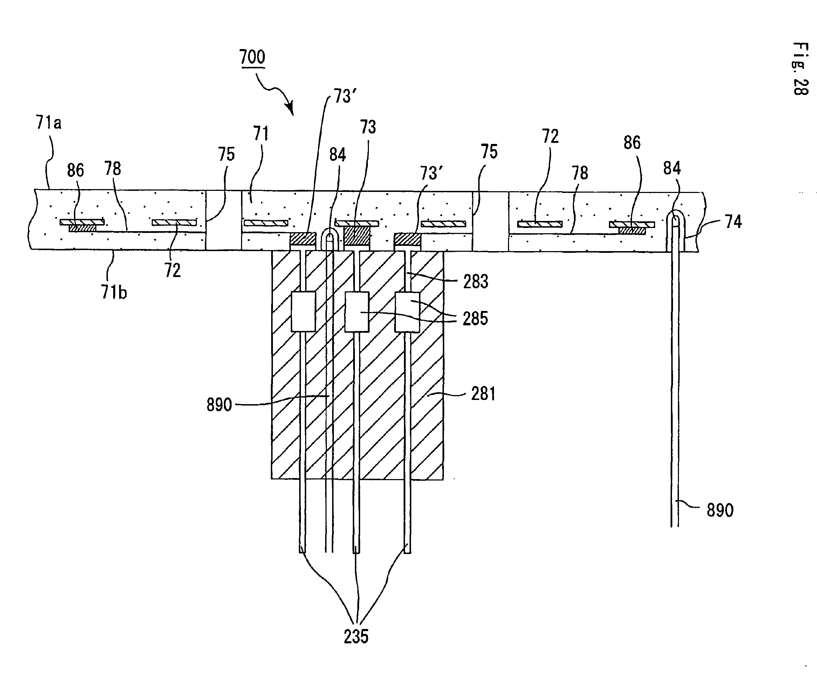

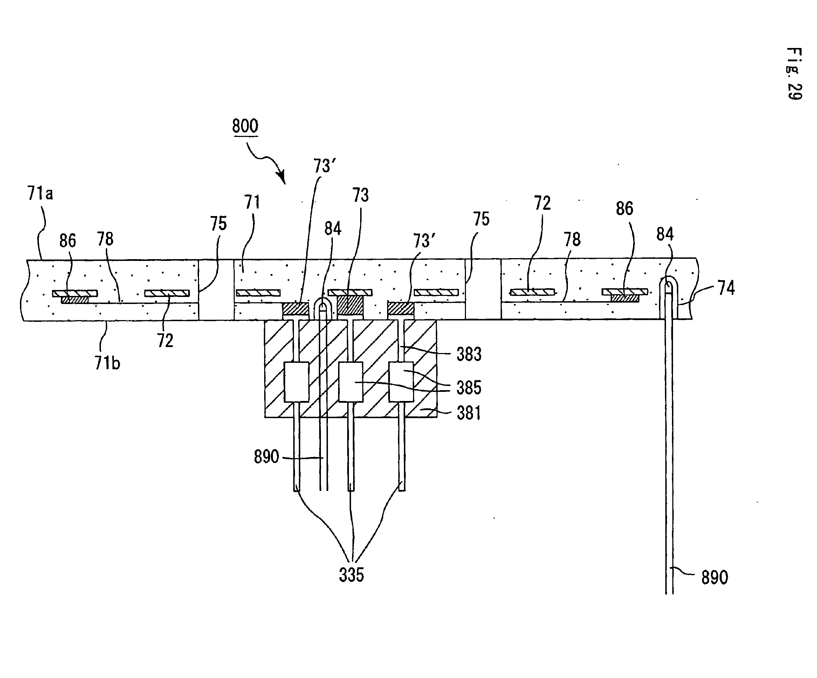

Fig. 28 is a sectional view which schematically illustrates a ceramic bonded body 700 using a ceramic body 281 made of a filled body. In the ceramic body 281 made of the filled body, external terminals 283 having sockets 285, and conductive wires 235 are embedded, and further a lead wire 890 of a temperature measuring element 84 is also embedded. Fig. 29 is a sectional view which schematically illustrates a ceramic bonded body 800 using a ceramic body 381 made of a plate-form body. In the ceramic body 381 made of the filled body, external terminals 383 having sockets 385, and conductive wires 335 are embedded, and further a lead wire 890 of a temperature measuring element 84 is also embedded.

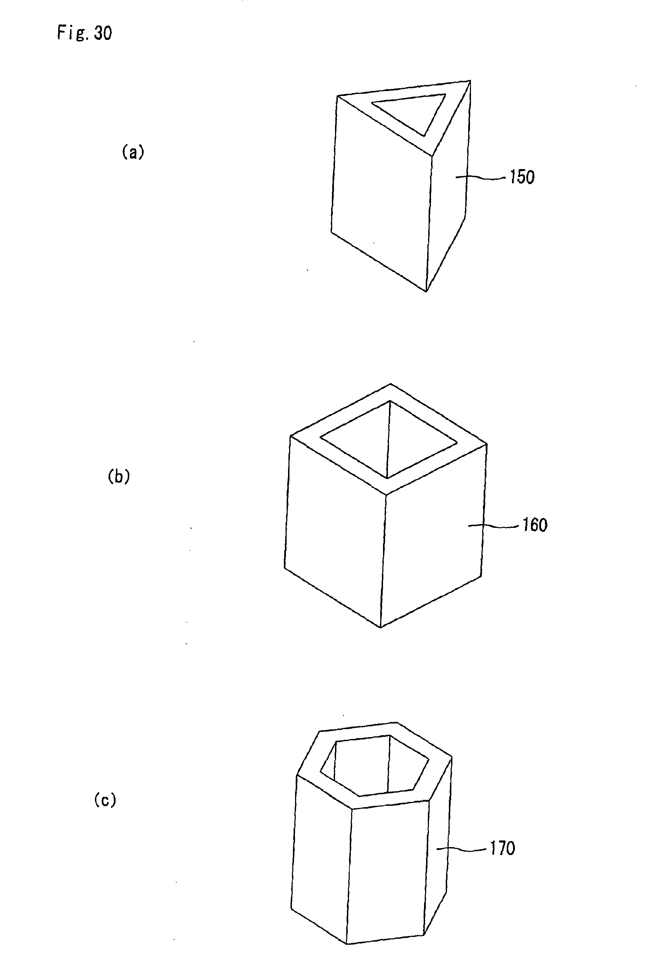

In the case of the columnar body, it may be a triangle pole body 150 or a square pole body 160 or may be a polygonal pole body 170, as illustrated in Figs. 30(a) to 30(c).

In the third aspect of the present invention, the center of the area surrounded by the interface between the ceramic body and the ceramic substrate, or the center of the area constituted by the interface between the ceramic body and the ceramic substrate means the centroid of a figure constituted by being surrounded by the interface, or the centroid of a figure constituted by the interface itself.

The centroid is defined as intersection points of straight lines for dividing a figure into two exact halves. In the case of a circle, the center of the circle is the centroid.

The most preferred example of the present invention is a ceramic bonded body including: a disk-like ceramic substrate inside which a conductor is provided; and a ceramic body bonded to the bottom face of the ceramic substrate, wherein
the center of a circle surrounded by the interface between the cylindrical ceramic body and the ceramic substrate is 3 to 200 µm apart from the center of the bottom face of the ceramic substrate. Thus, this ceramic bonded body will be described hereinafter.

For example, in the case of heating a ceramic bonded body wherein the center of a circle surroundedby the interface between a cylindrical ceramic body and a ceramic substrate, (which may be referred to the center A hereinafter), is consistent with the center of the bottom face of the ceramic substrate, (which may be referred to as the center B hereinafter), the direction along which the cylindrical ceramic body expands is consistent with the direction along which the ceramic substrate expands in the above-mentioned interface. As a result, thermal stress concentrates locally so that thermal fatigue is generated. Thus, cracks and the like are generated.

However, according to the third aspect of the present invention, that is, the ceramic bonded body wherein the distance between the center A and the center B, (which may be referred to as the distance L) , is from 3 to 200 µm apart, when it is heated, the direction along which the cylindrical ceramic body expands is different from the direction along which the ceramic substrate expands. As a result, thermal stress can be dispersed so that the generation of cracks and the like can be prevented.

In the ceramic bonded body having a distance L of less than 3 µm, it is difficult to disperse thermal stress sufficiently.

If the distance L exceeds 200 µm, thermal stress is conversely concentrated so that cracks are easily generated. Furthermore, the temperature distribution in the face for heating a semiconductor wafer gets large.

It is desired that the above-mentioned conductor is a heating element and the ceramic bonded body functions as a ceramic heater.

As described above, this ceramic bonded body has a structure capable of dispersing thermal stress so that the thermal stress does not concentrate locally. Thus, even if temperature-rising and temperature-dropping thereof are repeated, no thermal fatigue is generated. In the ceramic bonded body, a flange portion need not be formed in the bonding face between the cylindrical ceramic body and the ceramic substrate. Therefore, the thermal capacity does not increase so that the temperature-dropping speed is not lowered. For this reason, the ceramic bonded body can be suitably used as a ceramic heater.

The heating element may be formed into a layer form or into a line form.

Moreover, it is desired that the above-mentioned conductor is an electrostatic electrode and the above-mentioned ceramic bonded body functions as an electrostatic chuck.

This is because any electrostatic chuck is used in a corrosive atmosphere in many cases and a constitution wherein the ceramic substrate and the cylindrical ceramic body are bonded to each other as described above is optimal for this chuck.

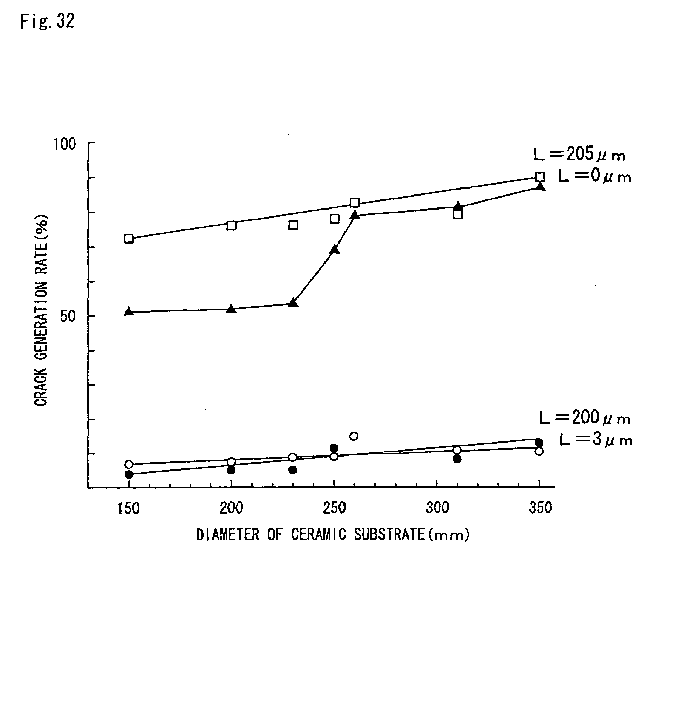

Additionally, the ceramic substrate desirably has a diameter of 250 mm or more. If the diameter of the ceramic substrate is 250 mm or more, the effects of the third aspect of the present invention, i.e., the effects of dispersing thermal stress and preventing the generation of cracks and the like get larger. This fact can easily be understood from Fig. 32, which shows results of Examples. That is, in the case of the distance L = 0, the generation rate of the cracks is higher as the diameter is larger. When the diameter exceeds 250 mm, the rate abruptly becomes large. However, by setting L to 3 µm or 200 µm, the crack generation rate can be suppressed at a low level.

### Brief Description of the Drawings

Fig. 1 is a bottom face view which schematically illustrates a ceramic heater of a first aspect of the present invention.
Fig. 2 is a partially enlarged sectional view of the ceramic heater illustrated in Fig. 1.
Fig. 3 is a bottom face view which schematically illustrates another example of the ceramic heater according to the first aspect of the present invention.
Fig. 4 is a partially enlarged sectional view of the ceramic heater illustrated in Fig. 3.
Figs. 5(a) to 5(d) are sectional views which schematically illustrate some parts of the process for producing the ceramic heater illustrated in Fig. 1.
Figs. 6(a) to 6(d) are sectional views which schematically illustrate some parts of the process for producing the ceramic heater illustrated in Fig. 3.
Fig. 7 is a graph showing a relationship between temperature difference when temperature is risen up and the position of a through hole.
Fig. 8 is a graph showing a relationship between the number of free particles and the position of a through hole.
Fig. 9 is a bottom face view which schematically illustrates a ceramic heater of a second aspect of the present invention.
Fig. 10 is a partially enlarged sectional view of the ceramic heater illustrated in Fig. 9.
Fig. 11 is a bottom face view which schematically illustrates another example of the ceramic heater of the second aspect of the present invention.
Fig. 12 is a partially enlarged sectional view of the ceramic heater illustrated in Fig. 11.
Figs. 13 (a) to 13(d) are sectional views which schematically illustrate some parts of the process for producing the ceramic heater illustrated in Fig. 9.
Figs. 14(a) to 14(d) are sectional views which schematically illustrate some parts of the process for producing the ceramic heater illustrated in Fig. 11.
Fig. 15 is a bottom face view of a conventional ceramic heater.
Fig. 16 is a graph showing a relationship between temperature difference (ΔT) in a silicon wafer when being heated with a ceramic heater according to Example 4 and (the diameter of its diameter-increasing portion in its heating face)/(the diameter of its columnar portion).
Fig. 17(a) is a plan view which schematically illustrates a ceramic bonded body according to a third aspect of the present invention, and Fig. 17 (b) is a sectional view of the ceramic bonded body illustrated in Fig. 17 (a).
Fig. 18 is a bottom face view which schematically illustrates a ceramic bonded body of the third aspect of the present invention.
Fig. 19 is a sectional view of the ceramic bonded body of the third aspect of the present invention.
Fig. 20 is a partially enlarged sectional view which schematically illustrates a ceramic substrate constituting the ceramic bonded body of the third aspect of the present invention.
Fig. 21 is a vertically sectional view which schematically illustrates a ceramic substrate constituting an electrostatic chuck which is an example of the ceramic bonded body of the third aspect of the present invention.
Fig. 22 is a partially enlarged sectional view which schematically illustrates a ceramic substrate constituting the electrostatic chuck illustrated in Fig. 21.
Fig. 23 is a horizontally sectional view which schematically illustrates an example of an electrostatic electrode embedded in the ceramic substrate.
Fig. 24 is a horizontally sectional view which schematically illustrates another example of the electrostatic electrode embedded in the ceramic substrate.
Fig. 25 is a horizontally sectional view which schematically illustrates still another example of the electrostatic electrode embedded in the ceramic substrate.
Figs. 26(a) to 26(d) are sectional views which schematically illustrate an example of the process for producing a ceramic heater which is an example of the ceramic bonded body of the third aspect of the present invention.
Fig. 27 is a perspective view which schematically illustrates an example of the method for bonding a ceramic substrate and a cylindrical ceramic body.
Fig. 28 is a sectional view which schematically illustrates an example of the ceramic bonded body of the third aspect of the present invention.
Fig. 29 is a sectional view which schematically illustrates an example of the ceramic bonded body of the third aspect of the present invention.
Figs. 30(a) to 30(c) are perspective views which illustrate examples of a columnar body constituting the ceramic bonded body of the third aspect of the present invention.
Fig. 31 is a graph showing results of Test Examples.
Fig. 32 is a graph showing results of Comparative Examples 9 and 10 and Examples 15 and 16.

### Explanation of symbols

- 10, 20, 30, 40, 70: ceramic heater
- 11, 21, 31, 41, 71, 91: ceramic substrate
- 11a, 21a, 31a, 41a, 71a: heating face
- 11b, 21b, 31b, 41b, 71b: bottom face
- 12, 22, 32, 42, 72: heating element
- 120, 320: conductor containing paste layer
- 130, 330: filled layer
- 13, 23, 33, 43: external terminal
- 13a, 33a, 73, 73': conductor filled through hole
- 13b, 33b, 79: blind hole
- 14, 24, 34, 44, 74: bottomed hole
- 15, 25, 35, 45, 75: through hole
- 16, 26, 36, 46: lifter pin
- 220, 420: metal covering layer
- 39, 59: semiconductor wafer
- 50, 100, 500: green sheet
- 77: cylindrical ceramic body

### Detailed Disclosure of the Invention

First, a ceramic heater according to a first aspect of the present invention will be described.

The ceramic heater according to a first aspect of the present invention includes a disk-like ceramic substrate; a heating element formed on a surface of or inside the above-mentioned ceramic substrate; and through holes for letting lifter pins pass through at the above-mentioned ceramic substrate, wherein three or more of the above-mentioned through holes are formed, and the above-mentioned through holes are formed in an area whose distance from the center of the above-mentioned ceramic substrate is 1/2 or more of the distance from the center of the above-mentioned ceramic substrate to the outer edge of the above-mentioned ceramic substrate.

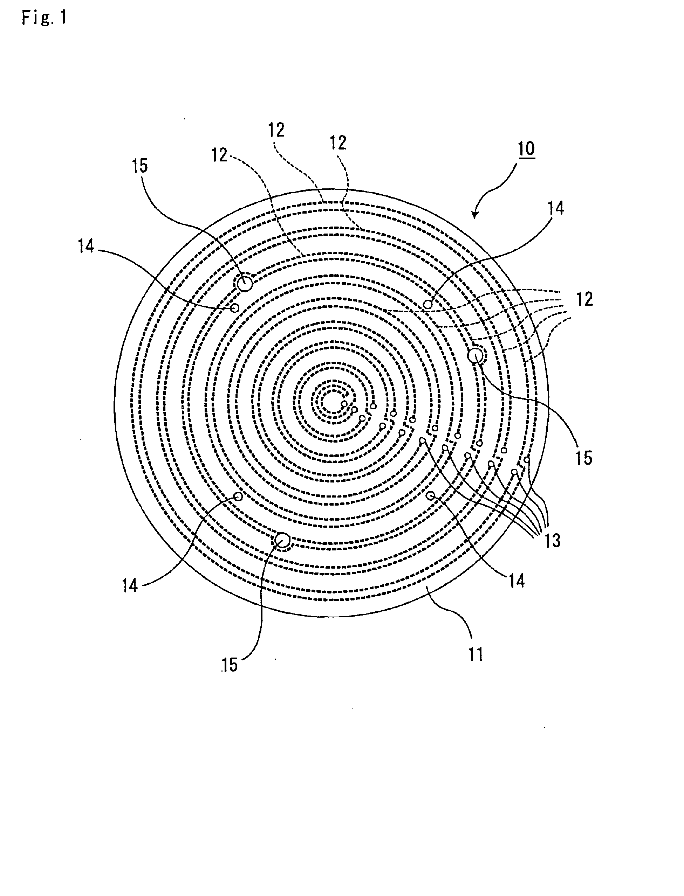

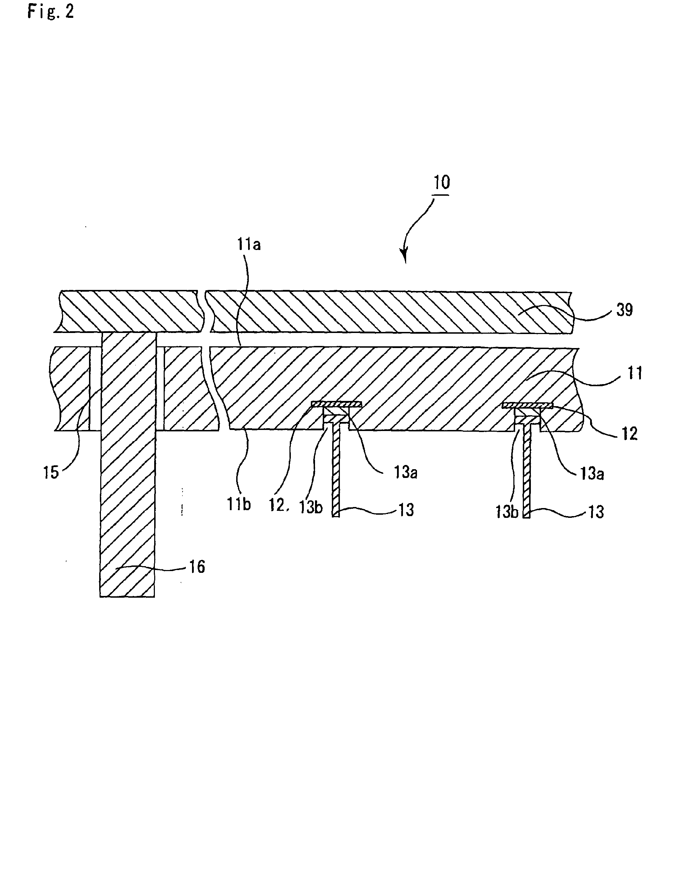

Fig. 1 is a bottom face view which schematically illustrates a ceramic heater according to the first aspect of the present invention. Fig. 2 is a partially enlarged sectional view which schematically illustrates the ceramic heater in Fig. 1. In this ceramic heater, heating elements are formed inside its ceramic substrate.

In the ceramic heater 10, the ceramic substrate 11 is formed in a disk-like form. In order to heat the ceramic heater in such a manner that the temperature in the whole of a heating face 11a of the ceramic heater 10 is made even, the heating elements 12 which has a concentrically circular pattern are formed inside the ceramic substrate 11.

Conductor-filled through holes 13a are formed just under ends of heating elements 12, and further blind holes 13b for making the conductor-filled through holes 13a exposed are formed in the bottom face 11b. An external terminal 13 is inserted into the blind hole 13b, and they are bonded to each other with a brazing material and the like (not illustrated). For example, a socket (not illustrated) having a conductive wire is fitted to the external terminal 13. This conductive wire is connected to a power source and the like.

In the bottom face of the ceramic substrate 11, bottomed holes 14 for inserting temperature measuring elements (not illustrated) into are formed.

Furthermore, in the ceramic substrate 11, three through holes 15, for passing lifter pins 16 through, are formed at regular intervals on a circle whose distance from the center of the ceramic substrate 11 is 55% of the distance from the center to the outer edge thereof.

By moving the lifter pins 16 up and down, a semiconductor wafer or the like can be relatively easily received from the previous line, and the semiconductor wafer or the like can be carried to the next line.

Since the semiconductor wafer or the like is not rubbed with the ceramic substrate, no free particles are generated fromthe ceramic substrate.

When the semiconductor wafer 39 is heated, the semiconductor wafer 39 can be held and heated in the state that the wafer is a given distance apart, through the lifter pins 16, from the heating face 11a of the ceramic substrate 11 by being held by the lifter pins 16 in the state that the pins project slightly from the heating face 11a of the ceramic substrate 11.

By arranging a member having proj ected structures, such as pins, on the surface of the ceramic substrate, the semiconductor wafer or the like can be heated in the state that the semiconductor wafer or the like is apart from the heating face of the ceramic substrate in the same manner as in the case of holding the lifter pins in the state that the lifter pins project slightly from the heating face of the ceramic substrate.

In the ceramic heater according to the first aspect of the present invention, the.heating elements may be formed inside the ceramic substrate or may be formed outside the ceramic substrate.

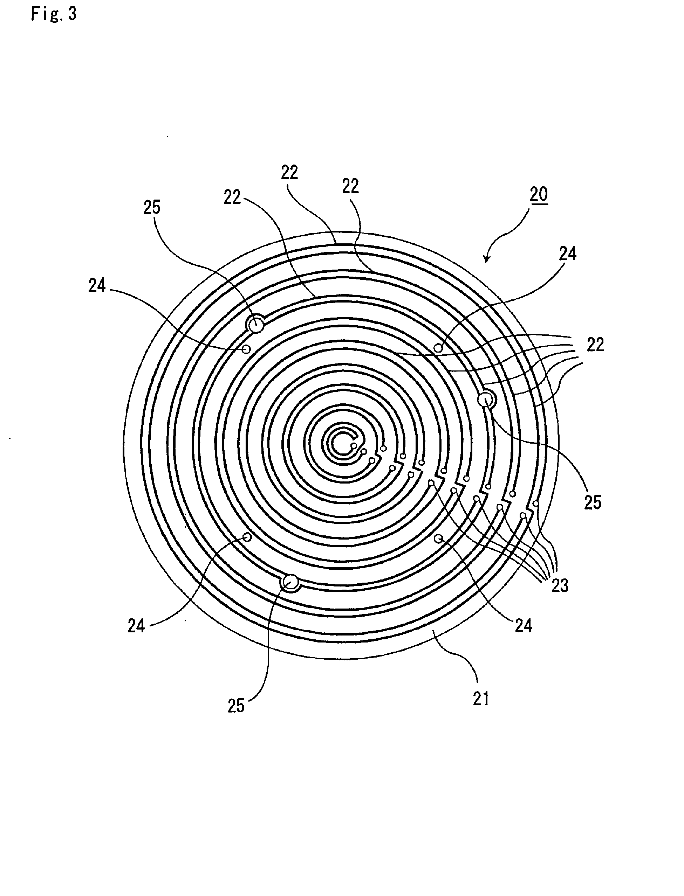

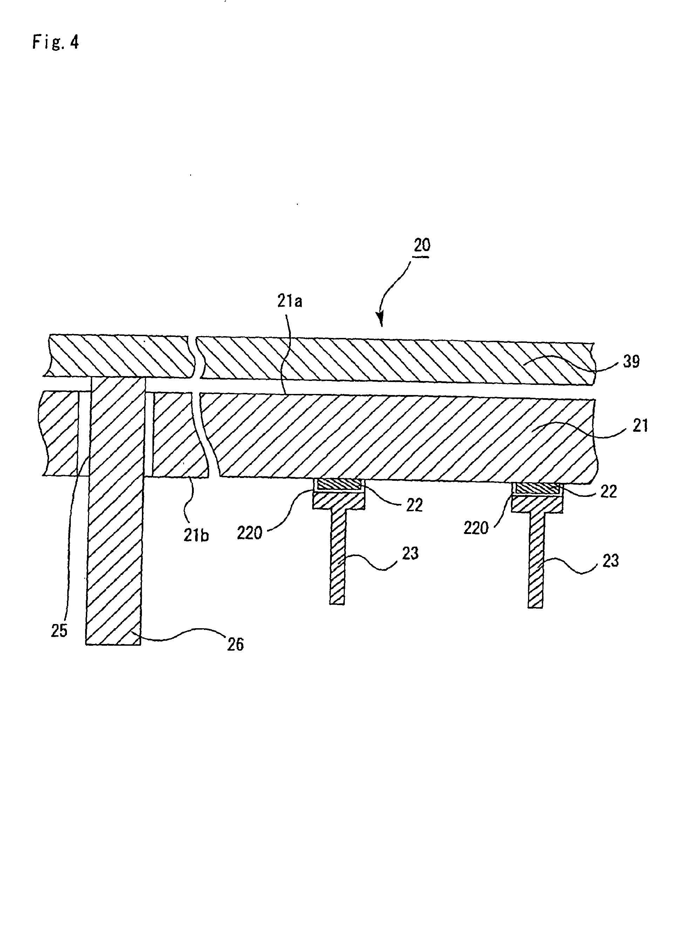

Fig. 3 is a bottom face view which schematically illustrates another example of the ceramic heater according to the first aspect of the present invention. Fig. 4 is a partially enlarged sectional view of the ceramic heater in Fig. 3. In this ceramic heater, heating elements are formed on a surface of the ceramic substrate.

In the ceramic heater 20, its ceramic substrate 21 is formed in a disk-like form, and heating elements 22 having a concentrically circular pattern are formed on the surface of the ceramic substrate 21. External terminals 23, which are terminals for input and output, are connected through a metal covering layer 220 to both ends of the heating element.

In the bottom face of the ceramic substrate 21, bottomed holes 24, for inserting temperature measuring elements (not illustrated) into, are formed.

Additionally, in the ceramic substrate 21 are formed three through holes 25 at regular intervals on a circle whose distance from the center of the ceramic substrate 21 is 75% of the distance from the center to the outer edge of the ceramic substrate.

In the same way as in ceramic heater 10, in the ceramic heater 20, lifter pins 26 are passed through the through holes 25 and moved up and down, whereby a semiconductor wafer or the like can be carried. Moreover, the lifter pins 26 are caused to project from a heating face 21a of the ceramic substrate 21, whereby the semiconductor wafer 39 is held apart from the ceramic substrate 21a.

In the ceramic substrate according to the first aspect of the present invention, the number of the through holes formed in the ceramic substrate is three or more. If the number of the through holes is less than 3, that is, 2 or less, it is difficult to support an object to be heated, such as the semiconductor wafer, stably by the lifter pins passed through the through holes. The number of the through holes is not particularly limited if the number is 3 or more. However, the number of the through holes formed in the ceramic substrate is desirably 11 or less in order to suppress the generation of cooling spots when the ceramic heater is used.

The position of the through hole is not particularly limited if the through hole is formed in an area whose distance from the center of the ceramic substrate is 1/2 or more of the distance from the center to the outer edge of the ceramic substrate.

However, in order to keep the semiconductor wafer or the like horizontal, the through hole is desirably formed in an area whose distance from the center of the ceramic substrate is from 50 to 75% of the distance from the center to the outer edge thereof. In the case that the through hole is formed in an area whose distance from the center of the ceramic substrate exceeds 75% of the distance from the center to the outer edge thereof, the semiconductor wafer or the like can be stably supported but it is apprehended that the semiconductor wafer or the like warps since the central portion thereof is not supported.

From the viewpoint that the semiconductor wafer or the like can be more stably supported and can be more evenly heated, the through holes are desirably formed at substantially regular intervals on a single circle having a concentric circle relationship with the ceramic substrate. Since the lifter pins passed through the through holes are widely dispersed in the ceramic substrate and arranged at regular intervals, the semiconductor wafer or the like can be more stably supported and kept in more horizontal manner so that the distance between the ceramic substrate and the semiconductor wafer or the like becomes constant. As a result, the semiconductor wafer or the like can be more evenly heated.

In the case that three through holes described above are formed, the arrangement of the through holes is, for example, as follows: as illustrated in Fig. 1, an arrangement in which three through holes 15 are formed at regular intervals on a single circle having a concentric circle relationship with the ceramic substrate in an area whose distance from the center of the ceramic substrate 11 is 1/2 or more of the distance from the center to the outer edge thereof. In the case that four through holes are formed, an example of the arrangement thereof is an arrangement in which four through holes are formed at regular intervals on a single circle having a concentric circle relationship with the ceramic substrate in the same area.

In the case that four or more through holes are formed in the ceramic substrate, one of the through holes may be formed at the center of the ceramic substrate. When the semiconductor wafer or the like is held apart from the ceramic substrate by the lifter pins and heated, the central portion of the semiconductor wafer or the like can be prevented from being warped. As a result, the distance between the semiconductor wafer or the like and the ceramic substrate is formed constant so that the semiconductor wafer or the like can be evenly heated.

When the semiconductor wafer or the like is held apart by the lifter pins and heated, the height of the lifter pins passed through the through holes, projecting from the heating face of the ceramic substrate, is desirably from 5 to 5000 µm, that is, the semiconductor wafer or the like is desirably held in the state that the semiconductor wafer or the like is from 5 to 5000 µm apart from the heating face of the ceramic substrate. If the height is less than 5 µm, the temperature of the semiconductor wafer or the like is affected by the temperature distribution in the ceramic substrate and made uneven. If the height exceeds 5000 µm, the temperature of the semiconductor wafer or the like does not rise easily. As a result, in particular, the temperature of the peripheral portion of the semiconductor wafer or the like becomes low.

The object to be heated and the heating face of the ceramic substrate are desirably from 5 to 500 µm, more desirably from 20 to 200 µm apart from each other.

The shape of the through holes and the lifter pins, as viewed in plan, is usually a circular shape. About the through holes, their diameter on the heating face side, which heats the obj ect to be heated, may be larger than that on the bottom face side. This is because the heat capacity of the portion where cooling spots are easily generated can be largely lowered so that the semiconductor wafer can be more evenly heated.

Furthermore, the diameter of the through holes is desirably from 1 to 100 mm, more desirably from 1 to 20 mm. If the diameter is less than 1 mm, the semiconductor wafer or the like cannot be stably put on the lifter pins since the lifter pins passed through the through holes are too thin. On the other hand, if the diameter exceeds 100 mm, cooling spots are generated in the heating face of the ceramic heater since the through holes are too large. As a result, it is apprehended that the semiconductor wafer or the like cannot be evenly heated.

The diameter of the lifter pins is desirably substantially equal to that of the through holes for letting the lifter pins pass through. When the diameter of the lifter pins is largely different from that of the through holes, that is, when the diameter of the lifter pins is far smaller than that of the through holes, gaps are generated between the lifter pins and the side walls of the through holes. Accordingly, heat is radiated from the gaps so that cooling spots are generated in the heating face of the ceramic heater. Thus, it is apprehended that the semiconductor wafer or the like cannot be evenly heated.

In the ceramic heater according to the first aspect of the present invention, the diameter of the ceramic substrate is desirably 200 mm or more for the following reason: as the diameter of the ceramic heater is larger, the semiconductor wafer or the like having a larger diameter, which warps more easily, can be placed; therefore, the constitution of the first aspect of the present invention functions effectively.

The diameter of the ceramic substrate is desirably 12 inches (300 mm) or more. This size is a size which becomes the main current of semiconductor wafers in the next generation.

The thickness of the ceramic substrate is desirably 25 mm or less. This is because the temperature-following character deteriorates if the thickness of the ceramic substrate exceeds 25 mm. The thickness is desirably 0.5 mm or more. If the thickness is less than 0.5 mm, the ceramic substrate is more easily broken since the strength itself of the ceramic substrate drops. More desirably, the thickness exceeds 1.5 and 5 mm or less. If the thickness is more than 5 mm, heat is not easily conducted so that the heating efficiency trends to deteriorate. On the other hand, if the thickness is 1.5 mm or less, a temperature distribution is generated in the heating face since heat conducted in the ceramic substrate does not diffuse sufficiently. Additionally, the strength of the ceramic substrate drops so that it may be broken.

In the ceramic heater according to the first aspect of the present invention, it is desired that a bottomed hole extending from the side opposite to the heating face, on which an object to be heated are put, to the heating face is formed in the ceramic substrate and further the bottom of the bottomed hole is formed relatively closer to the heating face than to the heating elements and a temperature measuring element (not illustrated), such as a thermocouple, is fitted to this bottomed hole.

The distance between the bottom of the bottomed hole and the heating face is desirably from 0.1 mm to 1/2 of the thickness of the ceramic substrate.

In this way, a temperature-measuring position is closer to the heating face than the heating elements, so that the temperature of the semiconductor wafer or the like can be more precisely measured.

If the distance between the bottom of the bottomed hole and the heating face is less than 0.1 mm, heat is radiated at the point so that a temperature distribution is formed in the heating face. If the distance exceeds 1/2, the ceramic substrate is easily affected by the temperature of the heating elements so that temperature-control cannot be performed. Thus, a temperature distribution is formed as well in the heating face.

The diameter of the bottomed hole desirably ranges from 0.3 to 5 mm. If the diameter is too large, the heat-radiating property becomes large. If the diameter is too small, the workability deteriorates so that the distance to the heating face cannot be made even.

A plurality of the bottomed holes are desirably arranged symmetrically with the center of the ceramic substrate and arranged into a cross form. This is because temperatures in the entire heating face can be measured.

Examples of the temperature measuring element include a thermocouple, a platinum temperature measuring resistor, a thermistor and the like.

Examples of the thermocouple include K, R, B, S, E, J and T type thermocouples, as described in JIS-C-1602 (1980). Of these, the K type thermocouple is preferred.

Desirably, the size of the connecting part of the thermocouple is equal to or more than the strand diameter thereof, and is 0.5 mm or less. This is because if the connecting part is large, the heat capacity is large so that the responsibility deteriorates. It is difficult that the size is made smaller than the strand diameter.

The above-mentioned temperature measuring element may be bonded to the bottom of the bottomed hole with brazing gold, brazing silver and the like or, the above-mentioned temperature measuring element may be inserted into the bottomed hole followed by the step of sealing the bottomed holes with a heat-resistant resin. The two may be used together. Examples of the heat-resistant resin include thermosetting resins, in particular, epoxy resin, polyimide resin, bismaleimide-triazine resin and the like. These resins may be used alone or in combination of two or more.

As the above-mentioned brazing gold, desired is at least one selected from an alloy of 37 to 80.5% by weight of Au and 63 to 19.5% by weight of Cu, and an alloy of 81.5 to 82.5% by weight of Au and 18.5 to 17.5% by weight of Ni. These have a melting temperature of 900°C or more, and are not easily melted in high temperature regions.

Examples of the brazing silver include Ag-Cu types.

The material of the ceramic substrate constituting the ceramic heater according to the first aspect of the present invention is not particularly limited. For example, a nitride ceramic or a carbide ceramic is desirable. Since a nitride ceramic or a carbide ceramic has a smaller thermal expansion coefficient than metals and a far higher mechanical strength than metals, the ceramic substrate thereof does not warp or bend even if the thickness thereof is made small. Therefore, the ceramic substrate can be made thin and light. Since the thermal conductivity of the ceramic substrate is high and the ceramic substrate itself is thin, the surface temperature of the ceramic substrate follows temperature change in the heating elements promptly. That is, the surface temperature of the ceramic substrate can be controlled by changing voltage or electric current quantity to change the temperature of the heating elements.

Examples of the nitride ceramic include aluminum nitride, silicon nitride, boron nitride, titanium nitride and the like. These may be used alone or in combination of two or more.

Examples of the carbide ceramic include silicon carbide, zirconium carbide, titanium carbide, tantalum carbide, tungsten carbide and the like. These may be used alone or in combination of two or more.

Of these, aluminum nitride is most preferred. This is because its thermal conductivity is highest, that is, 180 W/m · K and aluminum nitride has superior temperature-following character.

When a nitride ceramic, a carbide ceramic and the like are used as the ceramic substrate, an insulating layer maybe formed if necessary. About a nitride ceramic, the volume resistance value thereof drops easily at high temperatures by solid-solution of oxygen and the like, and a carbide ceramic has an electric conductivity so far as the ceramic is not made into high purity. By making the insulating layer, a short circuit is prevented between the circuits at high temperatures or even if it contains impurities. Thus, the temperature controllability can be ensured.

The above-mentioned insulating layer is desirably an oxide ceramic. Specifically, silica, alumina, mullite, cordierite, beryllia, and the like can be used.

Such an insulating layer may be formed by spin-coating the ceramic substrate with a sol solution wherein an alkoxide is hydrolyzed and polymerized, and then drying and firing the solution, or by sputtering, CVC and the like. The surface of the ceramic substrate may be subjected to oxidization-treatment to deposit an oxide layer.

The insulating layer is desirably from 0.1 to 1000 µm in thickness. If the thickness is less than 0.1 µm, insulating property cannot be ensured. If the thickness exceeds 1000 µm, heat conductivity from the heating elements to the ceramic substrate is hindered.

Furthermore, the volume resistivity of the insulating layer is desirably 10 or more times larger than that of the above-mentioned ceramic substrate (at the same measurement temperature). In the case of less than 10 times, a short circuit between the circuits cannot be prevented.

It is desired that the ceramic substrate contains carbon and the carbon content is from 200 to 5000 ppm. This is because the electrodes can be concealed and black-body radiation is easily used.

The brightness of the ceramic substrate is desirably N6 or less as a value based on the rule of JIS Z 8721. This is because the ceramic having such a brightness is superior in radiant heat capacity and the property of the concealing.

The brightness N is defined as follows: the brightness of ideal black is made to 0; that of ideal white is made to 10; respective colors are divided into 10 parts in the manner that the brightness of the respective colors is recognized stepwise between the brightness of black and that of white; and the resultant parts are indicated by symbols N0 to N10, respectively.

Actual measurement thereof is performed by comparison with color signals corresponding to N0 to N10. One place of decimals in this case is made to 0 or 5.

When the heating elements are disposed, they may be formed on the surface (bottom face) of the ceramic substrate or may be embedded in the ceramic substrate.

When the heating elements are formed inside the ceramic substrate, it is desired that the heating elements are formed at positions having a distance, from the face opposite to the heating face, of 60% or less of the thickness. In the case of more than 60%, heat conducted in the ceramic substrate does not diffuse sufficiently since the heating elements are too close to the heating face. Thus, a temperature dispersion in the heating face is generated.

When the heating elements are formed inside the ceramic substrate, a plurality of heating element forming layers may be formed. In this case, the patterns of the respective layers are desirably in the state that any one of the heating elements is formed on some layer so as to be complementary to each other and, when viewed from a position above the heating surface, the patterns are formed in all areas. An example of such a structure having a staggered relation.

The heating elements may be set inside the ceramic substrate and the heating elements may be partially formed exposed.

When the heating elements are formed on the surface of the ceramic substrate, the heating face is desirably on the side opposite to the face on which the heating elements are formed. This is because temperature evenness in the heating face can be improved since the ceramic substrate plays a role for thermal diffusion.

When the heating elements are formed on the surface of the ceramic substrate, the following method is preferred: a method of applying a conductor containing paste which contains metal particles to the surface of the ceramic substrate to form a conductor containing paste layer having a given pattern, and firing this to sinter the metal particles on the surface of the ceramic substrate. If the metal particles are melted and adhered to each other and the metal particles and the ceramic are melted and adhered to each other in the sintering of the metal, the sintering is sufficient.

When the heating elements are formed inside the ceramic substrate, the thickness thereof is preferably from 1 to 50 µm. When the heating elements are formed on the surface of the ceramic substrate, the thickness of the heating elements is preferably from 1 to 30 µm, more preferably from 1 to 10 µm.

When the heating elements are formed inside the ceramic substrate, the width of the heating elements is preferably from 5 to 20 µm. When the heating elements are formed on the surface of the ceramic substrate, the width of the heating elements is preferably from 0.1 to 20 mm, more preferably from 0.1 to 5 mm.

The resistance value of the heating elements can be changed dependently on their width or thickness. The above-mentioned ranges are however most practical. The resistance value becomes larger as the heating elements become thinner and narrower. The thickness and the width of the heating elements become larger in the case that the heating elements are formed inside the ceramic substrate. However, when the heating elements are formed inside, the distance between the heating surface and the heating elements becomes short so that the evenness of the temperature in the surface deteriorates. Thus, it is necessary to make the width of the heating elements themselves large. Since the heating elements are formed inside, it is unnecessary to consider the adhesiveness to a nitride ceramic and the like ceramic. Therefore, it is possible to use a high melting point metal such as tungsten or molybdenum, or a carbide of tungsten, molybdenum and the like. Thus, the resistance value can be made high. Therefore, the thickness itself may be made large in order to prevent wire-snapping and so on. For these reasons, the heating elements are desirably formed to have the above-mentioned thickness and width.

By setting the position where the heating elements are formed in this way, heat generated from the heating elements diffuses to the whole of the ceramic substrate while the heat is conducted. Thus, a temperature distribution in the face for heating an object to be heated (a semiconductor wafer or the like) is made even so that the temperatures of respective portions of the object to be heated are made even.

As the pattern of the heating elements in the ceramic heater according to the first aspect of the present invention, for example, a spiral pattern, an eccentrically circular pattern, a pattern of repeated bending lines and the like can be used, as well as the concentrically circular pattern illustrated in Fig. 1. These may be used together.

By making the heating element pattern formed in the outermost circumference into a pattern divided in the circumferential direction, minute temperature control can be attained in the outermost circumference of the ceramic heater, the temperature of which is readily lowered. Thus, any distribution in the temperature of the ceramic heater can be suppressed. Furthermore, the heating element pattern divided in the circumferential direction may be formed not only in the outermost circumference of the ceramic substrate but also inside it.

The heating elements may have a rectangular section or an elliptical section. They desirably have a flat section. From the flat section, heat is more easily radiated toward the heating face. Thus, a temperature distribution in the heating face is not easily generated.

The aspect ratio (the width of the heating element/the thickness of the heating element) of the section is desirably from 10 to 5000.

Adjusting the aspect ratio into this range makes it possible to increase the resistance value of the heating elements and keep the evenness of the temperature in the heating face.

In the case that the thickness of the heating elements is made constant, the amount of heat conducted toward the heating face of the ceramic substrate becomes small if the aspect ratio is smaller than the above-mentioned range. Thus, a heat distribution similar to the pattern of the heating elements is generated in the heating face. On the other hand, if the aspect ratio is too large, the temperature of the portions just above the centers of the heating elements becomes high so that a heat distribution similar to the pattern of the heating elements is generated in the heating face. Accordingly, if temperature distribution is considered, the aspect ratio of the section is preferably from 10 to 5000.

When the heating elements are formed on the surface of the ceramic substrate, the aspect ratio is desirably from 10 to 200. When the heating elements are formed inside the ceramic substrate, the aspect ratio is desirably from 200 to 5000.

The aspect ratio becomes larger in the case that the heating elements are formed inside the ceramic substrate. This is based on the following reason. If the heating elements are formed inside, the distance between the heating face and the heating elements becomes short so that temperature evenness in the surface deteriorates. It is therefore necessary to make the heating elements themselves flat.

A conductor containing paste used when the heating elements are formed is not particularly limited. Preferably, the paste contains a resin, a solvent, a thickener and the like as well as metal particles or a conductive ceramic for ensuring electric conductivity.

The above-mentioned metal particles are preferably made of, for example, a noble metal (gold, silver, platinum or palladium), lead, tungsten, molybdenum, nickel and the like. Of these, the noble metal (gold, silver, platinum or palladium) is more preferred. These may be used alone, but are desirably used in combination of two or more. These metals are not relatively easily oxidized, and have a resistance value sufficient for generating heat.

Examples of the above-mentioned conductive ceramic include carbides of tungsten and molybdenum. These may be used alone or in combination of two or more.

The particle diameter of these metal particles or the conductive ceramic particles is preferably from 0.1 to 100 µm. If the particle diameter is too fine, that is, less than 0.1µm, they are easily oxidized. On the other hand, if the particle diameter exceeds 100 µm, they are not easily sintered so that the resistance value becomes large.

The shape of the metal particles may be spherical or scaly. When these metal particles are used, they may be a mixture of spherical particles and scaly particles.

In the case that the metal particles are scaly or a mixture of spherical particles and scaly particles, metal oxides between the metal particles are easily held and adhesion between the heating elements and the nitride ceramic and the like is made sure. Moreover, the resistance value can be made large. Thus, this case is profitable.

Examples of the resin used in the conductor containing paste include epoxy resin, phenol resin and the like. Examples of the solvent are isopropyl alcohol and the like. Examples of the thickener is cellulose and the like.

It is desired to add a metal oxide to the metal particles in the conductor-containing paste and form the heating elements up to a sintered body of the metal particles and the metal oxide, as described above. By sintering the metal oxide together with the metal particles in this way, the nitride ceramic or the carbide ceramic constituting the ceramic substrate can be closely adhered to the metal particles.

The reason why the adhesion to the nitride ceramic or the carbide ceramic by mixing the metal oxide is improved is unclear, but would be based on the following. The surface of the metal particles, or the surface of the nitride ceramic or the carbide ceramic is slightly oxidized so that an oxidized film is formed. Pieces of this oxidized film are sintered and integrated with each other through the metal oxide so that the metal particles and the nitride ceramic or the carbide ceramic are closely adhered to each other.

A preferred example of the above-mentioned metal oxide is at least one selected from the group consisting of lead oxide, zinc oxide, silica, boron oxide (B₂O₃), alumina, yttria and titania.

These oxides make it possible to improve adhesion between the metal particles and the nitride ceramic or the carbide ceramic without increasing the resistance value of the heating elements.

When the total amount of the metal oxides is set to 100 parts by weight, the weight ratio of lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The weight ratio is desirably adjusted within the scope that the total thereof does not exceed 100 parts by weight.

By adjusting the amounts of these oxides within these ranges, in particular, adhesion to the nitride ceramic can be improved.

The amount of the metal oxide added in the metal particles is preferably 0.1% or more by weight and less than 10% by weight.

As the heating elements, a metal foil or a metal wire may be used. As the metal foil, a nickel foil or stainless steel foil formed into heating elements by patterning based on etching and the like is preferred. The patterned metal foil may be stuck with a resin film and the like. Examples of the metal wire include a tungsten wire and a molybdenum wire.

The area resistivity when the heating elements are formed is preferably from 1 mΩ/□ to 10 Ω/□. If the area resistivity is less than 0.1 Ω/□, the resistivity is too small so that the heat quantity is small. Thus, the heating elements do not exhibit its original function easily. On the other hand, if the area resistivity exceeds 10 Ω/□, the heat quantity becomes too large for applied voltage quantity. Thus, in the ceramic substrate wherein the heating elements are formed on the surface of the ceramic substrate, the heat quantity thereof is not easily controlled. From the viewpoint of the control of the heat quantity, the area resistivity of the heating elements is more preferably from 1 to 50 mΩ/□. However, if the area resistivity is made large, the pattern width (sectional area) can be made large so that a problem of wire-disconnection is not easily caused. Therefore, the area resistivity is preferably set to 50 mΩ/□ as the case may be.

In the case that the heating elements are formed on the surface of the ceramic substrate 21, a metal covering layer 220 (see Fig. 4) is preferably formed on the surface of the heating elements. The metal covering layer prevents a change in the resistance value based on oxidization of the inner metal sintered body. The thickness of the formed metal covering layer 220 is preferably from 0.1 to 10 µm.

The metal used when the metal covering layer 220 is formed is not particularly limited if the metal is a non-oxidizable metal. Specific examples thereof include gold, silver, palladium, platinum, and nickel. These may be used alone or in combination of two or more. Of these metals, nickel is preferred.

In the heating element 12, a terminal for connection to a power source is necessary. This terminal is fixed to the heating element 12 through solder. Nickel prevents thermal diffusion from the solder. An example of the connecting terminal is an external terminal 13 made of kovar.

In the case that the heating elements are formed inside the ceramic substrate, no covering is necessary since the surface of the heating elements is not oxidized. In the case that the heating elements are formed inside the ceramic substrate 11, a part of the heating elements may be exposed in the surface. It is allowable that conductor filled through holes for connecting the heating elements are formed in the terminal portions and terminals are connected and fixed to the conductor filled through holes.

In the case that the connecting terminals are connected, an alloy such as silver-lead, lead-tin or bismuth-tin can be used as the solder. The thickness of the solder layer is desirably from 0.1 to 50 µm. This is because this range is a range sufficient for maintaining connection based on the solder.

The ceramic heater according to the first aspect of the present invention can be used within the temperature range of 100 to 800°C.

A ceramic body having a cylindrical shape or the like may be bonded to the bottom face of the ceramic substrate constituting the ceramic heater according to the first aspect of the present invention so as to protect wires such as external terminals. In this way, the wires such as external terminals can be prevented from being corroded by reactive gas, halogen gas and the like.

Furthermore, the ceramic heater according to the first aspect of the present invention can be used when a liquid crystal substrate is heated.

The following will describe a process for producing the ceramic heater according to the first aspect of the present invention.

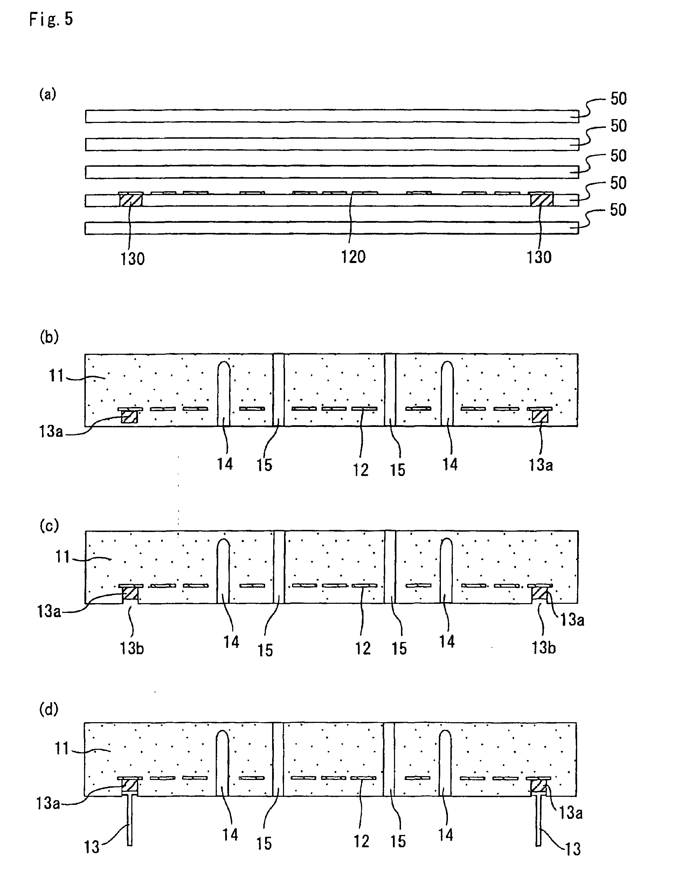

Firstly, a process for producing a ceramic heater wherein heating elements 12 are formed inside a ceramic substrate 11 (see Figs. 1 and 2) will be described on the basis of Fig. 5.

### (1) Step of forming the ceramic substrate

First, powder of a nitride ceramic and the like is mixed with a binder, a solvent and so on to prepare a paste. This is used to form green sheets 50.

As the above-mentioned ceramic powder, aluminum nitride, and the like can be used. If necessary, a sintering aid such as yttria, a compound containing Na or Ca, and the like may be added thereto.

As the binder, desirable is at least one selected from an acrylic resin binder, ethylcellulose, butylcellosolve, and polyvinyl alcohol.

As the solvent, desirable is at least one selected from α-terpineol and glycol.

A paste obtained by mixing these is formed into a sheet form by a doctor blade process, to manufacture green sheets.

The thickness of the green sheets is preferably from 0.1 to 5 mm.

### (2) Step of printing a conductor containing paste on the green sheet

A metal paste or a conductor containing paste containing a conductive ceramic, for forming heating elements 12, is printed on the green sheet 50, so as to form a conductor containing paste layer 120. A conductor containing paste filled layer 130 for conductor filled through holes 13a is formed in through holes.

The conductor containing paste contains metal particles or conductive ceramic particles.

The average particle diameter of tungsten particles or molybdenum particles is preferably from 0.1 to 5 µm. If the average particle is less than 0.1 µm or exceeds 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 to parts by weight of at least one binder selected from acrylic resin binders, ethylcellulose, butylcellosolve and polyvinyl alcohol; and 1.5 to 10 parts by weight of at least one solvent selected from α-terpineol and glycol.

### (3) Step of laminating the green sheets

Green sheets 50 on which no conductor containingpaste is printed are laminated on the upper and lower sides of the green sheet 50 on which the conductor containing paste is printed (see Fig. 5(a)).

At this time, the laminating is performed in such a manner that the green sheet 50 on which the conductor containing paste is printed is arranged at a position which has a distance, from the bottom face, of 60% or less of the thickness of the laminated green sheets.

Specifically, the number of the green sheets laminated on the upper side is preferably from 20 to 50, and that of the green sheets laminated on the lower side is preferably from 5 to 20.

### (4) Step of firing the green sheet lamination

The green sheet lamination is heated and pressed to sinter the green sheets and the inner conductor containing paste layer. The heating temperature is preferably from 1000 to 2000°C, and the pressing pressure is preferably from 10 to 20 MPa. The heating is performed in the atmosphere of an inert gas. As the inert gas, argon, nitrogen and the like can be used.

Next, three or more through holes 15, for letting lifter pins 16 for supporting a semiconductor wafer 39 pass through, are formed in the resultant sintered body. The holes 15 are formed in an area whose distance from the center of the ceramic substrate is 1/2 or more of the distance from the center to the outer edge of the ceramic substrate.

The through holes 15 are desirably formed at substantially regular intervals on a single circle having a concentric circle relationship with the ceramic substrate 11 for the following reason: the lifter pins, which are passed through the through holes 15, are widely dispersed on the ceramic substrate 11 and arranged at regular interval; therefore, the semiconductor wafer 39 can be kept more horizontal and the distance between the ceramic substrate 11 and the semiconductor wafer 39 is made constant, so that the semiconductor wafer 39 can be more evenly heated.

Furthermore, bottomed holes 14, for embedding temperature measuring elements such as thermocouples, are formed in the ceramic substrate (see Fig. 5(b)). Thereafter, blind holes 13 are provided to make the conductor filled through holes 13a, for connecting the heating elements 12 to external terminals 13, exposed (see Fig. 5(c)).

The above-mentioned steps of making the bottomed holes and the through holes may be applied to the above-mentioned sheet lamination, but is preferably applied to the above-mentioned sintered body. This is because the lamination may be deformed in the sintering step.

The through holes and the bottomed holes can be formed by grinding the surface and then subjecting the surface to blast treatment such as sandblast. The external terminals 13 are connected to the conductor filled through holes 13a for connecting the inner heating elements 12, and heated for re-flow. The heating temperature is preferably from 200 to 500°C.

Furthermore, thermocouples (not illustrated) as temperature measuring elements are fitted into the bottomed holes 14 with brazing silver, brazing gold and the like, and then holes are sealed up with aheat-resistant resin such as polyimide, so as to finish the production of a ceramic heater 10 (see Fig. 5(d)).

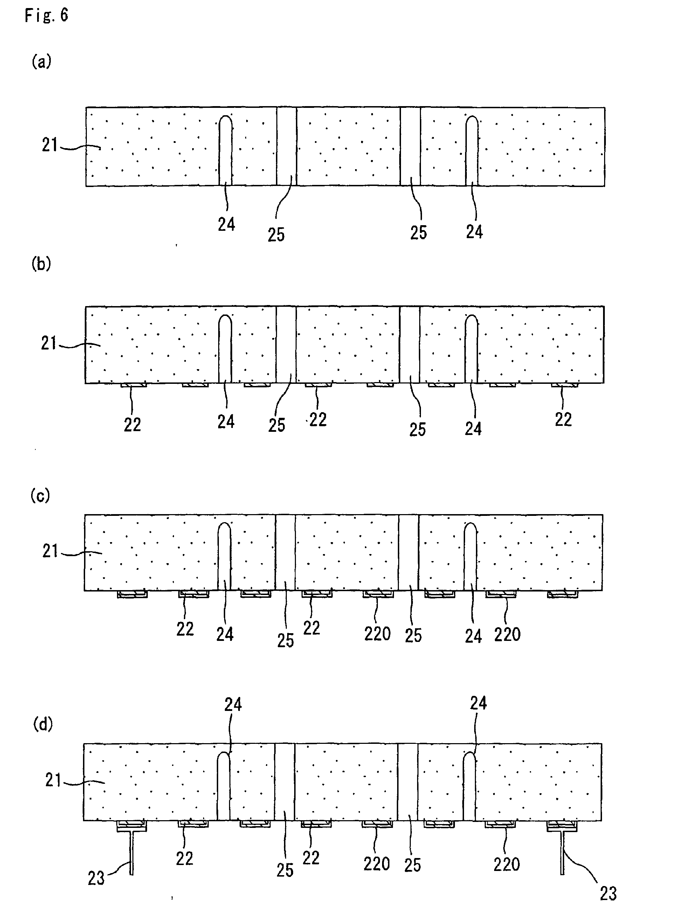

The following will describe a process for producing a ceramic heater 20 wherein heating elements 22 are formed on the bottom face of a ceramic substrate 21 (see Figs. 3 and 4) on the basis of Fig. 6.

### (1) Step of forming the ceramic substrate

A sintering aid such as yttria (Y₂O₃) or B₄C, a compound containing Na or Ca, a binder and so on are blended as appropriate with powder made of a ceramic such as a nitride ceramic, for example, the above-mentioned aluminum nitride or a carbide ceramic, so as to prepare a slurry. Thereafter, this slurry is made into a granular form by spray drying and the like. The granules are put into a mold and pressed to be formed into a plate form or some other form. Thus, a raw formed body(green) is produced.

Next, this raw formed body is heated and fired to be sintered. Thus, a plate made of the ceramic is produced. Thereafter, the plate is made into a given shape to produce the ceramic substrate 21. The shape of the raw formed body may be such a shape that the sintered body can be used as it is after the firing (Fig. 6(a)). By heating and firing the raw formed body under pressure, the ceramic substrate 21 having no pores can be produced. It is sufficient that the heating and the firing are performed at the sintering temperature or higher. The firing temperature is from 1000 to 2500°C for nitride ceramics or carbide ceramics. The firing temperature is from 1500 to 2000°C for oxide ceramics.

Furthermore, the ceramic substrate is drilled so as to form three or more through holes 25 for letting lifter pins 26 for supporting a semiconductor wafer 39 pass through, in an area whose distance from the center of the ceramic substrate is 1/2 or more of the distance from the center to the outer edge of the ceramic substrate.

In the same manner as in the ceramic substrate 10, the through holes 25 are desirably formed at substantially regular intervals on a single circle having a concentric circle relationship with the ceramic substrate 21.

Additionally, bottomed holes 24, for embedding temperature measuring elements such as thermocouples, are formed in the ceramic substrate (see Fig. 6(a)).

### (2) Step of printing a conductor containing paste on the ceramic substrate

A conductor containing paste is generally a fluid comprising metal particles, a resin and a solvent, and having a high viscosity. This conductor containing paste is printed on portions where heating elements 22 are to be formed by screen printing and the like. In this way, a conductor containing paste layer is formed.

The conductor containing paste is desirably formed in such a manner that sections of the heating elements 22 subj ected to the firing are rectangular and flat.

### (3) Firing of the conductor containing paste

The conductor containing paste layer printed on the bottom face 21b of the ceramic substrate is heated and fired to remove the resin and the solvent and sinter the metal particles. Thus, the metal particles are baked onto the bottom face of the ceramic substrate 21 to form the heating elements 22 (Fig. 6 (b)). The heating and firing temperature is preferably from 500 to 1000°C.

If the above-mentioned oxides are added to the conductor containing paste, the metal particles, the ceramic substrate and the oxides are sintered to be integrated with each other. Thus, the adhesiveness between the heating elements 22 and the ceramic substrate 21 is improved.

### (4) Step of forming a metal covering layer

Next, a metal covering layer 220 is deposited on the surface of the heating elements 22 (see Fig. 6(c)). The metal covering layer 220 can be formed by electroplating, electroless plating, sputtering and the like. From the viewpoint of mass-productivity, electroless plating is optimal.

### (5) Fitting of terminals and so on

A terminal (external terminal 23) for connection to a power source is fitted up to an end of each of the pattern pieces of the heating elements 22 with solder. Thermocouples (not illustrated) are fixed to the bottomed holes 24 with brazing silver, brazing gold and the like. The bottomed holes are sealed with a heat-resistant resin such as polyimide and the like, so as to finish the production of a ceramic heater 20 (see Fig. 6(d)).

About the ceramic heater according to the first aspect of the present invention, electrostatic electrodes are set inside the ceramic substrate, whereby the ceramic substrate can be used as an electrostatic chuck.

By forming a chuck top conductive layer on the surface, the ceramic heater can be used as a ceramic substrate for a wafer prober.

As described above, the ceramic heater according to the first aspect of the present invention can be used as a ceramic heater for a semiconductor producing/inspecting device or for heating a liquid crystal substrate.

Next, a ceramic heater according to a second aspect of thepresent invention will be described.

The ceramic heater according to the second aspect of the present invention includes: a disk-like ceramic substrate; a heating element formed on a surface of or inside the ceramic substrate; and through holes for letting lifter pins into at the ceramic substrate, wherein the diameter of each of the above-mentioned through holes on a heating face side for heating an object to be heated is larger than the diameter of the above-mentioned through hole on the side opposite to the above-mentioned heating face.

In the ceramic heater according to the second aspect of the present invention, the diameter on the heating face side of the through holes is desirably from 1. 2 to 10 times the diameter on the side opposite to the heating face. If the diameter on the heating side is less than 1.2 times the diameter on the side opposite to the heating face or exceeds 10 times, the effect of accumulating heat cannot be obtained.

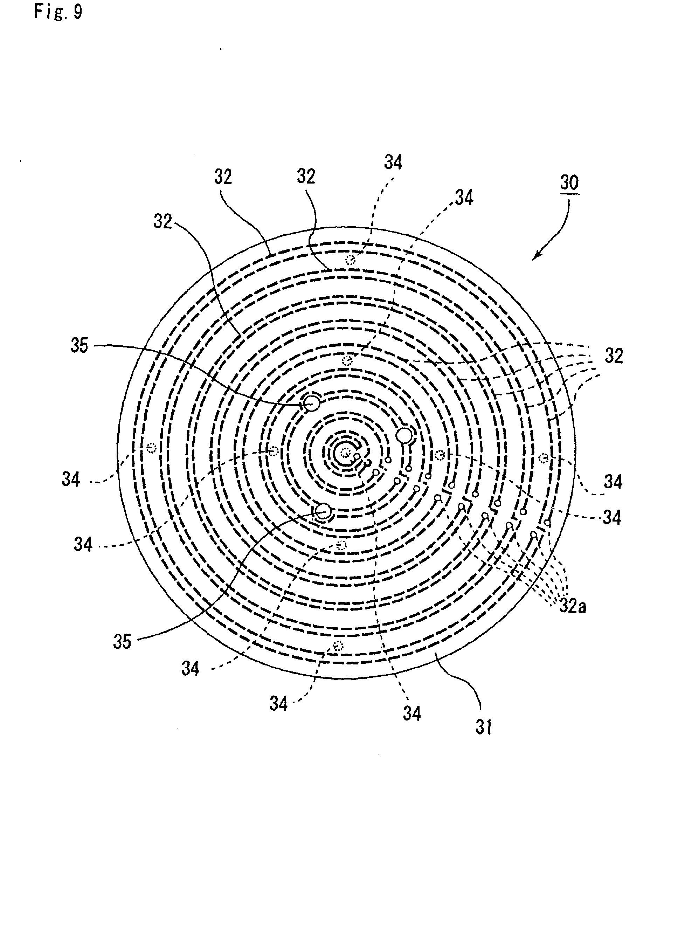

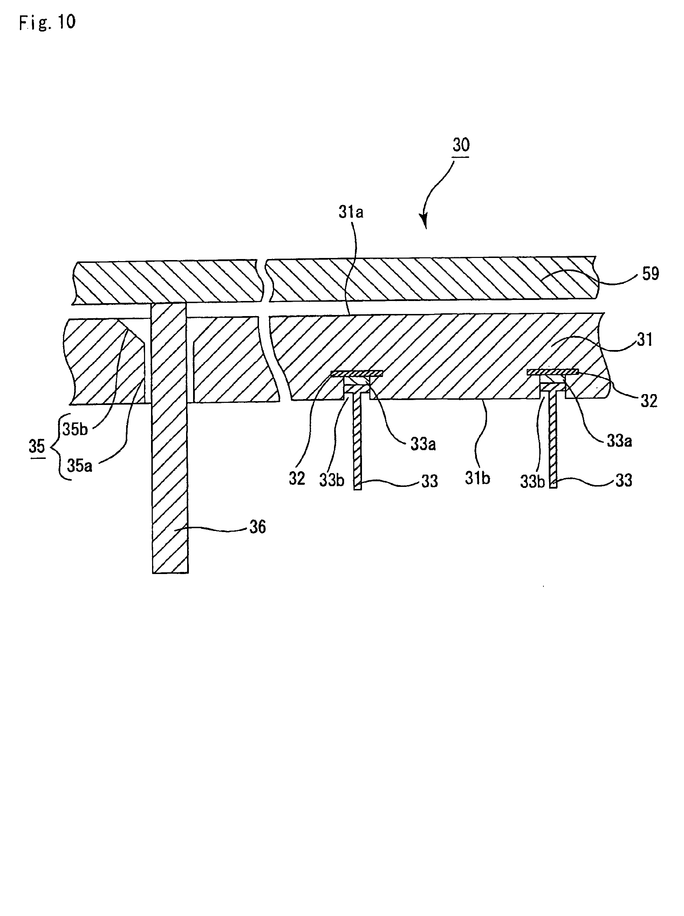

Fig. 9 is a plan view which schematically illustrates a ceramic heater according to the second aspect of the present invention. Fig. 10 is a partially enlarged sectional view which schematically illustrates the ceramic heater in Fig. 9. In this ceramic heater, heating elements are formed inside its ceramic substrate.

In this ceramic heater 30, the ceramic substrate 31 is formed in a disk-like form. In order to heat the ceramic heater in such a manner that the temperature in the whole of a heating face 31a of the ceramic heater 30 is made even, the heating elements 32 which has a concentrically circular pattern are formed inside the ceramic substrate 31.

Conductor filled through holes 33a are formed just under ends of heating elements 32, and further blind holes 33b for making the conductor filled through holes 33a exposed are formed in the bottom face 31b. An external terminal 33 is inserted into the blind hole 33b, and they are bonded to each other with a brazing material (not illustrated). For example, a socket (not illustrated) having a conductive wire is fitted to the external terminal 33. This conductive wire is connected to a power source and the like.

In the bottom face of the ceramic substrate 31, bottomed holes 34, for inserting temperature measuring elements (not illustrated) into, are formed.

Furthermore, three through holes 35, for letting lifter pins 36 pass through, are formed in the vicinity of the center of the ceramic substrate 31.

As illustrated in Fig. 10, the through hole 35 is composed of a columnar portion 35a and a diameter-increasing portion 35b the diameter of which becomes larger as the portion is closer to the heating face, and the whole thereof has a funnel shape. In portions where cooling spots are easily generated, the solid constituting the substrate is hardly present. Instead of it, gas such as air is present.

Accordingly, the heat capacity of the portion where cooling spots are easily generated gets small. Because of the presence of this portion, portions with low temperature are not easily generated in a semiconductor wafer 59. Since gas such as air accumulates heat and remains in the funnel-shaped portion, the semiconductor wafer 59 can be evenly heated.

In Fig. 10, the through hole 35 has a shape the diameter of which increases abruptly at a spot from the vicinity of the heating face (specifically a position whose distance from the heating face of the ceramic substrate is 2/3 or less of the thickness of the ceramic substrate) toward the heating face. However, the through hole may be a through hole having such a shape that the diameter thereof increases gradually from the vicinity of the bottom face side in order to cause the gas (such as the air) having accumulated heat to remain in the vicinity of the heating face.

When this ceramic heater 30 is used to heat the semiconductor wafer 59, it is allowable to receive the semiconductor wafer 59 by means of the lifter pins 36, put the semiconductor wafer 59 on the heating face, and send electric current to the ceramic heater so as to be heated. It is also allowable to support the semiconductor wafer 59 in the state that the wafer is a given distance apart from the heating face 31a of the ceramic substrate through the lifer pins 36 by holding the lifter pins 36 in the state that they project slightly from the heating face 31a of the ceramic substrate 31, and then heat the semiconductor wafer 59.

Inparticular, when the semiconductor wafer or the like is placed so as to contact the heating face, in general it is easily affected by cooling spots present in the vicinity of the through holes. In the second aspect of the present invention, however, the diameter on the heating face side of the through holes is larger as described above. Thus, cooling spots are not easily generated, and thus the semiconductor wafer can be more evenly heated than that in the prior art.

Before and after the step of using the ceramic substrate of the second aspect of the present invention to conduct heating treatment and so forth, the semiconductor wafer or the like can be relatively easily received from the previous line or carried to the next line by letting the lifter pins 36 pass through the through holes 35 and subsequently moving the lifter pins up and down.

When the semiconductor wafer or the like is supported by the lifter pins 36, the semiconductor wafer or the like is not rubbed with the ceramic substrate. Therefore, no free particles are generated from the ceramic substrate.

By arranging a member having projected structures, such as pins and the like, on the surface of the ceramic substrate, the semiconductor wafer or the like can be heated in the state that the semiconductor wafer or the like is apart from the heating face of the ceramic substrate in the same manner as in the case of holding the lifter pins in the state that the lifter pins project slightly from the heating face of the ceramic substrate.

In the ceramic heater according to the second aspect of the present invention, the heating elements may be formed inside the ceramic substrate or may be formed outside the ceramic substrate.

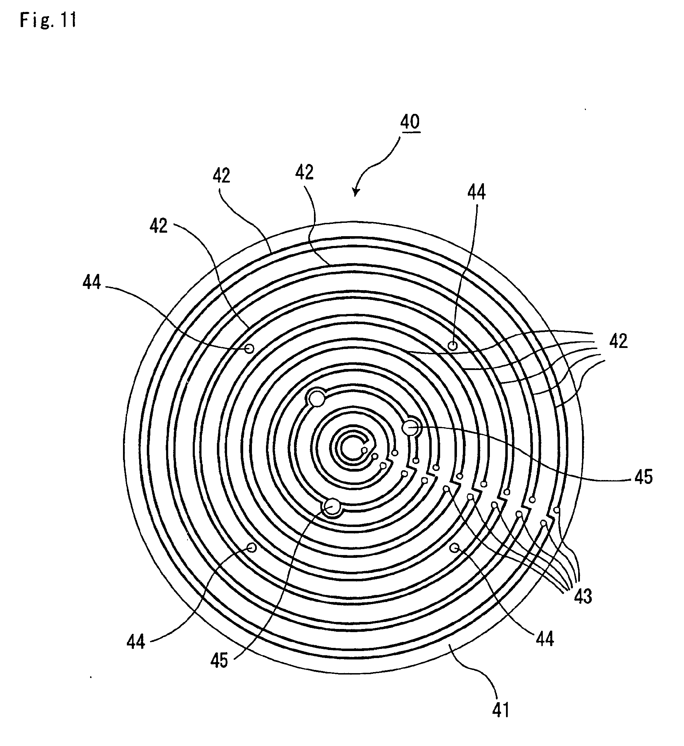

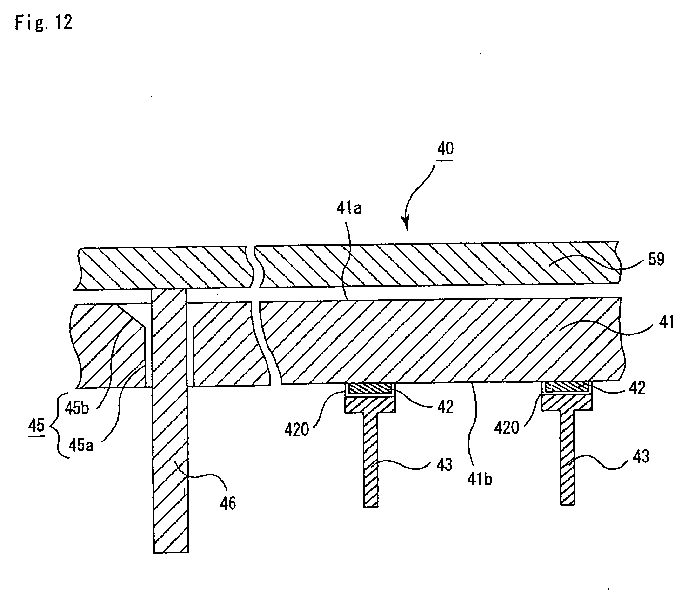

Fig. 11 is a bottom face view which schematically illustrates another example of the ceramic heater according to the second aspect of the present invention. Fig. 12 is a partially enlarged sectional view which schematically illustrates the ceramic heater in Fig. 11. In this ceramic heater, heating elements are formed on a surface of the ceramic substrate.

In the ceramic heater 40, its ceramic substrate 41 is formed in a disk-like form, and heating elements 42 having a concentrically circular pattern are formed on the surface of the ceramic substrate 41. External terminals 43, which are terminals for input and output, are connected through a metal covering layer 420 to both ends of the heating element.

In the bottom face of the ceramic substrate 41, bottomed holes 44, for inserting temperature measuring elements (not illustrated) into, are formed.

Additionally, three through holes 45, for letting lifter pins 46 pass through, are formed in the vicinity of the center of the ceramic substrate 41. In the same manner as in the case of the ceramic heater 30, the through hole 45 is composed of a columnar portion 45a and a diameter-increasing portion 45b. In portions where cooling spots are easily generated, the solid constituting the substrate is hardly present. Accordingly, the heat capacity of the portion where cooling spots are easily generated can be largely lowered. Thus, a semiconductor wafer 59 can be evenly heated.

By letting the lifter pins 46 pass through the through holes 45 and then moving the pins up and down, the semiconductor wafer or the like can be carried and moved. By projecting the lifter pins 46 from the heating face 41a of the ceramic substrate 41, the semiconductor wafer 59 can be held in the state that the wafer is apart from the ceramic substrate 41a.

In the ceramic heater according to the second aspect of the present invention, the shape of the through holes is not particularly limited if the diameter thereof on the heating face side is larger than that on the bottom face. As described, the through holes are preferably composed of a columnar portion and a diameter-increasing portion as illustrated in Fig. 10.

The number of the through holes formed in the ceramic substrate is preferably three or more. If the number of the through holes is two or less, it is difficult to support an object to be heated, such as a semiconductor wafer, stably by the lifter pins passed through the through holes. The number of the through holes is not particularly limited if the number is three or more. Since it is also true for the second aspect of the present invention that cooling spots are easily generated in the through holes portions, it is preferred that the number thereof is not very large. For example, the number is desirably 11 or less.

The position where the through holes are formed is not particularly limited. Desirably, the through holes are formed in an area whose distance from the center of the ceramic substrate is 1/2 or more of the distance from the center to the outer edge of the ceramic substrate. This is because this case makes it possible to support a semiconductor wafer or the like more stably. The volume of the peripheral portion is larger than that of the central portion; therefore, if the through holes are formed in the vicinity of the center, the heat capacity of the central portion gets small by making the through holes. Thus, the temperature in the central portion is readily made high. However, if the through holes are formed in the peripheral portion, difference in the heat capacitybetween the central portion and the peripheral portion is hardly generated so that the temperature in the heating face can be made even.

The through holes are desirably formed at substantially regular intervals on a single circle having a concentric circle relationship with the ceramic substrate since a semiconductor wafer or the like can be more stably supported and can be still more evenly heated. In the case that four or more through holes are formed in the ceramic substrate, one of the through holes may be formed in the center of the ceramic substrate. By the lifter pins, the semiconductor wafer or the like can be held apart from the ceramic substrate and further the central portion of the semiconductor wafer or the like can be prevented form warping when it is heated. As a result, the distance between the semiconductor wafer or the like and the ceramic substrate is made constant so that the semiconductor wafer or the like can be evenly heated.

When a semiconductor wafer or the like is held apart by the lifter pins, it is desired that the height of the lifter pins projecting from the heating face of the ceramic substrate, the pins being passed through the through holes, is from 5 to 5000 µm, that is, that the semiconductor wafer or the like is held from 5 to 5000 µm apart from the heating face of the ceramic substrate. If the distance is less than 5 µm, the temperature of the semiconductor or the like is affected by the temperature distribution in the ceramic substrate and is made uneven. If the distance exceeds 5000 µm, the temperature of the semiconductor wafer or the like does not rise easily. In particular, the temperature in the peripheral portion of the semiconductor wafer or the like drops.

An object to be heated and the heating face of the ceramic substrate are separated from each other more desirably by a distance of 5 to 500 µm, still more desirably 20 to 200 µm.

The diameter of the through holes is desirably from 1 to 100 mm, more desirably from 1 to 20 mm. In case the through holes have a trapezoidal sectional shape, the diameter of the through holes means the diameter thereof at the position in the middle between the bottom face and the heating face. When the through holes are composed of a columnar portion and a diameter-increasing portion, the diameter thereof means the diameter of the columnar portion. If the diameter of the through holes is less than 1 mm, the lifter pins passed through the through holes become too thin so that a semiconductor wafer or the like can not be stably put on the lifter pins with ease. On the other hand, if the diameter of the through holes exceeds 100 mm, the through holes are too large so that cooling spots are readily generated in the heating face by the effect of gas present inside the through holes. Additionally, the heat capacities in a given area of the ceramic substrate are different between the portion where the through holes are present and the portion where the through holes are not present; therefore, the temperature in the heating face readily gets uneven, whereby it is apprehended that the semiconductor wafer or the like cannot be evenly heated.

The constitutions of parts other than the through holes in the ceramic substrate, which are parts of the ceramic heater of the second aspect of the present invention, such as temperature measuring elements, heating elements, and connecting terminals, are the same as in the first aspect of the present invention. Thus, description thereof will not be repeated.

A ceramic body having a cylindrical shape or the like may be bonded to the bottom face of the ceramic substrate which constitutes the ceramic heater according to the second aspect of the present invention, so as to protect wires such as external terminals. In this way, the wires such as the external terminals can be protected from reactive gas, halogen gas and the like.

Furthermore, the ceramic heater according to the second aspect of the present invention can be used when a liquid crystal substrate is heated.

The following will describe a process for producing a ceramic heater according to the second aspect of the present invention.

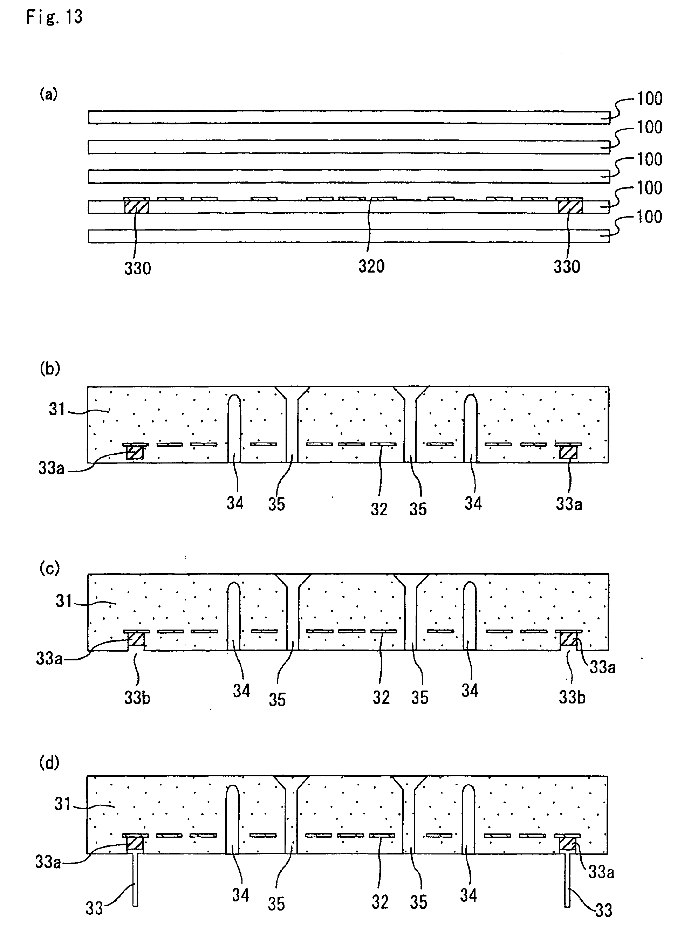

Firstly, a ceramic heater wherein heating elements 32 are formed inside a ceramic substrate 31 (see Figs. 9 and 10) will be described on the basis of Fig. 13.

### (1) Step of forming the ceramic substrate

First, ceramic powder made of a nitride ceramic and the like are mixed with a binder, a solvent and so on to prepare a paste. This is used to form green sheets 100.

Aluminum nitride and the like can be used as the above-mentioned ceramic powder made of a nitride ceramic and the like. If necessary, a sintering aid such as yttria, a compound containing Na or Ca, and the like may be added thereto.

As the binder, desirable is at least one selected from an acrylic resin binder, ethylcellulose, butylcellosolve, and polyvinyl alcohol.

As the solvent, desirable is at least one selected from α-terpineol and glycol.

A paste obtained by mixing these is formed into a sheet form by a doctor blade process, to manufacture green sheets.

The thickness of the green sheets is preferably from 0.1 to 5 mm.

### (2) Step of printing a conductor containing paste on the green sheet

A metal paste or a conductor containing paste which contains paste containing a conductive ceramic, for forming heating elements 32, is printed on the green sheet 100, so as to form a conductor containing paste layer 320. A conductor containing paste filled layer 330 for conductor filled through holes 33a is formed in through holes.

The conductor containing paste contains metal particles or conductive ceramic particles.

The average particle diameter of tungsten particles or molybdenum particles is preferably from 0.1 to 5 µm. If the average particle is less than 0.1 µm or exceeds 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 to parts by weight of at least one binder selected from acrylic resin binders, ethylcellulose, butylcellosolve and polyvinyl alcohol; and 1.5 to 10 parts by weight of at least one solvent selected from α-terpineol and glycol.

### (3) Step of laminating the green sheets

Green sheets 100 on which no conductor containing paste is printed are laminated on the upper and lower sides of the green sheet 100 on which the conductor containing paste is printed (see Fig. 13 (a)).

At this time, the laminating is performed in such a manner that the green sheet 100 on which the conductor containing paste is printed is arranged at a position which has a distance, from the bottom face, of 60% or less of the thickness of the laminated green sheets.

Specifically, the number of the green sheets laminated on the upper side is preferably from 20 to 50, and that of the green sheets laminated on the lower side is preferably from 5 to 20.

### (4) Step of firing the green sheet lamination

The green sheet lamination is heated and pressed to sinter the green sheets and the inner conductor containing paste. The heating temperature is preferably from 1000 to 2000°C, and the pressing pressure is preferably from 10 to 20 MPa. The heating is performed in the atmosphere of an inert gas. As the inert gas, argon, nitrogen and the like can be used.

Next, through holes 35, for letting lifter pins 36 for supporting a semiconductor wafer 59 pass through, are formed in the resultant sintered body.

At this time, the through holes 35 having a columnar portion 35a and a diameter-increasing portion 35b can be formed by: firstly, forming columnar through holes with a drill having an ordinary cutting edge; and subsequently processing the through hole portions from the heating face side, by using a drill having a cutting edge capable of making a conical shaped concave portions. Also, by sandblast treatment, through holes having a trapezoidal vertical section, as well as the above-mentioned shaped through holes, can be formed.

The through holes 35 are desirably formed at substantially regular intervals on a single circle having a concentric circle relationship with the ceramic substrate 31 for the following reason: the lifter pins 36, which are passed through the through holes 35, are widely dispersed on the ceramic substrate 31 and arranged at regular interval; therefore, the semiconductor wafer 59 can be kept more horizontal.

Furthermore, bottomed holes 34, for embedding temperature measuring elements such as thermocouples, are formed in the ceramic substrate (see Fig. 13 (b)). Thereafter, blind holes 33 are provided in order to make the conductor filled through holes 33a, which is for connecting the heating elements 32 to external terminals 33, exposed (see Fig. 13(c)).

The above-mentioned steps of making the bottomed holes and the through holes may be applied to the above-mentioned sheet lamination, but is preferably applied to the above-mentioned sintered body. This is because the lamination may be deformed in the sintering step.

The formation of the through holes and the bottomed holes is usually performed after grinding the surface. Thereafter, the external terminals 33 are connected to the conductor filled through holes 33a for connecting the inner heating elements 32, and heated for re-flow. The heating temperature is preferably from 200 to 500°C.

Furthermore, thermocouples (not illustrated) as temperature measuring elements are fitted into the bottomed holes 14 with brazing silver, brazing gold and the like, and then holes are sealed up with a heat-resistant resin such as polyimide, so as to finish the production of a ceramic heater 30 (see Fig. 13(d)).

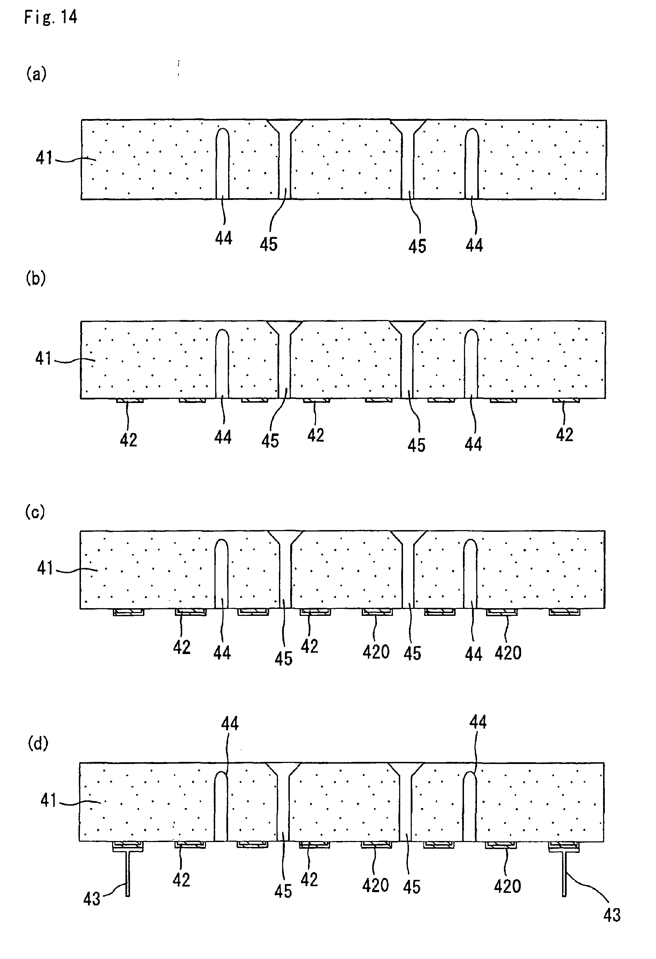

The following will describe a process for producing a ceramic heater 40 wherein heating elements 42 are formed on the bottom face of a ceramic substrate 41 (see Figs. 11 and 12) on the basis of Fig. 14.

### (1) Step of forming the ceramic substrate

A sintering aid such as yttria (Y₂O₃) or B₄C, a compound containing Na or Ca, a binder and so on are blended as appropriate with powder made of a ceramic such as a nitride ceramic, for example, the above-mentioned aluminum nitride or a carbide ceramic, so as to prepare a slurry. Thereafter, this slurry is made into a granular form by spray drying and the like. The granules are put into a mold and pressed to be formed into a plate form or some other form. Thus, a raw formed body(green) is produced.

Next, this raw formed body is heated and fired to be sintered. Thus, a plate made of the ceramic is produced. Thereafter, the plate is made into a given shape to produce the ceramic substrate 41. The shape of the raw formed body may be such a shape that the sintered body can be used as it is after the firing. By heating and firing the raw formed body under pressure, the ceramic substrate 41 having no pores can be produced. It is sufficient that the heating and the firing are performed at the sintering temperature or higher. The firing temperature is from 1000 to 2500°C for nitride ceramics or carbide ceramics. The firing temperature is from 1500 to 2000°C for oxide ceramics.

Furthermore, the ceramic substrate is drilled so as to form through holes 45, for letting lifter pins 46 for supporting a semiconductor wafer 59 pass through. The method of forming the through holes is the same as in the case of the above-mentioned ceramic heater having the heating elements inside.

Additionally, bottomed holes 44, for embedding temperature measuring elements such as thermocouples, are formed in the ceramic substrate (see Fig. 14(a)).

### (2) Step of printing a conductor containing paste on the ceramic substrate

A conductor containing paste is generally a fluid comprising metal particles, a resin and a solvent, and having a high viscosity. This conductor containing paste is printed on portions where heating elements 4 are to be formed by screen printing and the like. In this way, a conductor containing paste layer is formed.

The conductor containing paste is desirably formed in such a manner that sections of the heating elements 42 subj ected to the firing are rectangular and flat.

### (3) Firing of the conductor containing paste

The conductor containing paste layer printed on the bottom face 41b of the ceramic substrate is heated and fired to remove the resin and the solvent and sinter the metal particles. Thus, the metal particles are baked onto the bottom face of the ceramic substrate 41 to form the heating elements 42 (Fig. 14(b)). The heating and firing temperature is preferably from 500 to 1000°C.

If the above-mentioned oxides are added to the conductor containing paste, the metal particles, the ceramic substrate and the oxides are sintered to be integrated with each other. Thus, the adhesiveness between the heating elements 42 and the ceramic substrate 41 is improved.

### (4) Step of forming a metal covering layer

Next, a metal covering layer 420 is deposited on the surface of the heating elements (Fig. 14(c)). The metal covering layer 420 can be formed by electroplating, electroless plating, sputtering and the like. From the viewpoint of mass-productivity, electroless plating is optimal.

### (5) Fitting of terminals and so on

A terminal (external terminal 43 for connection to a power source is fitted up to an end of each of the pattern pieces of the heating elements 42 with solder. Thermocouples (not illustrated) are fixed to the bottomed holes 44 with brazing silver, brazing gold and the like. The bottomed holes are sealed with a heat-resistant resin such as polyimide, so as to finish the production of a ceramic heater 40 (Fig. 14(d)).

About the ceramic heater of the second aspect of the present invention, electrostatic electrodes are set inside the ceramic substrate, whereby the ceramic heater can be used as an electrostatic chuck.

By forming a chuck top conductive layer on the surface, the ceramic heater can be used as a ceramic substrate for a wafer prober.

The following will describe a ceramic bonded body according to a third aspect of the present invention according to embodiments. The third aspect of the present invention is not limited to this description. In the following, the ceramic body will be described as a cylindrical ceramic body. However, the ceramic body may be a columnar filled body, or may be a triangle polar or square polar hollow body or filled body.

The ceramic bonded body of the third aspect of the present invention according to an embodiment includes: a disk-like ceramic substrate inside which a conductor is provided; and a cylindrical ceramic body having a cylindrical shape bonded to the bottom face of the ceramic substrate, wherein the center of the circle surrounded by the interface between the cylindrical ceramic body and the ceramic substrate is 3 to 200 µm apart from the center of the bottom face of the ceramic substrate.

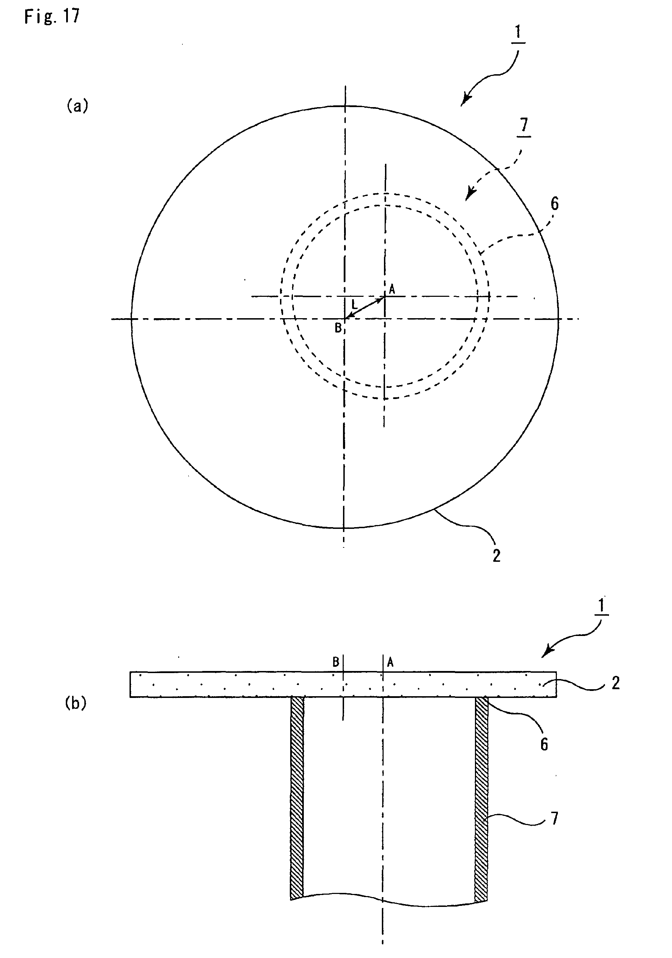

Fig. 17(a) is a plan view which schematically illustrates a ceramic bonded body according to the third aspect of the present invention, and Fig. 17 (b) is a partially enlarged sectional view which schematically illustrates this ceramic bonded body.

Fig. 17 illustrates only a ceramic substrate and the ceramic body in a cylindrical form and does not illustrate a conductor formed inside the ceramic substrate, or other members.

The ceramic bonded body 1 is formed by bonding the cylindrical ceramic body 7 to the bottom face of the ceramic substrate 2 having a disk-like shape. At this time, the face on which the ceramic substrate 2 and the cylindrical ceramic body 7 are bonded is an interface 6.

In the ceramic bonded body 1, the distance L between: the center A of the circle surrounded by the interface 6; and the center B of the bottom face of the ceramic substrate 2 is from 3 to 200 µm.

The method for bonding the ceramic substrate and the cylindrical ceramic body will be described in detail later.

In the case that the ceramic bonded body according to the third aspect of the present invention is applied to a semiconductor producing/inspecting device, it is desired that a ceramic substrate having therein conductors is fixed to the upper portion of a supporting case having a bottom plate and further wires from the conductors are stored in the cylindrical ceramic body bonded to the bottom face of the ceramic substrate. This is for preventing the wires from being exposed to corrosive gas and the like and corroded.

In the case that the conductors formed in the ceramic substrate constituting a ceramic bonded body of the third aspect of the present invention are heating elements and conductor circuits, the ceramic bonded body functions as a ceramic heater.

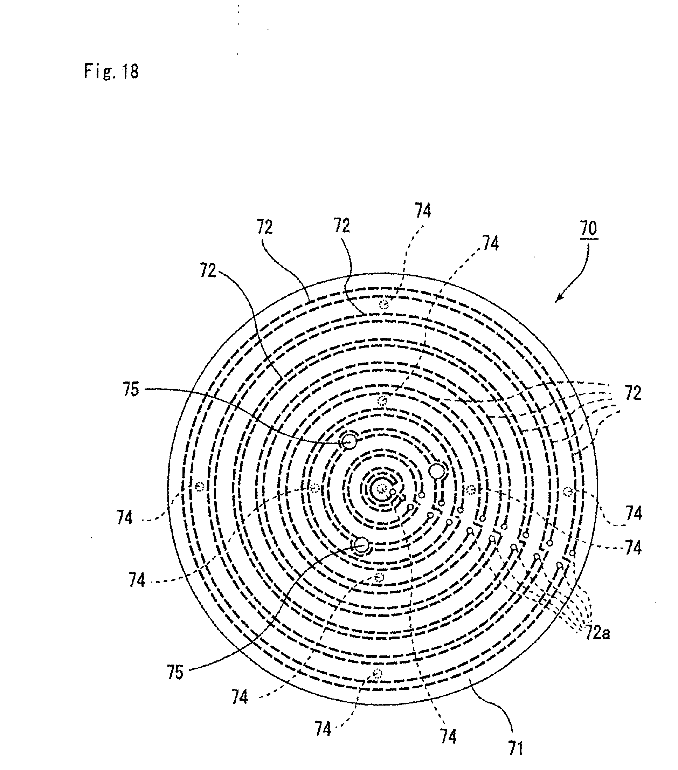

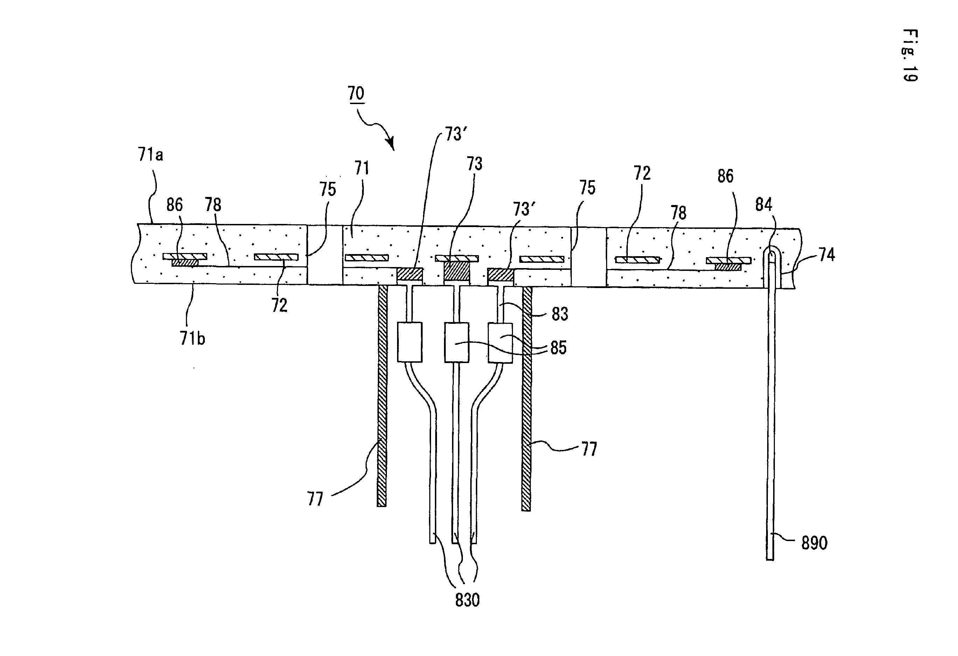

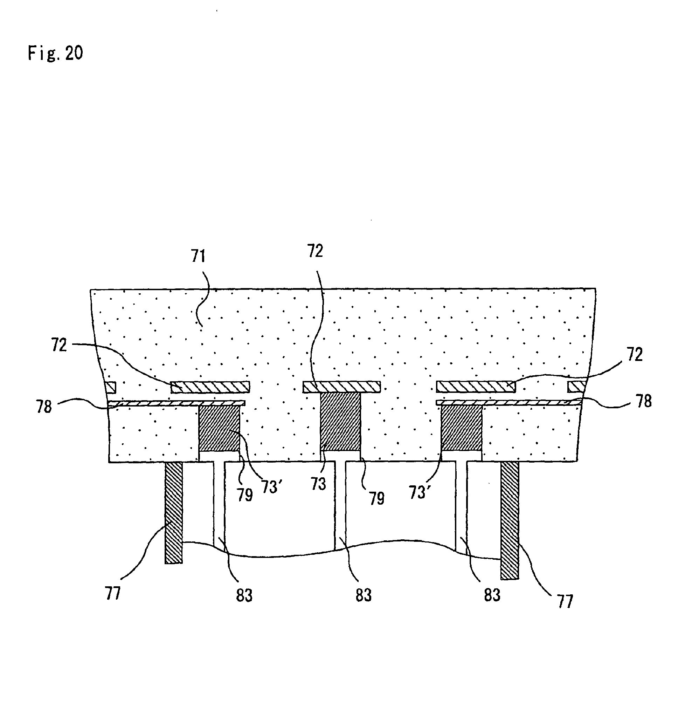

Fig. 18 is a plan view which schematically illustrates a ceramic heater which is an example of the ceramic bonded body of the third aspect of the present invention, and Fig. 19 is a sectional view thereof. Fig. 20 is a partially enlarged sectional view of the vicinity of the cylindrical ceramic body illustrated in Fig. 19.

As illustrated in Fig. 19, in this ceramic heater 70, cylindrical ceramic body 77 is bonded directly to the vicinity of the center of the bottom face 71b of a ceramic substrate 71 having a disk-like shape. At this time, the center of the circle surrounded by the interface between the cylindrical ceramic body 77 and the ceramic substrate 71 is 3 to 200 µm apart from the center of the bottom face of the ceramic substrate 71, as described above.

Since the cylindrical ceramic body 77 is formed to adhere closely to the bottom plate (not illustrated) of the supporting case, the inside and the outside of the cylindrical ceramic body 77 are completely separated.

As illustrated in Fig. 18, heating elements 72 formed of circuits having a concentrically circular shape are formed in the ceramic substrate 71. About these heating elements 72, two concentric circles adjacent to each other are connected to each other so as to be a single line as one circuit.

As illustrated in Fig. 19, conductor circuits 78 extending toward the center of the ceramic substrate 71 are formed between the heating elements 72 and the bottom face 71b, and ends 72a of the heating element are connected to one end of the conductor circuit 78 through via holes 86.

The conductor circuit 78 is formed to extend the ends 72a of the heating element to the central portion. In the ceramic substrate 71, a conductor filled through hole 73' and a blind hole 79 for making the conductor filled through hole 73' exposed are formed just under the other end of the conductor circuit 78 extending in the vicinity of the inside of the cylindrical ceramic body 77. This conductor filled through hole 73' is connected to an external terminal 83 whose tip has a T-shape through a solder layer (not illustrated).

In the case that the ends 72a of the heating element are inside the cylindrical ceramic body 77, no via holes or conductor circuits are necessary. Accordingly, the conductor filled through holes 73 are directly fitted to the ends of the heating element and they are connected to the external terminals 83 through a solder layer.

Sockets 85 having a conductive wire 830 are fitted to these external terminals 83, and this conductive wire 830 is led out from the through holes formed in the bottom plate (not illustrated) and then connected to a power source (not illustrated) and the like.

On the other hand, temperature measuring elements 84, such as thermocouples, having a lead wire 890 are inserted into the bottomed holes 74 formed in the bottom face 71b of the ceramic substrate 71, and the holes are sealed with a heat-resistant resin, a ceramic (such as silica gel and the like. This lead wire 890 is passed through an insulator (not illustrated) , and is led out through a through hole (not illustrated) formed in the bottom plate of the supporting case. The inside of the insulator is also insulated from the outside thereof.

Furthermore, through holes 75, for letting lifter pins (not illustrated) pass through, are formed in the vicinity of the center of the ceramic substrate 71.

The lifter pins can be formed so as to be moved up and down in the state that an object to be heated, such as a silicon wafer, is put thereon. This makes it possible to deliver the silicon wafer to a non-illustrated carrying machine or receive the silicon wafer from the carrying machine and further to heat the silicon wafer put on the heating face 71a of the ceramic substrate 71, or support the silicon wafer 50 to 2000 µm apart from the heating face 71a and heat it.

The silicon wafer may be heated 50 to 2000 µm apart from the heating face 71a by making: through holes or concave portions in the ceramic substrate 71; inserting supporting pins whose tips are in a spire form or a hemispherical form into the through holes or concave portions; fixing the supporting pins in the state that they project slightly from the ceramic substrate 71; and then supporting the silicon wafer by the supporting piping system.

A coolant introducing pipe and the like may be fitted to the bottom plate of the supporting case. In this case, the temperature of the ceramic substrate 71, the cooling rate and so forth can be controlled by introducing a coolant into this coolant introducing pipe through a pipe.

As described above, in this ceramic heater 70, the cylindrical ceramic body 77 is bonded to the bottom face 71b of the ceramic substrate 71 and the cylindrical ceramic body 77 is formed to extend to the bottom plate (case wall) of the non-illustrated supporting case; therefore, the inside of the cylindrical ceramic body 77 is completely insulated from the outside thereof.

Accordingly, by protecting the conductive wires 830 led out from the through holes in the bottom plate by tubular members, even if the ceramic heater 70 is surrounded by an atmosphere containing reactive gas, halogen gas and the like, and even in the state that the reactive gas and the like enter easily the inside of the supporting case, the wires inside the cylindrical ceramic body 77 do not corrode. The wires 890 from the temperature measuring elements 84 do not corrode since they are protected from the insulator and so on.

Furthermore, inert gas and the like may be caused to flow slowly in the cylindrical ceramic body 77 so that reactive gas, halogen gas and the like do not flow in the cylindrical ceramic body 77. In this way, the corrosion of the conductive wires 830 can be still more surely prevented.

Since the cylindrical ceramic body 77 has a function for supporting the ceramic substrate 71 fixedly, the ceramic substrate 71 can be prevented from being warped by its self weight even when the ceramic substrate 71 is heated to a high temperature. As a result, an object to be heated, such as a silicon wafer, can be prevented from being damaged, and further the object to be heated can be heated to have an even temperature.

The constitutions of the ceramic substrate and temperature measuring elements which are parts of the ceramic heater of the third aspect of the present invention are the same as disclosed in the ceramic heater of the first aspect of the present invention. Thus, description thereon is omitted.

The number of the through holes formed to pass the lifter pins through the ceramic substrate, and the position where they are formed are not limited to the above.

The shape of the cylindrical ceramic body in the ceramic bonded body of the third aspect of the present invention is a cylindrical shape as illustrated in Fig. 19, and the inner diameter thereof is desirably 30 mm or more.

If the diameter is less than 30 mm, the ceramic substrate is not fixedly supported with ease. When the ceramic substrate is heated to a high temperature, it is apprehended that the ceramic substrate is warped by its self weight.

The thickness of the cylindrical ceramic body is desirably from 3 to 20 mm. If the thickness is less than 3 mm, the thickness of the cylindrical ceramic body is too small so that the mechanical strength is poor. Thus, it is apprehended that the cylindrical ceramic body is damaged by repeating temperature-rising and temperature-dropping thereof. If the thickness exceeds 20 mm, the thickness of the cylindrical ceramic body is too large so that the heat capacity gets large. Thus, it is apprehended that the temperature-rising rate drops.

As the ceramic which forms the cylindrical ceramic body, the same material for the above-mentioned ceramic substrate can be used. The method for bonding the cylindrical ceramic body to the ceramic substrate will be described in detail later.

The constitutions of heating elements, external terminals, conductive wires and so on formed inside the ceramic substrate are the same as in the ceramic heater of the first aspect of the present invention. Thus, description thereon is omitted.

In the ceramic heater 70 illustrated in Figs. 18, 19 and 20, the ceramic substrate 71 is usually fitted to the upper part of the supporting case (not illustrated). In other embodiments, however, the substrate may be put on the upper face of a supporting face having a substrate-receiving portion at its upper end, and fixed with fixing members such as bolts.

The above-mentioned ceramic heater 70 is desirably used at 100°C or more, more desirably 200°C or more.

The ceramic substrate which constitutes the ceramic bonded body of the third aspect of the present invention is used to product a semiconductor or inspect a semiconductor. Specifically, examples thereof include an electrostatic chuck, susceptor, a ceramic heater (hot plate) and the like.

The above-mentioned ceramic heater is a device wherein only heating elements are formed inside the ceramic substrate. This makes it possible to hold an object to be heated, such as a silicon wafer, on the surface of the ceramic substrate or apart from the surface, and heat the object to a given temperature or wash the object.

Furthermore, the ceramic heater which is an example of the ceramic bonded body of the third aspect of the present invention can be used when a liquid crystal substrate is heated.

In the case that conductors formed inside the ceramic substrate which constitutes the ceramic bonded body of the third aspect of the present invention are electrostatic electrodes or conductor circuits, the ceramic bonded body functions as an electrostatic chuck.

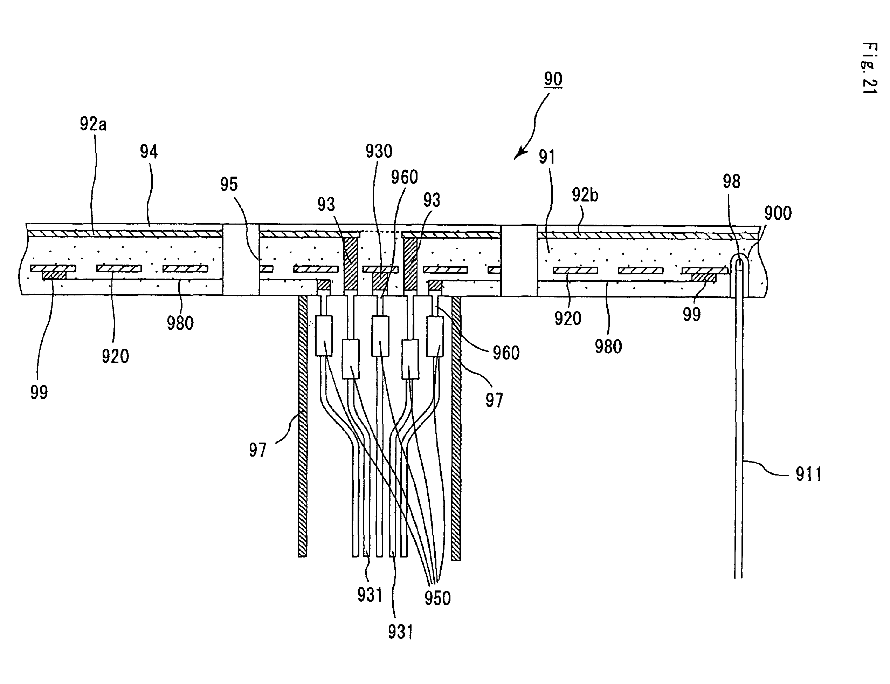

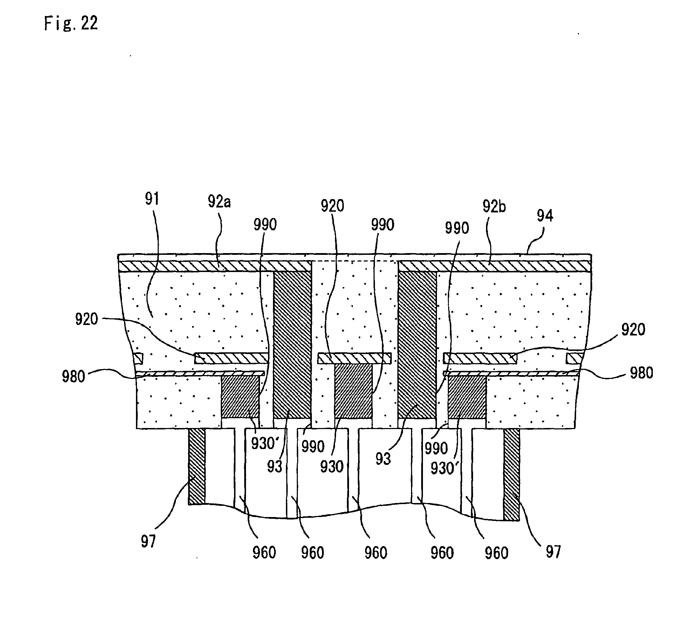

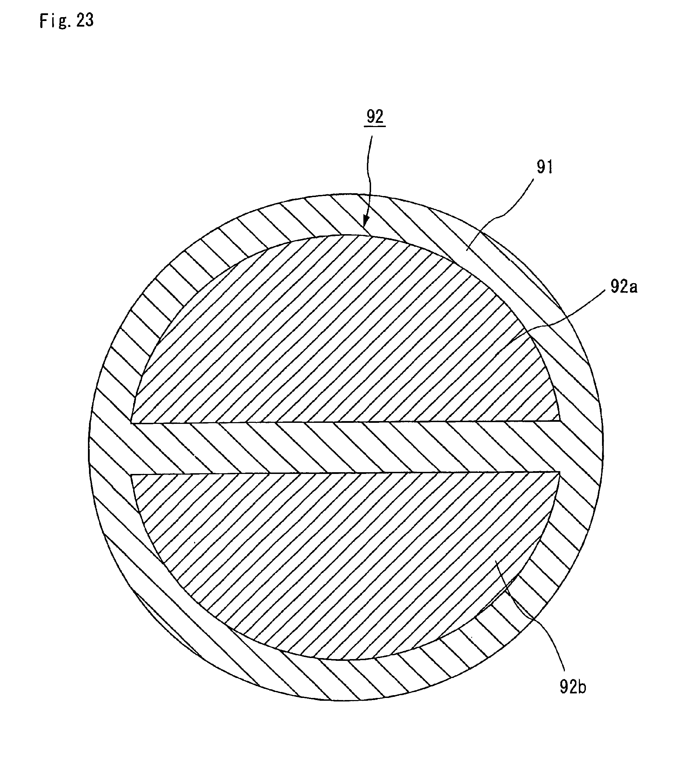

Fig. 21 is a vertical sectional view which schematically illustrates such an electrostatic chuck, and Fig. 22 is a partially enlarged sectional view thereof. Fig. 23 is a horizontal sectional view which schematically illustrates the vicinity of electrostatic electrodes formed on a substrate which constitutes the electrostatic chuck.

Inside the ceramic substrate 91 which constitutes this electrostatic chuck 90, chuck positive and negative electrostatic layers 92a and 92b in a semicircular form are arranged oppositely to each other. A ceramic dielectric film 94 is formed on these electrostatic electrodes. Inside the ceramic substrate 91, heating elements 920 are formed so that an object to be heated, such as a silicon wafer, can be heated. If necessary, RF electrodes are embedded in the ceramic substrate 91.

The electrostatic electrodes are preferably made of a metal such as a noble metal (gold, silver, platinum or palladium) , lead, tungsten, molybdenum, nickel and the like, or a conductive ceramic such as a carbide of tungsten or molybdenum. These may be used alone or in combination of two or more thereof.

As illustrated in Figs. 21, 22, in this electrostatic chuck 90, electrostatic electrodes 92a, 92b are formed in the ceramic substrate 91, and a conductor filled through hole 93 is formed just under an end of each of the electrostatic electrodes 92a, 92b. A ceramic dielectric film 94 is formed on the electrostatic electrodes 92. Except these matters, the electrostatic chuck has the same constitution as the above-mentioned ceramic heater 70.

That is, a cylindrical ceramic body 97 is bonded to the vicinity of the center of the bottom face of the ceramic substrate 91. As described above, at this time the center of the circle surrounded by the interface between the cylindrical ceramic body 97 and the ceramic substrate 91 is 3 to 200 µm apart from the center of the bottom face of the ceramic substrate 91.

The conductor filled through holes 93 and conductor filled through holes 930 are formed above the area inside of the cylindrical ceramic body 97. These conductor filled through holes 93, 930 are connected to the electrostatic electrodes 92a, 92b and the heating elements 920, and further connected to external terminals 960 inserted into blind holes 990. A socket 950 having a conductive wire 931 is connected to one end of the external terminal 960. This conductive wire 931 is led out from a through hole (not illustrated).

In the case of heating elements 920 having an end outside the cylindrical ceramic body 97, via holes 99, conductor circuits 980 and conductor filled through holes 930' are formed in the same manner as in the case of the ceramic heater 70 illustrated in Figs. 18 to 20, whereby ends of the heating elements 920 extend to the inside the cylindrical ceramic body 97 (see Fig. 22). Accordingly, by inserting the external terminals 960 into the blind holes 990 for making the conductor filled through holes 930' exposed and connecting them, the external terminals 960 can be stored inside the cylindrical ceramic body 97.

When this electrostatic chuck 90 is worked, voltages are applied to the heating elements 920 and the electrostatic electrodes 92, respectively. In this way, a silicon wafer put on the electrostatic chuck 90 is heated to a given temperature and further electrostatically absorbed on the ceramic substrate 91. This electrostatic chuck may not necessarily have the heating elements 920.

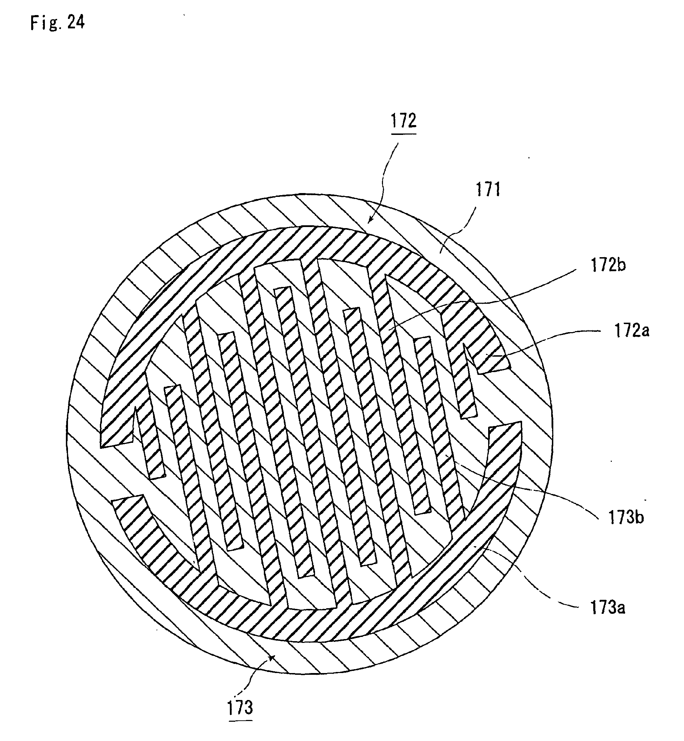

Fig. 24 is a horizontal sectional view which schematically illustrates another electrostatic electrode formed on a substrate for electrostatic chuck. A chuck positive electrostatic layer 172, which is composed of a semicircular part 172a and a combteeth-shaped part 172b, and a chuck negative electrostatic layer 173, which is also composed of a semicircular part 173a and a combteeth-shaped part 173b, are arranged face-to-face in such a manner that the teeth of one comb teeth shaped part 172b extend in staggered relation with the teeth of the other comb teeth shaped part 173b.

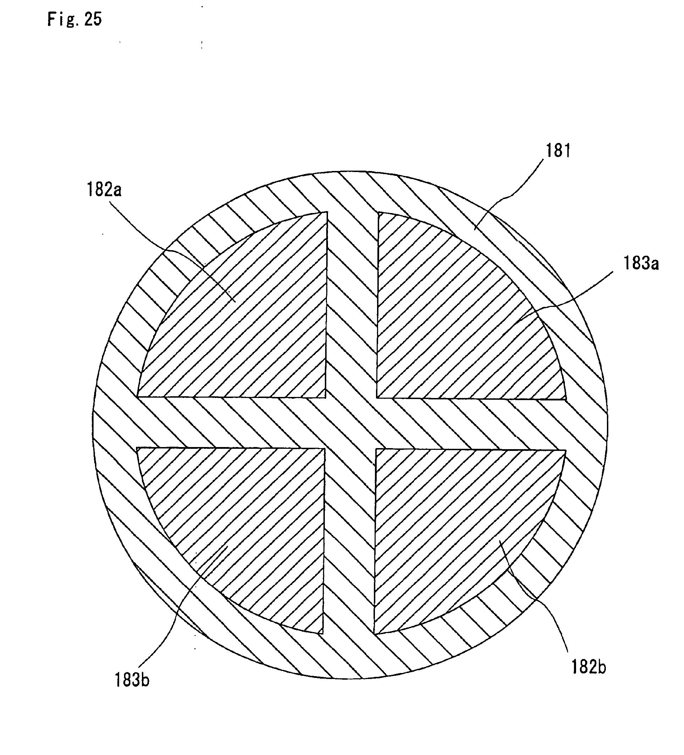

Fig. 25 is a horizontal sectional view which schematically illustrates further another electrostatic electrode formed on a substrate for an electrostatic chuck. In this electrostatic chuck, chuck positive electrostatic layers 182a, 182b and chuck negative electrostatic layers 183a, 183b, each of which has a shape obtained by dividing a circle into 4 parts, are formed inside the ceramic substrate 181. The two chuck positive electrostatic layers 182a, 182b and the two chuck negative electrostatic layers 183a, 183b are formed to cross each other.

In the case that electrodes having a form obtained by dividing an electrode having a circular shape or some other shape are formed, the number of divided pieces is not particularly limited and may be 5 or more. Its shape is not limited to a fan-shape.

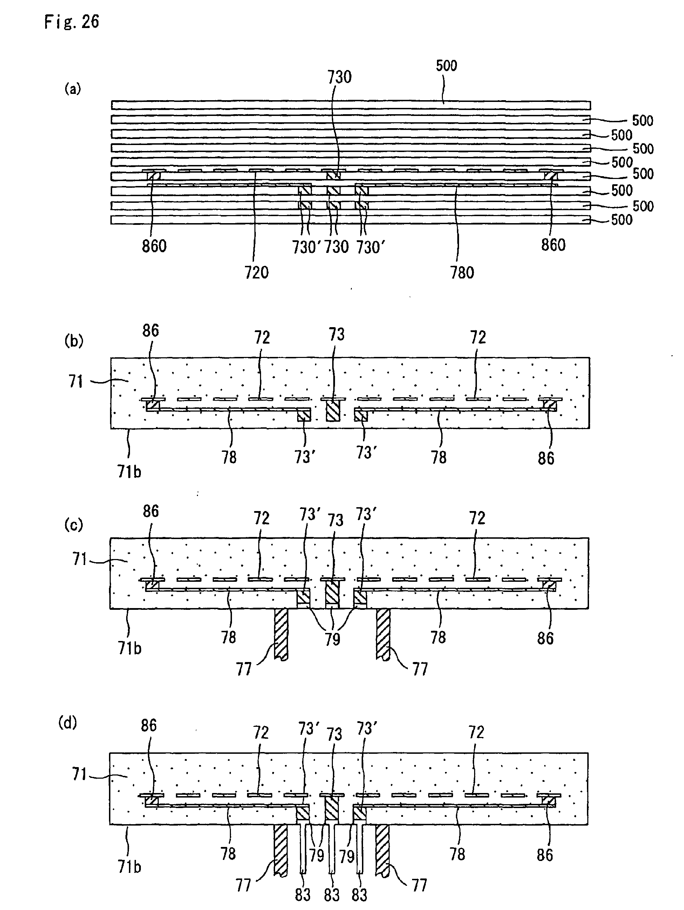

The following will describe a process for producing a ceramic heater, as an example of a process for producing the ceramic bonded body of the third aspect of the present invention, referring to Fig. 26.

Figs. 26(a) to (d) are sectional views which schematically illustrate some parts of the process for producing a ceramic heater, which is an example of the ceramic bonded body of the third aspect of the present invention.

### (1) Step of forming green sheets

First, a green sheet 500 is formed in the same way as in the process for producing the ceramic heater of the first aspect of the present invention.

Next, the following are produced: a green sheet wherein portions 860 which will be via holes for connecting an end of a heating element to a conductor circuit are formed; and a green sheet wherein portions 730, 730' which will be conductor filled through hole for connecting the conductor circuit to an external terminal are formed.

If necessary, the following are formed: portions which will be through holes for letting lifter pins for carrying a silicon wafer pass through; portions which will be through holes for inserting supporting pins for supporting a silicon wafer into; portions which will be bottomed holes for embedding temperature measuring elements such as thermocouples; and the like. About the through holes and the bottomed holes, the above-mentioned working may be performed after a green sheet lamination which will be described later is formed, or after the lamination is formed and fired.

The above-mentioned paste to which carbon is added may be filled into the portions 860, which will be the via holes, and the portions 730, 730', which will be the conductor filled through holes. This is because the carbon in the green sheet reacts with tungsten or molybdenum filled into the conductor filled through holes to form carbides thereof.

### (2) Step of printing a conductor containing paste on the green sheet

A metal paste or a conductor containing paste which contains a conductive ceramic is printed on the green sheet wherein the portions 860, which will be the via holes, are formed, so as to form a conductor containing paste layer 720.

The conductor containing paste contains metal particles or conductive ceramic particles.

The average particle diameter of tungsten particles or molybdenum particles , which will be the metal particles, is preferably from 0.1 to 5 µm. If the average particle is less than 0.1 µm or exceeds 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 to parts by weight of at least one binder selected from acrylic resin binders, ethylcellulose, butylcellosolve and polyvinyl alcohol; and 1.5 to 10 parts by weight of at least one solvent selected from α-terpineol and glycol.

A conductor containing paste which is usually used when electrostatic electrodes and the like are formed is printed on the green sheet wherein the portions 730, 730' , which will be the conductor filled through holes, are formed, so as to form a conductor containing paste layer 780.

### (3) Step of laminating the green sheets

Green sheets 500 on which no conductor containing paste is printed are laminated on the green sheet on which the conductor containing paste is printed, and then the green sheet wherein the conductor containing paste layer 780 is formed is put beneath the resultant. Furthermore, green sheets 500 wherein no conductor containing paste layer is printed is printed are laminated beneath this green sheet (see Fig. 26(a)).

At this time, the number of the green sheets 500 laminated on the upper side of the green sheet wherein the conductor containing paste layer 720 is printed is made larger than that of the green sheets 500 laminated on the lower side, so that the positions where heating elements to be produced are formed are biased toward the bottom side.

Specifically, the number of the green sheets 500 laminated on the upper side is preferably from 20 to 50, and that of the green sheets 500 laminated on the lower side is preferably from 5 to 20.

### (4) Step of firing the green sheet lamination

The green sheet lamination is heated and pressed to sinter the green sheets 500 and the inner conductor containing paste layers 720, 780, and so forth, thereby producing a ceramic substrate 71, heating elements 72, conductor circuits 78, and so forth (see Fig. 26(b)).

The heating temperature is preferably from 1000 to 2000°C, and the pressing pressure is preferably from 10 to 20 MPa. The heating is performed in the atmosphere of an inert gas. As the inert gas, argon, nitrogen and the like can be used.

Next, bottomed holes, for embedding temperature measuring elements, are formed in the bottom face 71b of the ceramic substrate 71 (not illustrated). The bottomed holes can be formed by grinding the surface and then performing drilling or blast treatment such as sandblast. The above-mentioned bottomed holes or concave portions may be formed after the ceramic substrate 71 and a cylindrical ceramic body 70, which will be described later, are bonded to each other, or may be formed at the same time of laminating and firing the green sheets 500 after portions which will be the bottomed holes are beforehand formed in the green sheets 500.

Blind holes 79 are also provided to make the conductor filled through holes 73, 73' , for connecting the inner heating elements 72, exposed. The blind holes 79 may also be formed after the ceramic substrate 71 is bonded to the cylindrical ceramic body 77.

### (5) Production of the cylindrical ceramic body

Nitride aluminum power and the like are put into a cylindrical mold, and is formed. If necessary, the formed body is cut. This is sintered at a heating temperature of 1000 to 2000°C under a normal pressure to produce the cylindrical ceramic body 77. The sintering is performed in an inert gas atmosphere. Examples of the inert gas which can be used include argon and nitrogen.

The size of the cylindrical ceramic body 77 is adjusted in such a manner that the conductor filled through holes 73, 73' formed inside the ceramic substrate are put in the body 77.

Next, end faces of the cylindrical ceramic body 77 are ground to be made flat.

### (6) Bonding of the ceramic substrate to the cylindrical ceramic body

In the state that the central vicinity of the bottom face 71b of the ceramic substrate 71 contacts the end face of the cylindrical ceramic body 77, the ceramic substrate 71 and the cylindrical ceramic body 77 are heated and bonded to each other. At this time, the conductor filled through holes 73, 73' inside the ceramic substrate 71 are allowed to be above an area inside the inner diameter of the cylindrical ceramic body 77, and further the center of the circle surrounded by the interface between the cylindrical ceramic body 77 and the ceramic substrate 71 is positioned 3 to 200 µm apart from the center of the bottom face of the ceramic substrate 71 to bond the cylindrical ceramic body 77 to the bottom face 71b of the ceramic substrate 71 (see Fig. 26 (c)).

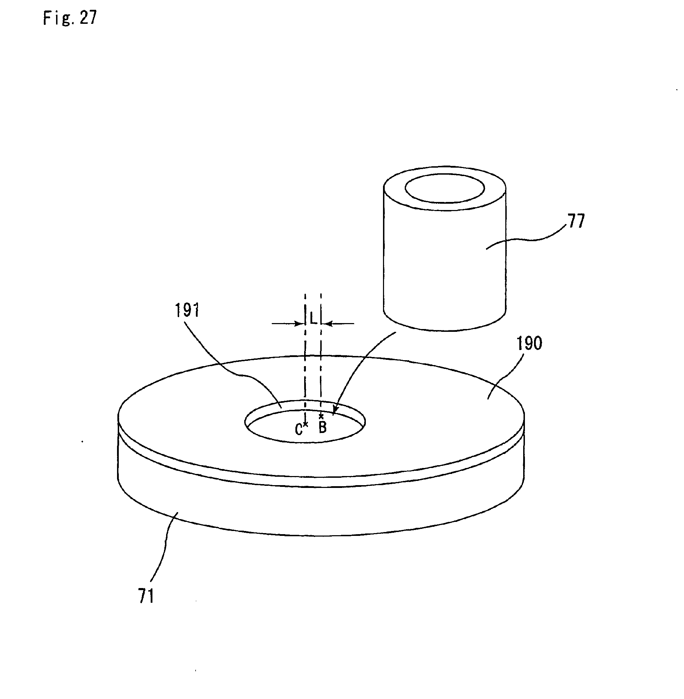

Specifically, a mask 190 in which an opening 191 is formed as illustrated in Fig. 27 is put on the bottom face of the ceramic substrate 71 and subsequently the cylindrical ceramic body 77 is fitted into the opening 191 and heated, thereby bonding the ceramic substrate 71 and the cylindrical ceramic body 77 to each other.

Since the opening diameter of the opening 191 is equal to the outer diameter of the cylindrical ceramic body 77 , the distance between the center C of the opening 191 and the center B of the bottom face of the ceramic substrate 71 is equal to the distance L between: the center of the circle surrounded by the interface between the ceramic substrate 71 and the cylindrical ceramic body 77; and the center of the bottom face of the ceramic substrate 71.

As the method of bonding the ceramic substrate 71 to the cylindrical ceramic body 77, a method of using brazing gold, brazing silver and the like to perform brazing, a method of using an adhesive made of oxide-based glass and the like to bond them, or some other method can be used.

The ceramic substrate 71 and the cylindrical ceramic body 77 can also be bonded to each other by a method of applying a ceramic paste comprising the same main component as the ceramic which constitutes the ceramic substrate 71 and the cylindrical ceramic body 77, and then sintering this, or a method of applying a solution containing a sintering aid to bonding faces of the ceramic substrate and the cylindrical ceramic body.

In the third aspect of the present invention, thermal stress in the bonding faces can be dispersed even if any one of the bonding methods is used. Therefore, the air-tightness of the bonded portions of the ceramic substrate 71 and the cylindrical ceramic body 77 can be ensured.

### (7) Fitting of terminals and so on

External terminals 83 are inserted into the blind holes 79 formed inside the inner diameter of the cylindrical ceramic body 77 through a solder or a brazing material, and the solder and the like are heated for re-flow, thereby connecting the external terminals 83 to the conductor filled through holes 73, 73' (Fig. 26(d)).

The heating temperature is preferably from 90 to 450°C in the case of the solder treatment, and is preferably from 900 to 1100°C in the case of the treatment with the brazing material.

Next, the external terminals 83 are connected through sockets 85 to conductive wires 830 connected to a power source (see Fig. 19) .

Furthermore, thermocouples as temperature measuring elements are inserted into the formed bottomed holes, and the holes are sealed with a heat-resistant resin and the like, whereby a ceramic heater having the cylindrical ceramic body on the bottom face thereof can be produced.

According to this ceramic heater, after a semiconductor wafer such as a silicon wafer is put on the ceramic heater or the silicon wafer or the like is held by lifter pins, supporting pins or some other member, an operation such as washing can be performed while the silicon wafer or the like is heated or cooled.

An electrostatic chuck can be produced by forming electrostatic electrodes inside the ceramic substrate when the above-mentioned ceramic heater is produced. In this case, however, it is necessary to formconductor filled through holes for connecting the electrostatic electrodes and external terminals, but it is unnecessary to form through holes for inserting supporting pins.

In the case that electrodes are formed inside the ceramic substrate, it is advisable that a conductor containing paste layer which will be electrostatic electrodes is formed on the surface of a green sheet in the same manner as in the case of forming heating elements.

### Best Modes for Carrying Out the Invention

The present invention will be described in more detail by way of working examples hereinafter.

### (Example 1)

### Production of Ceramic Heater (See Figs. 1, 2 and 5)

(1) The following paste was used to perform formation by a doctor blade method, so as to form a green sheet 50 having a thickness of 0.47 µm: a paste obtained by mixing 100 parts by weight of aluminum nitride powder (manufactured by Tokuyama Corp., average particle diameter: 0.6 µm), 4 parts by weight of alumina, 11.5 parts by weight of an acrylic resin binder, 0.5 part by weight of a dispersant and 53 parts by weight of alcohols of 1-butanol and ethanol.
(2) Next, this green sheet 50 was dried at 80°C for 5 hours, and subsequently portions which would be conductor filled through holes 13a were formed by punching.
(3) The following were mixed to prepare a conductor containing paste A: 100 parts by weight of tungsten carbide particles having an average particle diameter of 1 µm, 3.0 parts by weight of an acrylic resin binder, 3.5 parts by weight of α-terpineol solvent, and 0.3 part by weight of a dispersant.
   The following were mixed to prepare a conductor containing paste B: 100 parts by weight of tungsten particles having an average particle diameter of 3 µm, 1.9 parts by weight of an acrylic resin binder, 3.7 parts by weight of α-terpineol solvent, and 0.2 part by weight of a dispersant.
   This conductor containing paste A was printed on the green sheet by screen printing, so as to form a conductor containing paste layer 120 for heating elements. The printed pattern was made into a concentrically circular pattern as described in Fig. 1.
   Moreover, the conductor containing paste B was filled into the portions which would be conductor filled through holes 13a for connection to external terminals 13, so as to form a filled layer 130.
   Thirty seven green sheets 50 on which no conductor containing paste was printed were laminated on the upper side (heating surface) of the green sheet 50 that had been subjected to the above-mentioned processing, and the same thirteen green sheets were laminated on the lower side of the green sheet 50. The resultant was pressed at 130°C and a pressure of 8 MPa to form a lamination (see Fig. 5(a)).
(4) Next, the resultant lamination was degreased at 600°C in the atmosphere of nitrogen gas for 5 hours and hot-pressed at 1890°C and a pressure of 15 MPa for 10 hours to yield a ceramic plate 3 mm in thickness. This was cut off into a disk 210 mm in diameter to prepare a ceramic plate having therein heating elements 12 having a thickness of 6 µm and a width of 10 mm.
(5) Next, the ceramic plate obtained in the (4) was ground with a diamond grindstone. Subsequently, bottomed holes 14, for inserting thermocouples into, were formed in the bottom face.
   Moreover, three through holes 15 (diameter: 5.6 mm), for letting lifter pins (diameter: 5 mm) for carrying a semiconductor wafer or the like pass through, were formed (see Fig. 5(b)).
   The through holes 15 were formed at regular intervals on a circle having a diameter of 116 mm and having a concentric circle relationship with the ceramic substrate 11.
   The through holes 15 were present in an area whose distance from the center of the ceramic substrate 11 was 55%, that is, 1/2 or more of the distance from the center to the outer edge thereof.
(6) Next, the portions above the formed conductor filled through holes 13a were hollowed out to form blind holes 3b (see Fig. 5(c)). Brazing gold made of Ni and Au was used and heated for re-flow to connect external terminals 13 made of kovar to the blind holes 13b (see Fig. 5(d)).
(7) Thermocouples (not illustrated) for temperature-control were embedded in the bottomed holes 14 to finish the production of a ceramic heater 10 of the first aspect of the present invention.

### (Example 2)

### Production of Ceramic Heater (See Figs. 3, 4 and 6)

(1) A composition made of 100 parts by weight of aluminum nitride powder (average particle diameter: 0.6 µm), 4 parts by weight of yttria (average particle diameter: 0.4 µm), 12 parts by weight of an acrylic resin binder and an alcohol was subjected to spray-drying to form granular powder.
(2) Next, this granular powder was put into a mold and formed into a flat plate form to obtain a raw formed body(green).
(3) next, this raw formed body was hot-pressed at 1800°C and a pressure of 20 MPa to yield a nitride aluminum plate having a thickness of 3 mm.
   Next, this plate was cut out into a disk having a diameter of 210 mm, so as to prepare a plate made of the ceramic (ceramic substrate 21). This ceramic substrate 21 was drilled to form three through holes 25 (diameter: 3.5 mm) , for passing lifter pins 26 (diameter: 3 mm) through, and bottomed holes 24 for embedding thermocouples (see Fig. 6(a)).
   The through holes 25 were formed at regular intervals on a circle having a concentric circle relationship with the ceramic substrate 21 and having a diameter of 158 mm.
   The positions where the through holes 25 were formed were positions whose distance from the center of the ceramic substrate 21 was 75%, that is, 1/2 or more of the distance from the center to the outer edge thereof.
(4) A conductor containing paste layer was formed on the ceramic substrate 21 obtained in the above-mentioned step (3) by screen printing. The printed pattern was a concentrically circular pattern illustrated in Fig. 3.
   The used conductor containing paste was a paste having a composition of 48% by weight of Ag, 21% by weight of Pt, 1.0% by weight of SiO₂, 1.2% by weight of B₂O₃, 4.1% by weight of ZnO, 3.4% by weight of PbO, 3.4% by weight of ethyl acetate and 17.9% by weight of butyl carbitol.
   The conductor containing paste was a Ag-Pt paste, and the silver particles had an average particle diameter of 4.5 µm, and were scaly. The Pt particles had an average particle size of 0.5 µm, and were spherical.
(5) Furthermore, the ceramic substrate 21 was heated and fired at 780°C after the formation of the conductor containing paste layer, so as to sinter Ag and Pt in the conductor containing paste and bake them onto the ceramic substrate 21. Thus, heating elements 22 were formed (see Fig. 6(b)). The heating elements 22 had a thickness of 5 µm, a width of 2.4 mm and an area resistivity of 7.7 mΩ/□.
(6) The ceramic substrate 21 manufactured in the above-mentioned (5) was immersed into an electroless nickel plating bath consisting of an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) 220 having a thickness of 1 µm on the surface of the silver-lead heating elements 22 (see Fig. 6(c)).
(7) Next, by screen printing, a silver-lead solder paste (manufactured by Tanaka Kikinzoku Kogyo K. K.) was printed on portions onto which terminal portions 23 for attaining connection to a power source would be set up, to form a solder layer (not illustrated).
   Next, the external terminals 23 made of kovar were put on the solder layer, and heated for re-flow at 420°C to attach the external terminals 23 onto the surface of the heating elements 22 (see Fig. 6(d)).
(8) Thermocouples (not illustrated) for temperature-control were sealed in the bottomed holes 24 with a polyimide to finish the production of a ceramic heater 20 of the first aspect of the present invention.

### (Example 3)

(1) The following paste was used to perform formation by a doctor blade method, so as to form a green sheet 50 having a thickness of 0.47 µm: a paste obtained by mixing 100 parts by weight of SiC powder (manufactured by Yakushima Denko, average particle diameter: 1.1 µm), 4 parts by weight of B₄C, 11.5 parts by weight of an acrylic resin binder, 0.5 part by weight of a dispersant and 53 parts by weight of alcohols of 1-butanol and ethanol. Furthermore, 80 parts by weight of borosilicate glass having an average particle size of 1.0 µm, 5 parts by weight of polyethylene glycol and 15 parts by weight of alcohol were mixed to yield a glass paste. This glass paste was applied to the formed green sheet.
(2) Next, this green sheet was dried at 80°C for 5 hours, and subsequently portions which would be conductor filled through holes were formed by punching.
(3) The following were mixed to prepare a conductor containing paste A: 100 parts by weight of tungsten carbide particles having an average particle diameter of 1 µm, 3.0 parts by weight of an acrylic type binder, 3.5 parts by weight of α-terpineol solvent, and 0.3 part by weight of a dispersant.
   The following were mixed to prepare a conductor containing paste B: 100 parts by weight of tungsten particles having an average particle diameter of 3 µm, 1.9 parts by weight of an acrylic resin binder, 3.7 parts by weight of α-terpineol solvent, and 0.2 part by weight of a dispersant.
   This conductor containing paste A was printed on the green sheet by screen printing, so as to form a conductor containing paste layer for heating elements. The printed pattern was formed into a concentrically circular pattern as described in Fig. 3.
   Moreover, the conductor containing paste B was filled into the portions which would be the conductor filled through holes for connection to external terminals, so as to form a filled layer.
   The glass paste was applied to the green sheet which had been subjected to the above-mentioned processing, and further thirty seven green sheets on which no conductor containing paste was printed were laminated on the upper side (heating surface) of the green sheet, and the same thirteen green sheets were laminated on the lower side of the green sheet. The resultant was pressed at 130°C and a pressure of 8 MPa to form a lamination.
(4) Next, the resultant lamination was degreased at 600°C in the atmosphere of nitrogen gas for 5 hours and hot-pressed at 1890°C and a pressure of 15 MPa for 10 hours to yield a ceramic plate 3 mm in thickness. This was cut off into a disk 230 mm in diameter to prepare a ceramic plate having therein heating elements having a thickness of 6 µm and a width of 10 mm. Furthermore, three through holes for lifter pins, which had a diameter of 5 mm, were formed at regular intervals on a circle having a diameter of 207 mm and having a concentric circle relationship with the ceramic substrate. The positions where the through holes were formed were present in an area whose distance from the center of the ceramic substrate was 90%, that is, 1/2 or more of the distance from the center to the outer edge thereof.
(5) Next, the ceramic plate obtained in the (4) was ground with a diamond grindstone. Furthermore, a sputtering machine (ASP-34, manufactured by Showa Sinku) was used to form a magnesium fluoride film having a thickness of 2 mm on the surface.
(6) Next, the portions above the formed conductor filled through holes 13a were hollowed out to form blind holes. Brazing gold made of Ni andAu was used and heated for re-flow to connect external terminals made of kovar to the blind holes.
(7) Thermocouples (not illustrated) for temperature-control were embedded in the bottomed holes to yield a ceramic heater.

### (Test Example 1)

This example was basically the same as in Example 1, but the diameter was set to 330 mm, and the positions of the through holes for lifter pins were at positions whose distance from the center of the ceramic substrate was 10%, 20%, 30%, 40%, 50%, 60%, 70%, 80% or 90% of the distance from the center to the outer edge thereof. As will be described later, the temperature evenness in the heating face when the temperature of the ceramic heater was risen and the number of free particles were measured.

### (Comparative Example 1)

### Production of Ceramic Heater

A ceramic heater was produced in the same way as in Example 1 except that through holes (diameter: 5.6 mm) , for letting lifter pins (diameter: 5.0 mm) pass through, were formed at positions described below.

That is, three through holes were formed at regular intervals on a circle having a diameter of 63 mm and having a concentric circle relationship with the ceramic substrate.

The positions where the through holes were formed were positions whose distance from the center of the ceramic substrate was 30% of the distance from the center to the outer edge thereof, and were not in an area whose distance from the center was 1/2 or more thereof.

A silicon wafer was placed by means of the lifter pins at each of ceramic heaters according to Examples 1 to 3 and Comparative Example 1, and electric current was sent thereto so as to rise the temperature thereof to 300°C. They were evaluated by the following methods. The results are shown in Table 1.

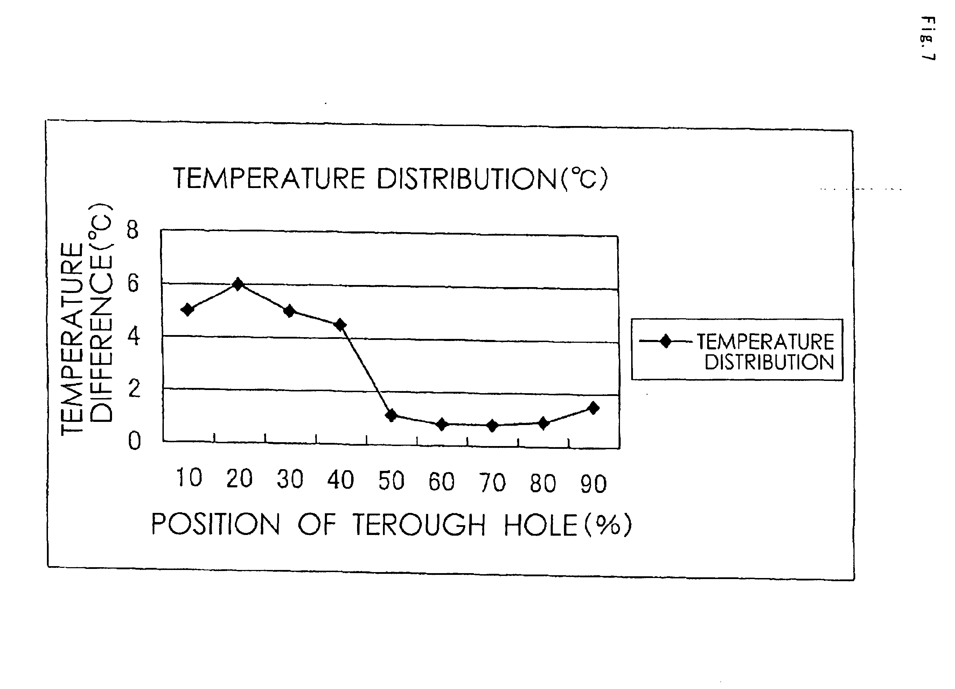

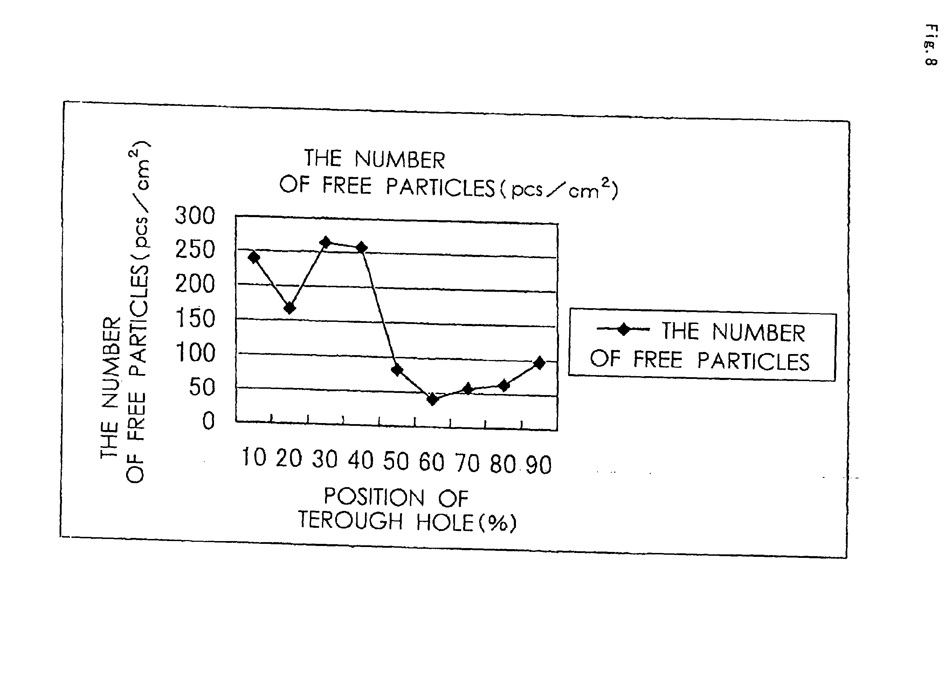

The nine ceramic heaters according to Test Example were also evaluated by the following methods. The results are shown in Figs. 7 and 8.

The lifter pins projected by 50 µm from the heating face of the ceramic heater. The portions of the silicon wafer supported by the lifter pins were 50 µm apart from the heating face.

### Evaluation Method

### (1) Temperature evenness of the In-face temperature of the heating face at the time of rising the temperature

The temperature of the ceramic heater was risen to 300°C in 45 seconds while a silicon wafer having thermocouples was placed. The difference in the temperature of the silicone wafer between the highest temperature and the lowest temperature in the step of rising the temperature was examined.

### (2) The number of free particles

A semiconductor wafer having a diameter of 200 mm or 300 mm was placed, and a test wherein this semiconductor wafer was pushed up by the lifter pins was carried out 100 times. The number of free particles adhering to the wafer was then measured. In the free particle-number measurement, arbitrary 10 points were observed with an electron microscope to measure the number of free particles, and the number was converted to the number per cm².

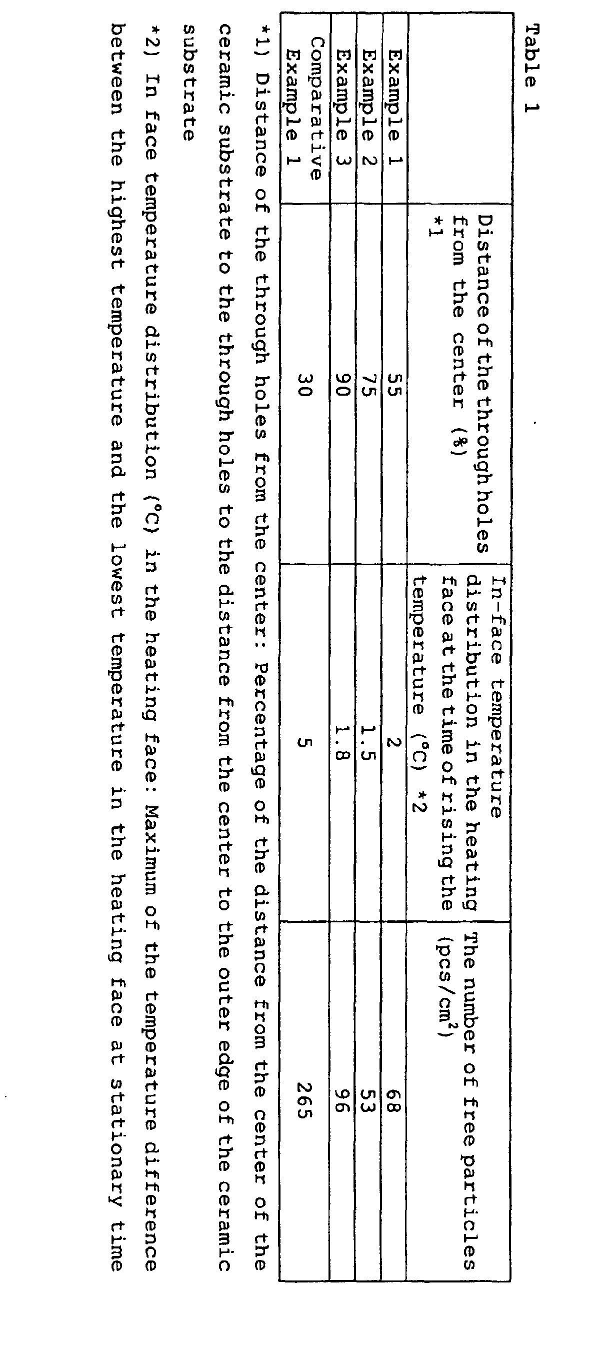

As is evident from Table 1, the temperature of the ceramic heaters according to the Examples was even at the time of rising the temperature. On the other hand, the temperature of the ceramic heater according to the comparative example was largely dispersed at the time of rising the temperature. This is because: in the ceramic heater according to the comparative example, the three through holes concentrated to the central portion thereof and the heat capacity per unit area (volume) of the central portion became smaller; therefore, the temperature of the central portion easily got high when the temperature was risen. On the other hand, in the ceramic heaters according to the Examples, this is also presumed to be because, the heat capacities per unit area (volume) between the central portion and the peripheral portion were hardly different since the through holes were formed in the peripheral portion, which had a large area (large volume).

It is understood from Fig. 7 that for the above-mentioned reason the temperature was even at the time of rising the temperature in the case that the through holes were formed at positions whose distance from the center of the ceramic substrate was 50% or more of the distance from the center to the outer edge thereof.

It can be understood from Fig. 8 that the number of free particles got fewer in the case that the through holes were formed at positions whose distance from the center of the ceramic substrate was 50% or more of the distance from the center to the outer edge thereof. As described above, it is presumed that: when the wafer warped upwards into a convex form, the outer circumference contacted the ceramic substrate linearly and scratched the ceramic substrate surface, whereby free particles were generated; however, in the first aspect of the present invention, the positions of the through holes for the lifter pins were arranged in an area whose distance from the center was 1/2 or more of the distance between the outer edge and the center of the substrate, whereby free particles were prevented from being generated.

### (Example 4)

### Production of Ceramic Heater (See Figs. 9, 10 and 13)

(1) The following paste was used to perform formation by a doctor blade method, so as to form a green sheet 100 having a thickness of 0.47 µm: a paste obtained by mixing 100 parts by weight of aluminum nitride powder:(manufactured by Tokuyama Corp., average particle diameter: 0.6 µm), 4 parts by weight of alumina, 11.5 parts by weight of an acrylic resin binder, 0.5 part by weight of a dispersant and 53 parts by weight of alcohols of 1-butanol and ethanol.
(2) Next, this green sheet 100 was dried at 80°C for 5 hours, and subsequently portions which would be conductor filled through holes 33a were formed by punching.
(3) The following were mixed to prepare a conductor containing paste A: 100 parts by weight of tungsten carbide particles having an average particle diameter of 1 µm, 3.0 parts by weight of an acrylic resin binder, 3.5 parts by weight of α-terpineol solvent, and 0.3 part by weight of a dispersant.
   The following were mixed to prepare a conductor containing paste B: 100 parts by weight of tungsten particles having an average particle diameter of 3 µm, 1.9 parts by weight of an acrylic resin binder, 3.7 parts by weight of α-terpineol solvent, and 0.2 part by weight of a dispersant.
   This conductor containing paste A was printed on the green sheet by screen printing, so as to form a conductor containing paste layer 320 for heating elements. The printed pattern was formed into a concentrically circular pattern as described in Fig. 9.
   Moreover, the conductor containing paste B was filled into the portions which would be conductor filled through holes 33a for connection to external terminals 33, so as to form a filled layer 330.
   Thirty seven green sheets 100 on which no conductor containing paste was printed were laminated on the upper side (heating surface) of the green sheet 100 that had been subjected to the above-mentioned processing, and the same thirteen green sheets were laminated on the lower side thereof. The resultant was pressed at 130°C and a pressure of 8 MPa to form a lamination (see Fig. 13(a)).
(4) Next, the resultant lamination was degreased at 600°C in the atmosphere of nitrogen gas for 5 hours and hot-pressed at 1890°C and a pressure of 15 MPa for 10 hours to yield a ceramic plate 4 mm in thickness. This was cut off into a disk of 310 mm in diameter to prepare a ceramic plate having therein heating elements 32 having a thickness of 6 µm and a width of 10 mm.
(5) Next, the ceramic plate obtained in the (4) was ground with a diamond grindstone. Subsequently bottomed holes 34, for inserting thermocouples into, were formed in the bottom face.
   Moreover, three through holes 35, for letting lifter pins 36 (diameter: 3 mm) for carrying a semiconductor wafer or the like pass through, were formed (see Fig. 13(b)).
   About the through holes 35, the diameter of their columnar portion 35a was 3.5 mm and the length thereof was 2 mm, and depth (length) of their diameter-increasing portion 35b was 2 mm and the diameter, at the heating face, of the diameter-increasing portion 35b was 7 mm (see Fig. 10).
   The through holes 35 were formed at regular intervals on a circle having a diameter of 200 mm and having a concentric circle relationship with the ceramic substrate 31.
(6) Next, the portions above the formed conductor filled through holes 33a were hollowed out to form blind holes 33b (see Fig. 13 (c)). Brazing gold made of Ni and Au was used and heated for re-flow to connect external terminals 33 made of kovar to the blind holes 33b (see Fig. 13(d)).
(7) Thermocouples (not illustrated) for temperature-control were embedded in the bottomed holes 34 to finish the production of a ceramic heater 30 of the second aspect of the present invention.

### (Example 5)

### Production of Ceramic Heater (See Figs. 11, 12 and 14)

(1) A composition made of 100 parts by weight of aluminum nitride powder (average particle diameter: 0.6µm), 4 parts by weight of yttria (average particle diameter: 0.4 µm), 12 parts by weight of an acrylic resin binder and an alcohol was subjected to spray-drying to form granular powder.
(2) Next, this granular powder was put into a mold and formed into a flat plate form to obtain a raw formed body(green).
(3) Next, this raw formed body was hot-pressed at 1800°C and a pressure of 20 MPa to yield a nitride aluminum plate having a thickness of 5 mm.
   Next, this plate was cut out into a disk having a diameter of 310 mm, so as to prepare a plate made of the ceramic (ceramic substrate 41). This ceramic substrate 41 was drilled to form three through holes 45 (diameter: 3.5 mm), for letting lifter pins 46 (diameter: 3 mm) pass through, and bottomed holes 44 for embedding thermocouples (see Fig. 14(a)).
   About the through holes 45, the diameter of their columnar portion 45a was 3.5 mm and the length thereof was 3 mm, and the depth (length) of their diameter-increasing portion 45b was 2 mm and the diameter, in the heating face, of the diameter-increasing portion 45b was 10 mm (see Fig. 12).
   The through holes 45 were formed at regular intervals on a circle having a concentric circle relationship with the ceramic substrate 41 and having a diameter of 40 mm.
(4) A conductor containing paste layer was formed on the ceramic substrate 41 obtained in the above-mentioned (3) by screen printing. The printed pattern was a concentrically circular pattern illustrated in Fig. 3.
   The used conductor containing paste was a paste having a composition of 48% by weight of Ag, 21% by weight of Pt, 1.0% by weight of SiO₂, 1.2% by weight of B₂O₃, 4. 1% by weight of ZnO, 3.4% by weight of PbO, 3.4% by weight of ethyl acetate and 17.9% by weight of butyl carbitol.
   This conductor containing paste was a Ag-Pt paste, and the silver particles had an average particle diameter of 4.5 µm, and were scaly. The Pt particles had an average particle size of 0.5 µm, and were spherical.
(5) Furthermore, the ceramic substrate 41 was heated and fired at 780°C after the formation of the conductor containing paste layer, so as to sinter Ag and Pt in the conductor containing paste and bake them onto the ceramic substrate 41. Thus, heating elements 42 were formed (see Fig. 14(b)). The heating elements 42 had a thickness of 5 µm, a width of 2.4 mm and an area resistivity of 7.7 mΩ/□.
(6) The ceramic substrate 41 formed in the above-mentioned (5) was immersed into an electroless nickel plating bath consisting of an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer (nickel layer) 420 having a thickness of 1 µm on the surface of the silver-lead heating elements 42 (see Fig. 14(c)).
(7) By screen printing, a silver-lead solder paste (manufactured by Tanaka Kikinzoku Kogyo K. K.) was printed on portions onto which terminal portions 43 for attaining connection to a power source would be set up, to form a solder layer (not illustrated).
   Next, the external terminals 43 made of kovar were put on the solder layer, and heated for re-flow at 420°C to attach the external terminals 43 onto the surface of the heating elements 42 (see Fig. 14(d)).
(8) Thermocouples (not illustrated) for temperature-control were sealed in the bottomed holes 44 with a polyimide to finish the production of a ceramic heater 40 of the second aspect of the present invention.

### (Comparative Example 2)

### Production of Ceramic Heater

In the same way as in the prior art, a ceramic heater was produced in the same way as in Example 4 except that columnar through holes (diameter: 3.5 mm), for letting lifter pins (diameter: 3.0 mm) pass through, were formed in the ceramic substrate.

### (Comparative Example 3)

A ceramic heater was produced in the same way as in Example 4 except that plugs, which were capable of being fitted into the through holes and were made of AlN, were fitted to the through holes.

A silicon wafer was placed by means of the lifter pins at each of ceramic heaters according to Examples 4 and 5 and Comparative Examples 2 and 3, and electric current was sent thereto so as to rise the temperature thereof to 300°C. They were evaluated by the following methods.

The lifter pins projected by 50 µm from the heating face of the ceramic heater. The portions of the silicon wafer which is supported by the lifter pins were 50 µm apart from the heating face.

### Evaluation method

### (1)Temperature evenness of the In-face temperature of the heating face at the time of rising the temperature

The temperature of the ceramic heater was risen to 300°C in 45 seconds while a silicon wafer having thermocouples was placed. The difference in the temperature of the silicone wafer between the highest temperature and the lowest temperature in the step of rising the temperature was examined. The results are shown in Table 2.

### (2) The number of free particles on the silicon wafer

The temperature of the ceramic heater was risen to 300°C. Thereafter, the number of free particles generated on the silicon wafer was measured. The results are shown in Table 2.

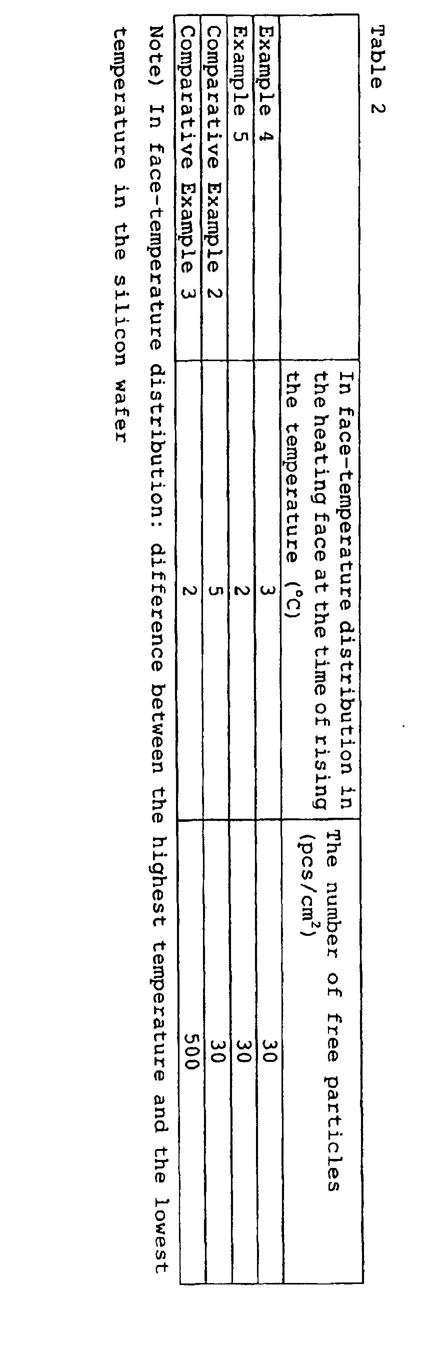

As is evident from Table 2, according to the ceramic heaters according to the Examples, the temperature of the silicon wafer was even at the time of rising the temperature. On the other hand, according to the ceramic heater according to Comparative Example 2, the temperature of the silicon wafer was largely dispersed at the time of rising the temperature. In particular, at portions corresponding to the portions where the through holes were formed, the temperature thereof dropped. It appears that the reason for this is as follows: in the ceramic heater according to Comparative Example 2, the heat capacity of cooling spot portions was large since the through holes had a columnar shape and the diameter thereof was not increased in the vicinity of the heating face, and this resulted in a drop in the temperature of silicon wafer at portions corresponding to the portions where the through holes were formed.

On the other hand, in the ceramic heaters of the Examples, the through holes were composed of the columnar portion and the diameter-increasing portion and the diameter thereof was increased in the vicinity of the heating face; therefore, the heat capacity of portions where cooling spots were easily generated was small. For this reason, a dispersion in the temperature of the silicon wafer is considered not be easily generated.

In the ceramic heater according to Comparative Example 3, the plugs made of AlN were fitted to the through holes. Thus, the ceramic heater had no portions where cooling spots were easily generated. For this reason, the temperature of the silicon wafer was even at the time of rising the temperature.

In the ceramic heaters according to Examples 4, 5 and Comparative Example 2, the silicon wafer was placed by way of the lifter pins. Thus, free particles were hardly generated. However, in the ceramic heater according to Comparative Example 3, the ceramic heater was scrubbed with the plugs made of AlN at the time of the heating, so that a large amount of free particles were generated in the silicon wafer.

### (Example 6)

In the present Example 6, a ceramic heater was produced in the same way as in Example 4 except that the ratio of the diameter of the diameter-increasing portion in the heating face and the columnar portion was changed.

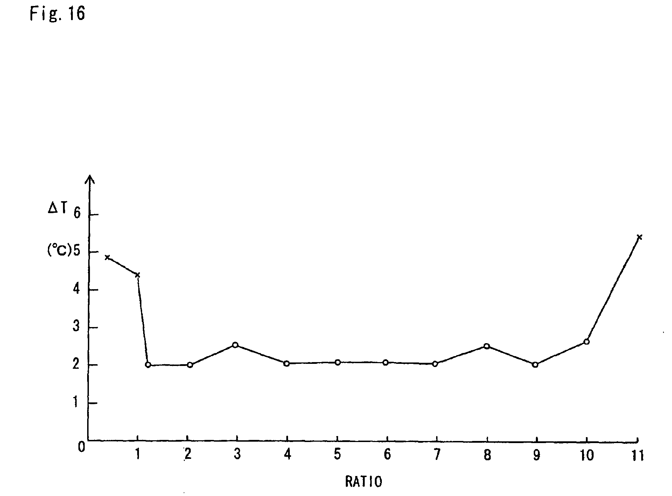

A silicon wafer having thermocouples was placed on the produced ceramic heater through the lifter pins, and then the wafer was heated to 300°C. The difference between the highest temperature and the lowest temperature in the silicon wafer was examined. The result is shown in Fig. 16.

In Fig. 16, the vertical axis ΔT represents the temperature difference (°C) between the highest temperature and the lowest temperature in the silicon wafer, and the ratio as the horizontal axis represents the ratio of the diameter of the diameter-increasing portion at the heating face of the ceramic heater to the diameter of the columnar portion (the diameter of the diameter-increasing portion/the diameter of the columnar portion).

As is clear from Fig. 16, if the ratio of the diameter of the diameter-increasing portion in the heating face to the diameter of the columnar portion is less than 1.2 or exceeds 10, the temperature difference ΔT in the silicon wafer gets large.

### (Example 7) Production of Electrostatic Chuck (See Figs. 21 to 22)

(1) The following paste was used to perform formation by a doctor blade method, so as to form a green sheet having a thickness of 0.47 µm: a paste obtained by mixing 100 parts by weight of aluminum nitride powder (manufactured by Tokuyama Corp., average particle diameter: 1.1 µm), 4 parts by weight of yttrium (average particle diameter: 0.4 µm), 12 parts by weight of an acrylic resin binder, 0.5 part by weight of a dispersant and 53 parts by weight of alcohols of 1-butanol and ethanol.
(2) Next, this green sheet 100 was dried at 80°C for 5 hours, and subsequently the following were produced: a green sheet to which no processing was applied; a green sheet in which through holes for via holes, for connecting heating elements to conductor circuits, were formed by punching; a green sheet in which through holes for viaholes, for connecting the conductor circuits to external terminals, were formed by punching; and a green sheet in which through holes for conductor filled through holes, for connecting electrostatic electrodes to the external terminals, were formed by punching.
(3) The following were mixed to prepare a conductor containing paste A: 100 parts by weight of tungsten carbide particles having an average particle diameter of 1 µm, 3.0 parts by weight of an acrylic resin binder, 3.5 parts by weight of α-terpineol solvent, and 0.3 part by weight of a dispersant.
   The following were mixed to prepare a conductor containing paste B: 100 parts by weight of tungsten particles having an average particle diameter of 3 µm, 1.9 parts by weight of an acrylic resin binder, 3.7 parts by weight of α-terpineol solvent, and 0.2 part by weight of a dispersant.
(4) The conductor containing paste A was printed on the surface of the green sheets in which the through holes for the via holes were formed by screen printing, so as to print a conductor containing paste layer which would be the heating elements. The conductor containing paste A was printed on the surface of the green sheets in which the through holes for the conductor filled through holes, for connecting the conductor circuits to the external terminals, were formedby screen printing, so as to print a conductor containing paste layer which would be the conductor circuits. A conductor containing paste layer having an electrostatic electrode pattern having the shape illustrated in Fig. 23 was formed on the green sheets to which no processing was applied.
   Moreover, the conductor containing paste B was filled into the through holes for the via holes, for connecting the heating elements to the conductor circuits, and the through holes for the conductor filled through holes, for connecting the external terminals.
   Next, the respective green sheets which had been subjected to the above-mentioned processing were laminated.
   First, thirty four green sheets in which only the portions which would be the conductor filled through holes 93 were formed were laminated on the upper side (heating face side) of the green sheet on which the conductor containing paste layer which would be the heating elements was printed, and then the green sheet on which the conductor containing paste layer which would be the conductor circuits was printed was laminated on the just lower side thereof (bottom face side). Furthermore, twelve green sheets in which the portions which would be the conductor filled through holes 93, 930 and 930' were formed were laminated on the lower side thereof.
   The green sheet on which the conductor containing paste layer having the electrostatic electrode pattern was printed was laminated on the topmost portion of the thus-laminated green sheets, and further two green sheets to which no processing was applied were laminated thereon. The resultant was pressed at 130°C and a pressure of 8 MPa to form a lamination.
(5) Next, the resultant lamination was degreased at 600°C in the atmosphere of nitrogen gas for 5 hours and then hot-pressed at 1890°C and a pressure of 15 MPa for 3 hours to yield a nitride aluminum plate 3 mm in thickness.
   This was cut off into a disk of 230 mm in diameter to prepare a ceramic substrate 91 having therein the heating elements 920 having a thickness of 5 µm and a width of 2.4 mm, the conductor circuits 980 having a thickness of 20 µm and a width of 10 mm, and the chuck positive electrostatic layer 92a and the chuck negative electrostatic layer 92b having a thickness of 6 µm.
(6) Next, the ceramic substrate 91 obtained in the (5) was ground with a diamond grindstone. Subsequently, a mask was put thereon, and blast treatment with glass beads was conducted to form bottomed holes 900 for thermocouples in the surface. The portions above the formed conductor filled through holes 93 and 930 were hollowed out in the bottom face 91b of the ceramic substrate 91 so as to form blind holes 990.
(7) A composition obtained by mixing 100 parts by weight of aluminum nitride powder (manufactured by Tokuyama Corp., average particle diameter: 1.1 µm), 4 parts by weight of yttria (average particle diameter: 0.4 µm), 11.5 parts by weight of an acrylic resin binder, 0.5 part by weight of a dispersant and 53 parts by weight of alcohols of 1-butanol and ethanol was used to produce granules by spray-drying. The granules were put into a pipe-form mold and sintered at 1890°C under a normal pressure to produce a cylindrical ceramic body having a length of 200 mm, an outer diameter of 45 mm and an inner diameter of 35 mm.
(8) To bonding faces of the ceramic substrate 91 and the cylindrical ceramic body 97 was applied a liquid obtained by mixing 100 parts by weight of aluminum nitride powder (manufactured by Tokuyama Corp., average particle diameter: 1.1 µm), 4 parts by weight of yttria (average particle diameter: 0.4 µm), 11.5 parts by weight of the acrylic resin binder, 0.5 part by weight of the dispersant and 53 parts by weight of alcohols of 1-butanol and ethanol. Thereafter, an end face of the cylindrical ceramic body 97 was brought into contact with the bottom face 91b of the ceramic substrate 91 at a position, in a manner that the blind holes 990 would be inside the inner diameter, of the end face. The resultant was heated at 1890°C to bond the ceramic substrate 91 and the cylindrical ceramic body 97.
   Specifically, a mask 190 in which an opening 191 as illustrated in Fig. 27 was formed was put on the bottom face of the ceramic substrate 91. Thereafter, the cylindrical ceramic body 97 was fitted into the opening 191, and the resultant was heated to bond the ceramic substrate 91 and the cylindrical ceramic body 97.
   The distance L between: the center of the circle surrounded by the interface between the ceramic substrate 91 and the cylindrical ceramic body 97; and the center of the bottom face of the ceramic substrate 91 was set to 5 µm.
(9) Next, brazing silver (Ag: 40% by weight, Cu: 30% by weight, Zn: 28% by weight, Ni: 1.8% by weight, and the balance: other elements, re-flow temperature: 800°C) was used to attach external terminals 960 to the blind holes 990 formed in the cylindrical ceramic body 97. Conductive wires 931 were connected to the external terminals 960 through sockets 950.
(10) Thermocouples for temperature-control were inserted into the bottomed holes 900, and silica sol was filled into the holes. The silica sol was hardened and gelation occured at 190°C for 2 hours to bond the cylindrical ceramic body to the bottom face of the ceramic substrate inside which the electrostatic electrodes, the heating elements, the conductor circuits, the via holes and the conductor filled through holes were formed. In this way, a ceramic bonded body wherein the ceramic substrate functioned as an electrostatic chuck was produced.

### (Example 8) Production of Ceramic Heater (See Figs. 18 to 19, and 26)

(1) The following paste was used to perform formation by a doctor blade method, so as to form a green sheet having a thickness of 0.47 µm: a paste obtained by mixing 100 parts by weight of aluminum nitride powder (manufactured by Tokuyama Corp., average particle diameter: 1.1 µm), 4 parts by weight of yttrium oxide (Y₂O₃: yttria, average particle diameter: 0.4 µm), 11.5 parts by weight of an acrylic resin binder, 0.5 part by weight of a dispersant and 53 parts by weight of alcohols of 1-butanol and ethanol.
(2) Next, this green sheet was dried at 80°C for 5 hours, and subsequently the following were formed by punching: portions which would be through holes 75, for letting lifter pins for carrying a silicon wafer pass through; portions which would be via holes 860; and portions 730, 730' which would be conductor filled through holes, as illustrated in Fig. 18.
(3) The following were mixed to prepare a conductor containing paste A: 100 parts by weight of tungsten carbide particles having an average particle diameter of 1 µm, 3.0 parts by weight of an acrylic resin binder, 3.5 parts by weight of α-terpineol solvent, and 0.3 part by weight of a dispersant.
   The following were mixed to prepare a conductor containing paste B: 100 parts by weight of tungsten particles having an average particle diameter of 3 µm, 1.9 parts by weight of an acrylic resin binder, 3.7 parts by weight of α-terpineol solvent, and 0.2 part by weight of a dispersant.
   This conductor containing paste A was printed on the green sheets in which the portions 860, which would be the via holes, were formed by screen printing, so as to print a conductor containing paste layer 720 for heating elements. The printed pattern was formed into a concentrically circular pattern as illustrated in Fig. 18. The width of the conductor containing paste layer 720 was set to 10 mm, and the thickness thereof was set to 12 µm.
   Subsequently, the conductor containing paste A was printed on the green sheet in which the portions 730', which wouldbe the conductor filled through holes, were formed by screen printing. In this way, a conductor containing paste layer 780 for conductor circuits was formed. The printed shape was a band shape.
   Moreover, the conductor containing paste B was filled into the portions 860, which would be the via holes, and the portions 730 and 730', which would be the conductor filled through holes.
   Thirty seven green sheets in which no conductor containing paste was printed were laminated on the green sheet which had been subjected to the above-mentioned processing, the sheet having the printed conductor containing paste layer 720. The green sheet on which the conductor containing paste layer 780 was printed was then laminated beneath it. Thereafter, twelve green sheets on which no conductor containing paste was printed were laminated beneath it. The resultant was pressed at 130°C and 8 MPa, so as to form a lamination.
(4) Next, the resultant lamination was degreased at 600°C in the atmosphere of nitrogen gas for 5 hours and then hot-pressed at 1890°C and a pressure of 15 MPa for 10 hours to yield a nitride aluminum plate 3 mm in thickness.
   This was cut off into a disk of 230 mm in diameter to prepare a ceramic substrate 71 having therein the heating elements 72 having a thickness of 6 µm and a width of 10 mm, the conductor circuits 78 having a thickness of 20 µm and a width of 10 mm, the via holes 860 and the conductor filled through holes 73, 73'.
(5) Next, the ceramic substrate 71 obtained in the (4) was ground with a diamond grindstone. Subsequently, a mask was put thereon, and blast treatment with glass beads was conducted to form bottomed holes 74 for thermocouples in the surface. The portions above the formed conductor filled through holes 73, 73' were hollowed out in the bottom face 71b of the ceramic substrate 71, so as to form blind holes 79.
(6) A composition obtained by mixing 100 parts by weight of aluminum nitride powder (manufactured by Tokuyama Corp., average particle diameter: 1.1 µm), 4 parts by weight of Y₂O₃ (average particle diameter: 0.4 µm), 11.5 parts by weight of an acrylic resin binder, 0.5 part by weight of a dispersant and 53 parts by weight of alcohols of 1-butanol and ethanol was used to produce granules by spray-drying. The granules were put into a cylindrical mold and sintered at 1890°C under a normal pressure to produce a cylindrical ceramic body 77.
(7) To bonding faces of the ceramic substrate 71 and the cylindrical ceramic body 77 was applied an aqueous yttrium nitrate (2.61×10⁻¹ mol/L) solution. Thereafter, an end face of the cylindrical ceramic body 77 was brought into contact with the bottom face 71b of the ceramic substrate 71 at a position, in a manner that the blind holes 79 would be inside the inner diameter, of the end face. The resultant was heated at 1890°C to bond the ceramic substrate 71 and the cylindrical ceramic body 77.
   Specifically, a mask 190 in which an opening 191 as illustrated in Fig. 27 was formed was put on the bottom face of the ceramic substrate 71. Thereafter, the cylindrical ceramic body 77 was fitted into the opening 191, and the resultant was heated to bond the ceramic substrate 71 and the cylindrical ceramic body 77.
   The distance L: between the center of the circle surrounded by the interface between the ceramic substrate 71 and the cylindrical ceramic body 77; and the center of the bottom face of the ceramic substrate 71 was set to 190 µm.
(8) Next, brazing silver (Ag: 40% by weight, Cu: 30% by weight, Zn: 28% by weight, Ni: 1.8% by weight, and the balance: other elements, re-flow temperature: 800°C) was used to attach external terminals 83 to the blind holes 79 formed in the cylindrical ceramic body 77. Conductive wires 830 were connected to the external terminals 83 through sockets 85.
(9) Thermocouples for temperature-control were inserted into the bottomed holes 74, and silica sol was filled into the holes. The silica sol was hardened and gelation was occurred at 190°C for 2 hours to bond the cylindrical ceramic body to the bottom face of the ceramic substrate inside which the heating elements, the conductor circuits, the via holes and the conductor filled through holes were formed. In this way, a ceramic bonded body wherein the ceramic substrate functioned as a ceramic heater was produced.

### (Example 9)

A ceramic bonded body was produced in the same way as in Example 7 except that the following steps were carried out.

First, the diameter of the ceramic substrate was set to 300 mm, and in the step (7) 100 parts by weight of aluminum nitride powder, 4 parts by weight of yttria, 11.5 parts by weight of an acrylic resin binder, 0.5 part by weight of a dispersant and 53 parts by weight of alcohols were mixed to produce granules by spray-drying. Moreover, conductive wires were bonded to external terminals through sockets to form power source supplying lines. The power source supplying lines were put into a mold, and the granules were filled into the mold, and then pressed. Furthermore, the granules were subjected to cold isostatic press at a pressure of 1000 kg/cm², and then sintered at 1890°C under a normal pressure. The resultant was then shaped into a ceramic body formed of a columnar sold body having a length of 200 mm and an outer diameter of 45 mm.

The distance L between: the center of the bottom face of the ceramic substrate; and the center of the interface between the ceramic body and the ceramic substrate was set to 3 µm.

### (Example 10)

A ceramic bonded body was produced in the same way as in Example 8 except that the following steps were carried out.

The diameter of the ceramic substrate was set to 320 mm, and in the (6) 100 parts by weight of aluminum nitride powder, 4 parts by weight of yttria, 11.5 parts by weight of an acrylic resin binder, 0.5 part by weight of a dispersant and 53 parts by weight of alcohols were mixed to produce granules by spray-drying. Moreover, conductive wires were bonded to external terminals through sockets to form power source supplying lines. The power source supplying lines were put into a mold, and the granules were filled into the mold, and then pressed. Furthermore, the granules were subjected to cold isostatic press at a pressure of 1000 kg/cm², and then sintered at 1890°C under a normal pressure. The resultant was then shaped into a ceramic body formed of a columnar sold body having a length of 200 mm and an outer diameter of 45 mm.

The distance L between: the center of the bottom face of the ceramic substrate; and the center of the interface (circle) between the ceramic body and the ceramic substrate was set to 200 µm.

### (Example 11)

A ceramic bonded body was produced in the same way as in Example 7 except that L was set to 10 µm.

### (Example 12)

A ceramic bonded body was produced in the same way as in Example 8 except that L was set to 50 µm.

### (Example 13)

A ceramic bonded body was produced in the same way as in Example 9 except that L was set to 100 µm.

### (Example 14)

A ceramic bonded body was produced in the same way as in Example 10 except that L was set to 150 µm.

### (Test Example 2)

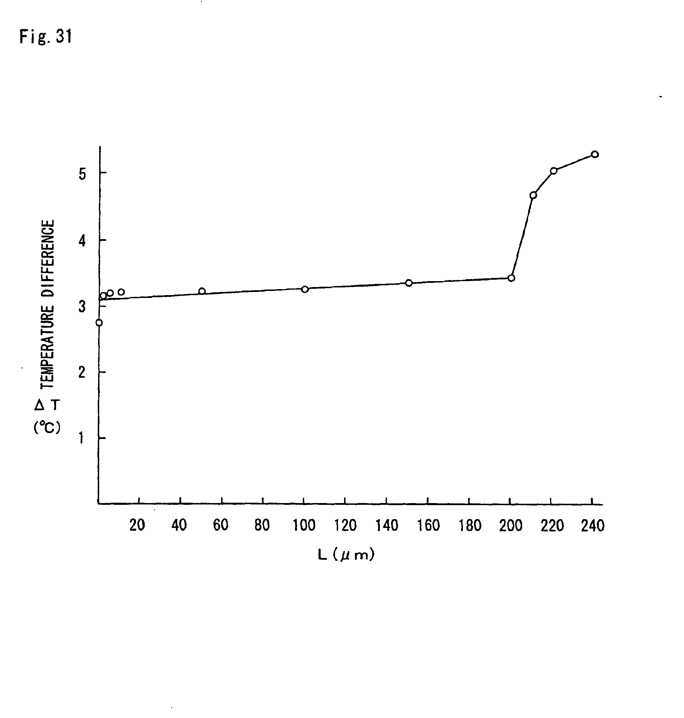

Ceramic bonded bodies wherein L was changed from 0 to 240 µm were produced. The temperatures of the ceramic bonded bodies were risen to 450°C. At this time, the temperature difference ΔT between the highest temperature and the lowest temperature in the heating face was measured. The results are shown in Fig. 31. It is understood that when L was more than 200 µm, ΔT got large. The ceramic bonded bodies had the same constitution as illustrated in Figs. 18 to 19.

### (Comparative Example 4)

A ceramic bonded body was produced in the same way as in Example 7 except that the ceramic substrate 91 was bonded to the cylindrical ceramic body 97 in such a manner that the center of the circle surrounded by the interface,between the ceramic substrate 91 and the cylindrical ceramic body 97 and the center of the bottom face of the ceramic substrate 91 would be at the same position.

### (Comparative Example 5)

A ceramic bonded body was produced in the same way as in Example 7 except that the distance Lbetween: the center of the circle surrounded by the interface between the ceramic substrate 91 and the cylindrical ceramic body 97; and the center of the bottom face of the ceramic substrate 91 was set to 2 µm.

### (Comparative Example 6)

A ceramic bonded body was produced in the same way as in Example 8 except that the distance L between: the center of the circle surrounded by the interface between the ceramic substrate 71 and the cylindrical ceramic body 77; and the center of the bottom face of the ceramic substrate 71 was set to 2 µm.

### (Comparative Example 7)

A ceramic bonded body was produced in the same way as in Example 7 except that the distance L between: the center of the circle surrounded by the interface between the ceramic substrate 91 and the cylindrical ceramic body 97; and the center of the bottom face of the ceramic substrate 91 was set to 205 µm.

### (Comparative Example 8)

A ceramic bonded body was produced in the same way as in Example 8 except that the distance L between: the center of the circle surrounded by the interface between the ceramic substrate 71 and the cylindrical ceramic body 77; and the center of the bottom face of the ceramic substrate 91 was set to 205 µm.

The ceramic bonded bodies according to Examples 7 to 14 and Comparative Examples 4 to 8 were subjected to the following evaluation tests. The results are shown in Table 3 described below.

### (1) Measurement of the breaking strength

A bending strength test was performed to measure the breaking strength of the bonding face.

### (2) Heat cycle test

A heat cycle test wherein the step of keeping each of the ceramic bonded bodies at 25°C and then heating it to 450°C was repeated was made 500 times. It was checked whether or not a crack was generated in the bonding portion between the cylindrical ceramic body and the ceramic substrate. A case in which the generation rate was less than 50% was judged as no generation of any crack, and a case in which the generation rate was 50% or more was judged as crack generation.

### (3) Existence of corrosion in the wires and so on

Each of the ceramic bonded bodies according to the Examples and the Comparative Examples was fitted to a supporting case, and the temperature thereof was risen to 200°C in the atmosphere of CF₄. Thereafter, the state of corrosion in the wires and so on of the ceramic bonded body was observed with the naked eye.

Nitrogen gas was introduced, as an inert gas, into the cylindrical ceramic body.

**Table 3**

| | Breaking strength (MPa) | Heat cycle test | Corrosion |
|---|---|---|---|
| Example 7 | 400 | No generation of crack | Not generated |
| Example 8 | 410 | No generation of crack | Not generated |
| Example 9 | 440 | No generation of crack | Not generated |
| Example 10 | 435 | No generation of crack | Not generated |
| Example 11 | 411 | No generation of crack | Not generated |
| Example 12 | 405 | No generation of crack | Not generated |
| Example 13 | 438 | No generation of crack | Not generated |
| Example 14 | 430 | No generation of crack | Not generated |
| Comparative Example 4 | 320 | Crack generation | Generated |
| Comparative Example 5 | 300 | Crack generation | Generated |
| Comparative Example 6 | 285 | Crack generation | Generated |
| Comparative Example 7 | 320 | Crack generation | Generated |
| Comparative Example 8 | 300 | Crack generation | Generated |

As is evident from the results shown in Table 3, the ceramic bonded bodies according to Examples 7 to 14 had sufficiently large bonding strength in both of the breaking strength test and the heat cycle test, and the wires and so on arranged inside the cylindrical ceramic bodies of these ceramic bonded body were not corroded by CF₄ gas.

On the other hand, in the ceramic bonded bodies according to Comparative Examples 4 to 8, the bonding strength between the cylindrical ceramic body and the ceramic substrate was low, and further the wires and so on arranged inside the cylindrical ceramic body were corroded by CF₄ gas.

It appears that this is because thermal stress concentrated locally in the bonding interface between the cylindrical ceramic and the disk-like ceramic, whereby thermal fatigue was generated so that cracks and the like were generated.

### (Examples 15 and 16, and Comparative Examples 9 and 10)

L was set to 3 (Example 15) , 200 µm (Example 16) , 0 µm (Comparative Example 9) and 205 µm (Comparative Example 10) , respectively, and the diameter of a ceramic substrate was changed from 150 mm to 350 mm. The crack generation rates of the thus-produced ceramic bonded bodies were examined. The results are shown in Fig. 32.

As is evident from Comparative Examples 9 and 10, the crack generation rate was close to 80% when the diameter was more than 250 mm and practical endurance was not obtained. On the other hand, in Examples 15 and 16, the value of the crack generation rate was kept low even if the diameter was more than 250 mm. As described above, the present invention can overcome endurance drop generated in ceramic heaters having a diameter of 250 mm or more.

### Industrial Applicability

According to the ceramic heater of the first aspect of the present invention, three ormore through holes are formed in a ceramic substrate and formed in an area whose distance from the center of the ceramic substrate is 1/2 or more of the distance from the center to the outer edge thereof; therefore, lifter pins passed through the through holes are also present in the peripheral portion of the ceramic substrate and do not concentrate in the central portion. Thus, a semiconductor wafer supported by the lifterpins and the like does not become unstable.

A difference in the heat capacity in the ceramic substrate is small so that a dispersion in the temperature thereof is small when the temperature is risen. Thus, a semiconductor wafer or the like can be evenly heated.

According to the ceramic heater of the second aspect of the present invention, in through holes formed in a ceramic substrate, the diameter thereof on the side of its heating face for heating an object to be heated is larger than that on the side opposite to the heating face; therefore, the occupation rate of gas in portions where cooling spots are generated gets large so that the heat capacity thereof gets small. Accordingly, the temperature of a semiconductor wafer, a liquid crystal substrate and the like of the portion in the vicinity of the formed through holes hardly drops so that the object to be heated, such as the semiconductor wafer or the liquid crystal substrate, can be more evenly heated.

Furthermore, according to the ceramic bonded body of the third aspect of the present invention, thermal stress does not concentrate locally in the bonding interface between a ceramic body having a given shape such as a cylindrical or columnar shape and a disk-like ceramic so that no crack and the like are generated in this portion; therefore, sufficient air-tightness can be kept. Thus, the reliability of the ceramic bonded body can be largely improved.

## Claims

1. A ceramic heater comprising:
a disk-like ceramic substrate;
a heating element formed on a surface of or inside said ceramic substrate; and
through holes for letting lifter pins pass through at said ceramic substrate,
wherein
three or more of said through holes are formed, and said through holes are formed in an area whose distance from the center of said ceramic substrate is 1/2 or more of the distance from the center of said ceramic substrate to the outer edge of said ceramic substrate.

2. The ceramic heater according to Claim 1,
wherein
said through holes are formedat substantially regular intervals on a single circle which has a concentric circle relationship with said ceramic substrate.

3. A ceramic heater comprising:
a disk-like ceramic substrate;
a heating element formed on a surface of or inside said ceramic substrate; and
through holes for letting lifter pins pass through at said ceramic substrate,
wherein
the diameter of each of said through holes on a heating face side for heating an object to be heated is larger than the diameter of said through hole on the side opposite to said heating face.

4. The ceramic heater according to Claim 3,
wherein
each of said through holes comprises a columnar portion and a diameter-increasing portion,
the diameter of said diameter-increasing portion becomes larger as the portion is closer to the heating face.

5. The ceramic heater according to Claim 3 or 4,
wherein
the diameter on the heating face side of each of said through holes is from 1.2 to 10 times as large as the diameter on the side opposite to said heating face of said through holes.

6. A ceramic bonded body comprising:
a disk-like ceramic substrate inside which a conductor is provided; and
a ceramic body bonded to the bottom face of said ceramic substrate,
wherein
the center of an area surrounded by the interface between said ceramic body and said ceramic substrate, or the center of an area constituted by the interface between said ceramic body and said ceramic substrate is 3 to 200 µm apart from the center of the bottom face of said ceramic substrate.

7. A ceramic bonded body comprising:
a disk-like ceramic substrate inside which a conductor is provided; and
a cylindrical ceramic body having a cylindrical shape bonded to the bottom face of said ceramic substrate, wherein
the center of the circle surrounded by the interface between said cylindrical ceramic body and said ceramic substrate is 3 to 200 µm apart from the center of the bottom face of said ceramic substrate.

8. The ceramic bonded body according to Claim 6 or 7,
wherein
said conductor is a heating element, and functions as a hot plate.

9. The ceramic bonded body according to Claim 6 or 7,
wherein
said conductor is an electrostatic electrode, and functions as an electrostatic chuck.

10. The ceramic bonded body according to Claim 6 or 7,
wherein
said ceramic substrate has a diameter of 250 mm or more.
